# EUROPEAN PATENT APPLICATION

(11) **EP 4 835 879 A1**
(43) Date of publication of application: **04.11.2026**
(21) Application number: 24915895.7
(22) Date of filing: 08.01.2024
(51) Int. Cl.: G09G 3/3266, G11C 19/28

(54) **GATE DRIVE CIRCUIT, DISPLAY SUBSTRATE, AND DISPLAY APPARATUS**

(71) Applicant: Boe Technology Group Co., Ltd., Beijing 100015 (CN); Yunnan Invensight Optoelectronics Technology Co., Ltd., Kunming, Yunnan 650211 (CN); Beijing BOE Technology Development Co., Ltd., Daxing District Beijing 100176 (CN)
(72) Inventor: ZHU, Zhijian, Beijing 100176 (CN); SHAN, Qingshan, Beijing 100176 (CN); HUANG, Yinhu, Beijing 100176 (CN); YANG, Shengji, Beijing 100176 (CN); LU, Pengcheng, Beijing 100176 (CN); FAN, Longfei, Beijing 100176 (CN); ZHANG, Dacheng, Beijing 100176 (CN)
(74) Representative: Durán-Corretjer, S.L.P.
(86) International application number: PCT/CN2024/071147
(87) International publication number: WO 2025/147813

(57) **Abstract**

A gate drive circuit, a display substrate, and a display apparatus. The gate drive circuit comprises a shift register circuit (100) arranged on a silicon base (101), and the shift register circuit (100) comprises a plurality of transistor groups sequentially arranged in a first direction, wherein at least one transistor group comprises a P-type transistor and an N-type transistor arranged on one side of the P-type transistor in a second direction, the P-type transistor at least comprises a P-type active region, the N-type transistor at least comprises an N-type active region, a gap region (50) is provided between the P-type active region and the N-type active region in the second direction, and the gap region (50) has a gap center line (OC), the first direction intersecting the second direction; and the plurality of transistor groups form at least one transmission gate, at least one NAND gate and at least one inverter, and the gap center lines (OC) of the transistor groups in the at least one transmission gate, the at least one NAND gate and the at least one inverter are in the same straight line extending in the first direction.

## Description

### Technical Field

The present disclosure relates to, but is not limited to, the field of display technology, and particularly to a gate drive circuit, a display substrate and a display apparatus.

### Background

Micro organic light emitting diodes (Micro OLEDs) are micro displays developed in recent years, and an OLED on silicon (OLEDoS) is one of them. OLEDoS is a new display technology that combines semiconductor process and OLED display technology and uses wafers as base substrates to manufacture OLED devices. Because the OLEDoS has advantages of both semiconductor process technology and OLED display technology, the OLEDoS not only has high pixel density (Pixels Per Inch, referred to as PPI), but also has advantages of high brightness, low power consumption, high response speed, high color gamut and high thermal stability.

### Summary

The following is a summary of subject matter described herein in detail. This summary is not intended to limit the protection scope of claims.

In one aspect, an embodiment of the present disclosure provides a gate drive circuit including a shift register circuit disposed on a silicon substrate, wherein the shift register circuit includes at least a plurality of transistor groups disposed sequentially in a first direction, at least one transistor group includes P-type transistors and N-type transistors disposed on a side of the P-type transistors in a second direction, the first direction and the second direction intersecting with each other; a P-type transistor includes at least a P-type active region, an N-type transistor includes at least an N-type active region, and there is a gap region between the P-type active region and the N-type active region in the second direction, the gap region having a gap centerline, wherein the gap centerline is a straight line bisecting the gap region in the second direction and extending in the first direction; the plurality of transistor groups form at least one transmission gate, at least one NAND gate, and at least one inverter, and gap centerlines of the transistor groups in the at least one transmission gate, the at least one NAND gate, and the at least one inverter are on a same straight line extending in the first direction.

In an exemplary implementation, the plurality of transistor groups form a first transmission gate, a first NAND gate, a third inverter, a second transmission gate, a third transmission gate, a second NAND gate, a fourth inverter, a second inverter, and a first inverter disposed sequentially in the first direction; widths of gap regions of transistor groups in a same type of devices are the same, gap centerlines of the transistor groups in the same type of devices are on a same straight line extending in the first direction, and the widths of the gap regions are dimensions in the second direction.

In an exemplary implementation, P-type transistors in the same type of devices have a same width-to-length ratio, and N-type transistors in the same type of devices have a same width-to-length ratio.

In an exemplary implementation, in at least one of the first inverter, the second inverter, the third inverter, and the fourth inverter, a ratio of a width-to-length ratio of P-type transistors to a width-to-length ratio of N-type transistors is greater than 1 and less than 3.

In an exemplary implementation, a ratio of a width-to-length ratio of P-type transistors to a width-to-length ratio of N-type transistors in the first NAND gate is greater than a ratio of a width-to-length ratio of P-type transistors to a width-to-length ratio of N-type transistors in the first inverter, and the ratio of the width-to-length ratio of the P-type transistors to the width-to-length ratio of the N-type transistors in the first inverter is greater than a ratio of a width-to-length ratio of P-type transistors to a width-to-length ratio of N-type transistors in the first transmission gate.

In an exemplary implementation, the shift register circuit further includes a power supply active region disposed on a side of the P-type active region away from the N-type active region and a ground active region disposed on a side of the N-type active region away from the P-type active region, wherein the power supply active region has a first centerline, the ground active region has a second centerline, the first centerline is a straight line bisecting the power supply active region in the second direction and extending in the first direction, the second centerline is a straight line bisecting the ground active region in the second direction and extending in the first direction, and a distance between the first centerline and the second centerline in the second direction is less than or equal to 6.3 µm.

In an exemplary implementation, in at least one transistor group, there is a first width between the first centerline and an edge of the P-type active region close to the first centerline, and there is a second width between the second centerline and an edge of the N-type active region close to the second centerline, wherein the first width is greater than 1 µm and less than 3 µm, the second width is greater than 1 µm and less than 3 µm, and the first width and the second width are dimensions in the second direction.

In an exemplary implementation, in at least one transistor group, there is a third width between an edge of the P-type active region away from the first centerline and an edge of the N-type active region away from the second centerline, the third width is greater than or equal to 1.5 µm, and the third width is a dimension in the second direction.

In an exemplary implementation, in at least one transistor group, there is a P-type active region width between an edge of the P-type active region close to the first centerline and an edge of the P-type active region away from the first centerline; there is an N-type active region width between an edge of the N-type active region close to the second centerline and an edge of the N-type active region away from the second centerline; the P-type active region width is greater than 1 µm and less than 3 µm, the N-type active region width is greater than 1 µm and less than 3 µm, and the P-type active region width and the N-type active region width are dimensions in the second direction.

In an exemplary implementation, the gate drive circuit further includes a logical transition unit, a level shifter, and a line driver disposed on the silicon substrate, wherein the shift register circuit is configured to generate a timing with row by row shift according to a timing signal, the logical transition unit is configured to generate a target timing by a logic operation, the level shifter configured to perform voltage domain conversion on the target timing, and the line driver configured to enhance the converted signal before outputting to a scan signal line in the display area.

In another aspect, an embodiment of the present disclosure provides a display substrate including a display area and a non-display area; the display area includes a plurality of sub-pixels, at least one sub-pixel including a pixel drive circuit and at least one scan signal line, and the scan signal line being configured to provide a scan signal to a pixel drive circuit connected the scan signal line; the non-display area includes a plurality of cascaded gate drive circuits, at least one gate drive circuit being connected to a scan signal line in one pixel row in the display area connected to, and the at least one gate drive circuit including the gate drive circuit as described above.

In another aspect, an embodiment of the present disclosure provides a display apparatus, including the display substrate as described above.

Other aspects may become clear after the drawings and the detailed description are read and understood.

### Brief Description of Drawings

Accompanying drawings are used for providing understanding of technical solutions of the present disclosure, constitute a part of the specification, and are used for explaining the technical solutions of the present disclosure together with the embodiments of the present disclosure, but do not form limitations on the technical solutions of the present disclosure. Shapes and sizes of each component in the drawings do not reflect actual scales, but are only intended to schematically illustrate contents of the present disclosure.
FIG. 1 is a schematic diagram of a structure of an OLEDoS display apparatus.
FIG. 2 is a schematic diagram of a planar structure of a display area in an OLEDoS display apparatus.
FIG. 3 is a schematic diagram of a sectional structure of a display area in an OLEDoS display apparatus.
FIG. 4 is an equivalent circuit diagram of a pixel drive circuit.
FIG. 5 is a drive timing diagram of the pixel drive circuit shown in FIG. 4.
FIG. 6 is a schematic diagram of a structure of a gate drive circuit according to an exemplary embodiment of the present disclosure.
FIG. 7 is a working principle diagram of a shift register circuit in an exemplary embodiment of the present disclosure.
FIG. 8 is an equivalent circuit diagram of a shift register circuit according to an exemplary embodiment of the present disclosure.
FIG. 9 is a schematic diagram of a structure of a shift register circuit according to an exemplary embodiment of the present disclosure.
FIGS. 10A and 10B are schematic diagrams after an N-well area and an active region pattern are formed according to an embodiment of the present disclosure.
FIG. 10C is an enlarged schematic diagram of an area where a first NAND gate and a third inverter in FIG. 10A are located.
FIGS. 11A and 11B are schematic diagrams after a pattern of a gate conductive layer is formed according to an embodiment of the present disclosure.
FIG. 11C is an enlarged schematic diagram of a twelfth P-type gate electrode and a twelfth N-type gate electrode of FIG. 11A.
FIGS. 12A and 12B are schematic diagrams after a pattern of a P-type doped region is formed according to an embodiment of the present disclosure.
FIGS. 13A and 13B are schematic diagrams after a pattern of an N-type doped region is formed according to an embodiment of the present disclosure.
FIG. 14 is a schematic diagram after a pattern of a second insulation layer is formed according to an embodiment of the present disclosure.
FIGS. 15A and 15B are schematic diagrams after a pattern of a first conductive layer is formed according to an embodiment of the present disclosure.
FIG. 15C is an enlarged schematic diagram of an area A in FIG. 15A.
FIG. 15D is an enlarged schematic diagram of an area B in FIG. 15A.
FIG. 16 is a schematic diagram after a pattern of a third insulation layer is formed according to an embodiment of the present disclosure;
FIGS. 17A and 17B are schematic diagrams after a pattern of a second conductive layer is formed according to an embodiment of the present disclosure.

Reference signs are described as follows.

| | | | | | |
|---|---|---|---|---|---|
| 10- | N-well area; | 31- | first P-type doped region; | 32- | second P-type doped region; |
| 41- | first N-type doped region; | 42- | second N-type doped region; | 51- | first power supply line; |
| 52- | ground wire; | 100- | shift register circuit; | 101- | silicon substrate; |
| 102- | drive circuit layer; | 103- | light emitting structure layer; | 104- | first encapsulation layer; |
| 105- | color film structure layer; | 106- | second encapsulation layer; | 107- | cover plate layer; |
| 200- | logical transition unit; | 300- | level shifter; | 201- | first transmission gate; |
| 202- | second transmission gate; | 203- | third transmission gate; | 301- | first NAND gate; |
| 302- | second NAND gate; | 400- | line driver; | 401- | first inverter; |
| 402- | second inverter; | 403- | third inverter; | 404- | fourth inverter; |

### Detailed Description

To make objectives, technical solutions, and advantages of the present disclosure clearer, the embodiments of the present disclosure will be described in detail below with reference to the accompany drawings. It is to be noted that implementations may be implemented in multiple different forms. Those of ordinary skills in the art may easily understand such a fact that implementations and contents may be transformed into various forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict. In order to keep following description of the embodiments of the present disclosure clear and concise, detailed description of part of known functions and known components are omitted in the present disclosure. The drawings in the embodiments of the present disclosure relate only to the structures involved in the embodiments of the present disclosure, and other structures may be described with reference to conventional designs.

Scales of the drawings in the present disclosure may be used as a reference in actual processes, but are not limited thereto. For example, a width-length ratio of a channel, a thickness and spacing of each film layer, and a width and spacing of each signal line may be adjusted according to actual needs. A quantity of pixels in a display substrate and a quantity of sub-pixels in each pixel are not limited to the quantity shown in the drawings. The drawings described in the present disclosure are schematic structural diagrams only, and one implementation of the present disclosure is not limited to the shapes or numerical values, or the like shown in the drawings.

Ordinal numerals "first", "second", "third", etc., in the specification are set not to form limits in numbers but only to avoid confusion between composition elements.

In the specification, for convenience, expressions "central", "above", "below", "front", "back", "vertical", "horizontal", "top", "bottom", "inside", "outside", etc., indicating directional or positional relationships are used to illustrate positional relationships between the constituent elements with reference to the accompanying drawings, not to indicate or imply that involved devices or elements are required to have specific orientations and be structured and operated with the specific orientations but only to easily and simply describe the present specification, and thus should not be understood as limitations on the present disclosure. The positional relationships between the constituent elements may be changed as appropriate according to a direction according to which each constituent element is described. Therefore, appropriate replacements based on situations are allowed, which is not limited to the expressions in the specification.

In the specification, unless otherwise specified and defined, terms "mounting", "mutual connection", and "connection" should be understood in a broad sense. For example, a connection may be a fixed connection, or a detachable connection, or an integral connection; it may be a mechanical connection or an electrical connection; it may be a direct connection, or an indirect connection through middleware, or internal communication inside two elements. Those of ordinary skills in the art may understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. It is to be noted that in the specification, the channel region refers to a region through which a current mainly flows.

In the specification, in order to distinguish between two electrodes of the transistor except the gate electrode, one of the two electrodes is directly referred to as a first electrode and the other is referred to as a second electrode. The first electrode may be a drain electrode and the second electrode may be a source electrode, or the first electrode may be a source electrode and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode" are interchangeable in the specification.

In the specification, an "electrical connection" includes a case that constituent elements are connected to each other through an element with a certain electrical action. An "element with a certain electrical action" is not particularly limited as long as electrical signals between the connected constituent elements may be sent and received. Examples of the "element with a certain electrical action" not only include an electrode and a wiring, but also include a switching element such as a transistor, a resistor, an inductor, a capacitor, another element with various functions, etc.

In the specification, "parallel" refers to a state in which an angle formed by two straight lines is above -10° and below 10°, and thus may include a state in which the angle is above -5° and below 5°. In addition, "perpendicular" refers to a state in which an angle formed by two straight lines is above 80° and below 100°, and thus may include a state in which the angle is above 85° and below 95°.

In the specification, a "film" and a "layer" are interchangeable. For example, a "conductive layer" may be replaced with a "conductive film" sometimes. Similarly, an "insulation film" may be replaced with an "insulation layer" sometimes.

In the specification, "arranged in a same layer" described refers to a structure formed by patterning two (or more than two) structures through a same patterning process, and their materials may be the same or different. For example, materials of precursors for forming multiple structures arranged in a same layer are the same, and final materials may be the same or different.

A triangle, rectangle, trapezoid, pentagon, or hexagon, etc. in the specification is not strictly defined, and it may be an approximate triangle, rectangle, trapezoid, pentagon, or hexagon, etc. There may be some small deformations caused by tolerance, and there may be a chamfer, an arc edge, deformation, etc.

In the present disclosure, "about" refers to that a boundary is not defined so strictly and numerical values within a range of process and measurement errors are allowed.

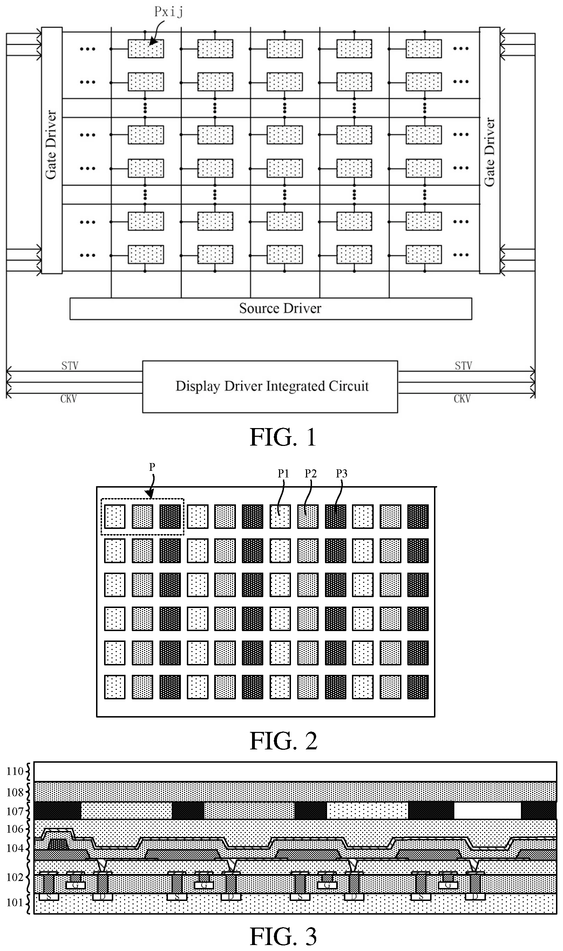

FIG. 1 is a schematic diagram of a structure of an OLEDoS display apparatus. As illustrated in FIG. 1, an OLEDoS display apparatus may include a display area and a non-display area. The display area may include a plurality of scan signal lines, a plurality of data signal lines, and a plurality of sub-pixels Pxij forming a plurality of pixel rows and a plurality of pixel columns. The plurality of scan signal lines are disposed in the plurality of pixel rows, respectively, and the plurality of data signal lines are disposed in the plurality of pixel columns, respectively. Each sub-pixel Pxij may include at least a pixel drive circuit and a light emitting device, wherein the pixel drive circuit is configured to supply a current required for light emission to the connected light emitting device, the pixel drive circuit of each sub-pixel Pxij may be connected to a scan signal line of a corresponding pixel row and a data signal line of a corresponding pixel column. The sub-pixel Pxij may refer to a sub-pixel in an i-th pixel row and a j-th pixel column, the pixel drive circuit of the sub-pixel Pxij may be connected to an i-th scan signal line and a j-th data signal line respectively, where i and j may be natural numbers. The non-display area may include a display drive circuit, (display driver integrated circuit, DDIC for short), a gate drive device, (gate driver, GD for short), and a data drive device, (source driver, SD). The display driver integrated circuit may include at least a timer controller (TCON) configured to generate a timing signal required by the gate driver, such as a start signal (STV) and a clock signal (CKV), and transmit the timing signal to the gate driver. A gate driver is respectively connected to a plurality of scan signal lines in the display area, and the gate driver is configured to provide a required timing signal to the connected pixel drive circuit to realize a display progressive scanning function. The source driver is respectively connected to a plurality of data signal lines in the display area, and the source driver is configured to provide required data signals (data) to the connected pixel drive circuits to realize switching and control of the display screen.

In an exemplary implementation, the OLEDoS display apparatus may be a single chip display architecture (One Chip), wherein a gate driver, a source driver, a clock control unit, an image process unit, a storage unit, and the like are integrated on a same chip. The chip with the One Chip architecture includes digital and analog parts, and is a mixed-signal chip.

In another exemplary implementation, the OLEDoS display apparatus may be a two chip display architecture (Two Chip), wherein a gate driver and a source driver are integrated in a display substrate, a clock control unit, an image process unit, a mobile industry processor interface (MIPI), and a storage unit are integrated in a chip, and the chip is bonded to the display substrate through a COC process.

FIG. 2 is a schematic diagram of a planar structure of a display area in an OLEDoS display apparatus. As shown in FIG. 2, in a plane parallel to the display apparatus, the display area may include a plurality of pixel units P arranged in a matrix. At least one pixel unit P may include a first sub-pixel P1 emitting light of a first color, a second sub-pixel P2 emitting light of a second color, and a third sub-pixel P3 emitting light of a third color. Each of the three sub-pixels may include a pixel drive circuit and a light emitting device, wherein the pixel drive circuit in the sub-pixel is respectively connected to a scan signal line and a data signal line, and the pixel drive circuit is configured to receive a data voltage transmitted by the data signal line and output a corresponding current to the display light emitting device under control of the scan signal line. The light emitting device in the sub-pixel is connected to the pixel drive circuit of the sub-pixel where the light emitting device is located, and the light emitting device is configured to emit light with a corresponding brightness in response to the current output by the pixel drive circuit of the sub-pixel where the light emitting device is located.

In an exemplary implementation, the first sub-pixel P1 may be a red (R) sub-pixel emitting red light, the second sub-pixel P2 may be a blue (B) sub-pixel emitting blue light, and the third sub-pixel P3 may be a green (G) sub-pixel emitting green light.

In an exemplary implementation, the sub-pixels may be in a shape of any one or more of a triangle, a square, a rectangle, a rhombus, a trapezoid, a parallelogram, a pentagon, a hexagon and other polygons. The three sub-pixels may be arranged side by side horizontally, side by side vertically or in delta-shaped arrangement, and the present disclosure is not limited thereto. In some other possible implementations, the pixel unit may include four sub-pixels, and the present disclosure is not limited thereto.

FIG. 3 is a schematic diagram of a sectional structure of a display area in an OLEDoS display apparatus, which illustrates a structure in which full color is implemented by white light + color film. As shown in FIG. 3, in a direction perpendicular to the display apparatus, the OLEDoS display apparatus may include a silicon substrate 101, a drive circuit layer 102 disposed on the silicon substrate 101, a light emitting structure layer 103 disposed on a side of the drive circuit layer 102 away from the silicon substrate 101, a first encapsulation layer 104 disposed on a side of the light emitting structure layer 103 away from the silicon substrate 101, a color film structure layer 105 disposed on a side of the first encapsulation layer 104 away from the silicon substrate 101, a second encapsulation layer 106 disposed on a side of the color film structure layer 105 away from the silicon substrate 101, and a cover plate layer 107 disposed on a side of the second encapsulation layer 106 away from the silicon substrate 101. In some possible implementations, the OLEDoS display apparatus may include other film layers, and the present disclosure is not limited thereto.

In an exemplary implementation, the silicon substrate 101 may be a bulk silicon substrate or a Silicon-On-Insulator (SOI) substrate. The drive circuit layer 102 may be prepared on the silicon substrate 101 through a silicon semiconductor process. The drive circuit layer 102 may include a plurality of circuit units, a circuit unit may at least include a pixel drive circuit connected to a scan signal line and a data signal line respectively. The pixel drive circuit may include a plurality of transistors and a storage capacitor. FIG. 3 merely illustrates an example where the pixel drive circuit includes one transistor. The transistor may include a gate electrode G, a source electrode S and a drain electrode D. The gate electrode G, the source electrode S and the drain electrode D may be connected respectively to corresponding connection electrodes through vias filled with tungsten metal (i.e., wolfram via, W-via), and may be connected to other electrical structures (e.g., traces, etc) through the connection electrodes.

In an exemplary implementation, the light emitting structure layer 103 may include a plurality of light emitting devices, and a light emitting device may at least include an anode, an organic light emitting layer and a cathode. The anode may be connected to the drain electrode D of the transistor through a connection electrode, the organic light emitting layer is connected to the anode, the cathode is connected to the organic light emitting layer, and the cathode is connected to a second power supply line. The organic light emitting layer emits light under driving of the anode and the cathode. In an exemplary implementation, the organic light emitting layer may include an Emitting Layer (EML) and any one or more of a Hole Injection Layer (HIL), a Hole Transport Layer (HTL), an Electron Block Layer (EBL), a Hole Block Layer (HBL), an Electron Transport Layer (ETL), and an Electron Injection Layer (EIL). In an exemplary implementation, for a light emitting device emitting white light, organic light emitting layers of all sub-pixels may be connected together to form a common layer.

In an exemplary implementation, the first encapsulation layer 104 and the second encapsulation layer 106 may be encapsulated in a Thin Film Encapsulation (TFE) mode, which may ensure that external moisture cannot enter the light emitting structure layer. The color film structure layer 105 may include at least a red filter unit disposed in the red sub-pixel to filter white light emitted from the light emitting device into red light, a blue filter unit disposed in the blue sub-pixel to filter white light emitted from the light emitting device into blue light, and a green filter unit disposed in the green sub-pixel to filter white light emitted from the light emitting device into green light. The cover plate layer 107 may be made of glass, or plastic colorless polyimide or the like with flexible properties.

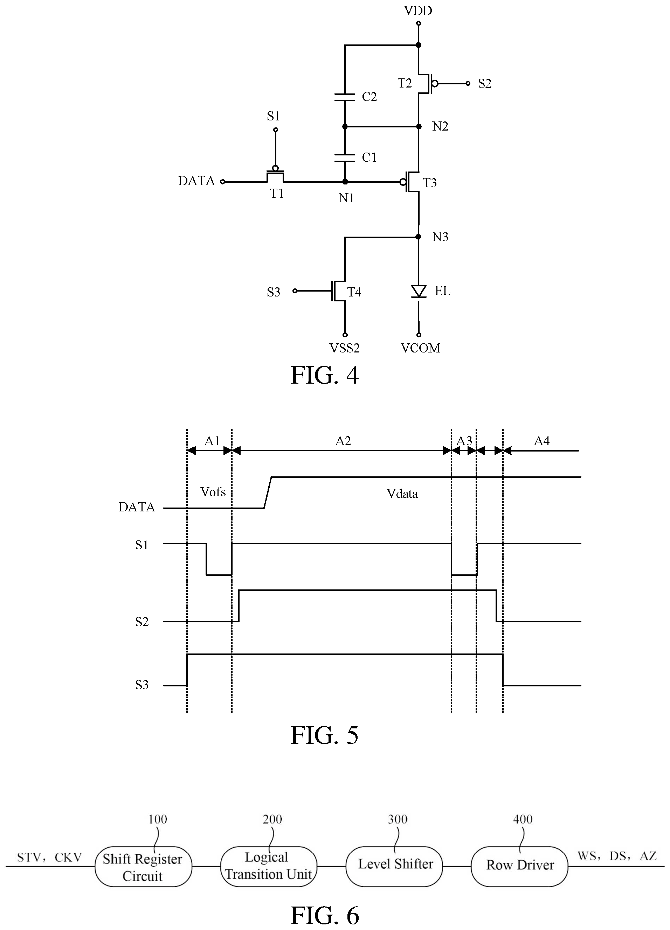

FIG. 4 is an equivalent circuit diagram of a pixel drive circuit. As shown in FIG. 4, the pixel drive circuit has a 4T2C structure, and may include four transistors (a first transistor T1, a second transistor T2, a third transistor T3, and a fourth transistor T4) and two storage capacitors (a first capacitor C1 and a second capacitor C2). The pixel drive circuit is connected to six signal lines (a first scan signal line S1, a second scan signal line S2, a third scan signal line S3, a data signal line DATA, a first power supply line VDD, and a second power supply line VSS).

In an exemplary implementation, the pixel drive circuit may include a first node N1, a second node N2, and a third node N3. The first node N1 is respectively connected to a second electrode of the first transistor T1, a gate electrode of the third transistor T3 and a first terminal of the first storage capacitor C1. The second node N2 is connected to a second electrode of the second transistor T2, a first electrode of the third transistor T3, a second terminal of the first capacitor C1, and a first terminal of the second capacitor C2 respectively. The third node N3 is connected to a second electrode of the third transistor T3, and a second electrode of the fourth transistor T4 respectively.

In an exemplary implementation, the first transistor T1 may be referred to as a write switch transistor. A gate electrode of the first transistor T1 is connected to the first scan signal line S1, a first electrode of the first transistor T1 is connected to the data signal line DATA, and the second electrode of the first transistor T1 is connected to the first node N1.

In an exemplary implementation, the second transistor T2 may be referred to as a display switch transistor. A gate electrode of the second transistor T2 is connected to the second light emitting signal line S2, a first electrode of the second transistor T2 is connected to the first power supply line VDD, and the second electrode of the second transistor T2 is connected to the second node N2.

In an exemplary implementation, the third transistor T3 may be referred to as a driver transistor. The gate electrode of the third transistor T3 is connected to the first node N1, the first electrode of the third transistor T3 is connected to the second node N2, and the second electrode of the third transistor T3 is connected to the third node N3.

In an exemplary implementation, the fourth transistor T4 may be referred to as a reset transistor (auto zero transistor). A gate electrode of the fourth transistor T4 is connected to the third scan signal line S3, a first electrode of the fourth transistor T4 is connected to the second power supply line VSS, and the second electrode of the fourth transistor T4 is connected to the third node N3.

In an exemplary implementation, the first terminal of the first storage capacitor C1 is connected to the first node N1, and the second terminal of the first storage capacitor C1 is connected to the second node N2. The first terminal of the second capacitor C2 is connected to the second node N2, and a second terminal of the second capacitor C2 is connected to the first power supply terminal VDD.

In an exemplary implementation, the light emitting device XL may be an organic light emitting diode (OLED) including a first electrode (anode), an organic light emitting layer, and a second electrode (cathode) that are stacked. A first electrode of the light emitting device XL is connected to the third node N3, and a second electrode of the light emitting device XL is connected to a common voltage line VCOM.

In an exemplary implementation, a signal of the first power line VDD may be a high level signal continuously provided, and signals of the second power line VSS and the common voltage line VCOM may be low level signals continuously provided.

In an exemplary implementation, the first transistor T1 to the fourth transistor T4 may be P-type transistors (PMOS), or may be N-type transistors (NMOS). For example, the first transistor T1 to the fourth transistor T4 may all be P-type transistors. Using the same type of transistors in the pixel circuit may simplify a process flow, reduce a process difficulty of the display substrate, and improve a product yield.

In an exemplary implementation, the first transistor T1 to the fourth transistor T4 may include P-type transistors and N-type transistors. For example, as shown in FIG. 4, the first transistor T1 to the third transistor T3 may be a P-type transistor, and the fourth transistor T4 may be an N-type transistor.

FIG. 5 is a drive timing diagram of the pixel drive circuit shown in FIG. 4. As shown in FIG. 5, in an exemplary implementation, a working process of the pixel drive circuit may include following stages A1 to A6.

A first stage A1 may be referred to as an initialization stage. Signals of the first scan signal line S1 and the second scan signal line S2 are low level signals, and a signal of the third scan signal line S3 is a high level signal, so that the first transistor T1, the second transistor T2, and the fourth transistor T4 are turned on. The first transistor T1 is turned on so that a bias voltage Vofs output from the data signal line DATA is written into the first capacitor C1, and a potential of the first node N1 (i.e. the gate electrode of the third transistor T3): Vs = Vofs. The second transistor T2 is turned on so that a first power supply voltage ELVDD output from the first power supply line VDD is written into the second node N2, a potential of the second node N2 (i.e. the first electrode of the third transistor T3): Vg = ELVDD, and at at this time, a gate-source voltage of the third transistor T3: Vgs = ELVDD-Vofs, a storage voltage of the first capacitor C1: V_{cs} = ELVDD-Vofs, and a potential of the third transistor T3: Vd = Vg + Vth. Here, ELVDD-V_{ofs} > |Vth|, and Vth is a threshold voltage of the third transistor T3.

A second stage A2 may be referred to as a self-discharge stage. The signal of the fourth scan signal line S3 is a high level signal, and the second transistor T4 is turned on. The signal of the first scan signal line S13 changes from a low level signal to a high level signal, so that the first transistor T1 is turned off firstly, and the first node N1 is floated. Subsequently, the signal of the second scan signal line S2 changes from a low level signal to a high level signal, so that the second transistor T2 is turned off, the second node N2 forms a loop through the turned on third transistor T3, the third node N3, and the turned on fourth transistor T4, and starts discharging, and the potential of the second node N2 decreases. Since the first node N1 is floated, a voltage difference across the first capacitor C1 does not change, and thus the potential of the first node N1 decreases as the potential of the second node N2 decreases. Since the gate-source voltage Vgs of the third transistor T3 remains unchanged due to a back-gate effect of the third transistor T3, an equivalent threshold voltage |V_{th_EF}| of the third transistor T3 gradually increases as the potential of the second node N2 decreases, and the equivalent threshold voltage of the third transistor T3: |V_{th_EF}| = α (ELVDD-Vs) + |Vth|, where α is a back-gate coefficient. When the equivalent threshold voltage |V_{th_EF}| of the third transistor T3 is increased to the gate-source voltage Vgs of the third transistor T3, the third transistor T3 is turned off, and the second node N2 stops discharging.

A third stage A3 may be referred to as a data write stage or a threshold compensation stage. The signal of the second scan signal line S2 is a high level signal, and the second transistor T2 is continuously turned off. The signal of the third scan signal line S3 is a high level signal, and the second transistor T4 is continuously turned on. The signal of the first scan signal line S13 changes from a high level signal to a low level signal, so that the first transistor T1 is turned on. The first transistor T1 is turned on, so that the data voltage Vdata output from the data signal line DATA is written to the first node N1, and the potential of the first node N1 changes from Vofs to Vdata. Since the second node N2 is floated, threshold compensation can be achieved at this stage.

A fourth stage A4 may be referred to as a light emission stage. The signals of the second scan signal line S2 and the third scan signal line S3 are low level signals, and the signal of the first scan signal line S1 is a high level signal, so that the second transistor T2 is turned on, and the first transistor T1 and the fourth transistor T4 are turned off. The second transistor T2 is turned on, so that a power supply voltage output from the first power supply line VDD provides a drive voltage to a first electrode of the light emitting device EL through the second transistor T2 and the third transistor T3 which are turned on, to drive the light emitting device EL to emit light.

During the light emission stage, a drive current of the third transistor T3 is not affected by the threshold voltage of the third transistor T3, influence of the threshold voltage of the third transistor T3 on the drive current is eliminated, a display brightness of the display product is ensured to be uniform, and a display effect of the entire display product is improved.

An exemplary embodiment of the present disclosure provides a display substrate including a display area and a non-display area. The display area includes a plurality of sub-pixels forming a plurality of pixel rows and a plurality of pixel columns, at least one sub-pixel including a pixel drive circuit and at least one scan signal line, and the scan signal line is configured to provide a scan signal to the pixel drive circuit. The non-display area includes a plurality of cascaded gate drive circuits, at least one gate drive circuit is connected to a scan signal line in a pixel row in the display area. The at least one gate drive circuit includes a shift register circuit configured to generate a timing with row by row shift according to a timing signal, a logical transition unit configured to generate a target timing by a logic operation, a level shifter configured to perform voltage domain conversion on the target timing, and a line driver (row drive enhancer) configured to enhance the converted signal which are disposed sequentially in a direction close to the display area. The shift register circuit includes at least a plurality of transistor groups disposed sequentially in a first direction, and at least one transistor group includes P-type transistors and N-type transistors disposed on a side of the P-type transistors in a second direction, and the first direction and the second direction intersect with each other. A P-type transistor includes at least a P-type active region, an N-type transistor includes at least an N-type active region, and a gap region is between the P-type active region and the N-type active region in the second direction. The gap region has a gap centerline, and the gap centerline is a straight line bisecting the gap region in the second direction and extending in the first direction. The plurality of transistor groups form at least one transmission gate, at least one NAND gate, and at least one inverter, and gap centerlines of the transistor groups in the at least one transmission gate, the at least one NAND gate, and the at least one inverter are on a same straight line extending in the first direction.

In an exemplary implementation, the plurality of transistor groups form a first transmission gate, a first NAND gate, a third inverter, a second transmission gate, a third transmission gate, a second NAND gate, a fourth inverter, a second inverter, and a first inverter disposed sequentially in the direction close to the display area. Widths of gap regions of transistor groups in a same type of devices are the same, gap centerlines of transistor groups in the same type of devices are on a same straight line extending in the first direction, and the widths of the gap regions are dimensions in the second direction.

In an exemplary implementation, P-type transistors in the same type of devices have a same width-to-length ratio, and N-type transistors in the same type of devices have a same width-to-length ratio.

In an exemplary implementation, in at least one of the first inverter, the second inverter, the third inverter, and the fourth inverter, a ratio of a width-to-length ratio of P-type transistors to a width-to-length ratio of N-type transistors is greater than 1 and less than 3.

In an exemplary implementation, a ratio of a width-to-length ratio of P-type transistors to a width-to-length ratio of N-type transistors in the first NAND gate is greater than a ratio of a width-to-length ratio of P-type transistors to a width-to-length ratio of N-type transistors in the first inverter, and the ratio of the width-to-length ratio of the P-type transistors to the width-to-length ratio of the N-type transistors in the first inverter is greater than a ratio of width-to-length ratio of P-type transistors to a width-to-length ratio of N-type transistors in the first transmission gate.

In an exemplary implementation, the shift register circuit further includes a power supply active region disposed on a side of the P-type active region away from the N-type active region and a ground active region disposed on a side of the N-type active region away from the P-type active region. The power supply active region has a first centerline, and the ground active region has a second centerline. The first centerline is a straight line bisecting the power supply active region in the second direction and extending in the first direction, the second centerline is a straight line bisecting the ground active region in the second direction and extending in the first direction, and a distance between the first centerline and the second centerline in the second direction is less than or equal to 6.3 µm.

In an exemplary implementation, in at least one transistor group, the P-type transistor includes at least a P-type active region, and the N-type transistor includes at least an N-type active region. There is a first width between the first centerline and an edge of the P-type active region close to the first centerline, and there is a second width between the second centerline and an edge of the N-type active region close to the second centerline. The first width may be greater than 1 µm and less than 3 µm, the second width may be greater than 1 µm and less than 3 µm, and the first width and the second width are dimensions in the second direction.

In an exemplary implementation, in at least one transistor group, there is a third width between an edge of the P-type active region away from the first centerline and an edge of the N-type active region away from the second centerline, the third width is greater than or equal to 1.5 µm, and the third width is a dimension in the second direction.

In an exemplary implementation, there is a P-type active region width between an edge of the P-type active region close to the first centerline and the edge of the P-type active region away from the first centerline. There is an N-type active region width between an edge of the N-type active region close to the second centerline and the edge of the N-type active region away from the second centerline. The P-type active region width may be greater than 1 µm and less than 3 µm, the N-type active region width may be greater than 1 µm and less than 3 µm, and the P-type active region width and the N-type active region width are dimensions in the second direction.

The technical solutions of the display substrate in accordance with the present disclosure will be described below through exemplary embodiments.

FIG. 6 is a schematic diagram of a structure of a gate drive circuit according to an exemplary embodiment of the present disclosure. In an exemplary implementation, the gate drivers may be disposed in the non-display area, may be located on one side of the pixel row direction of the display area, or may be located on two sides of the pixel row direction of the display area, respectively. The gate drivers may each include a plurality of cascaded gate drive circuits, and at least one gate drive circuit is connected to a scan signal line in one pixel row in the display area and provides a scan signal to the connected scan signal line. When the gate drivers are disposed on the two sides of the pixel row direction of the display area, the scan signal lines in the pixel rows are driven by two gate drive circuits to form a bilateral drive structure, which can ensure drive capability of high pixel density and avoid distortion of a drive signal. As shown in FIG. 6, a gate drive circuit may include a shift register circuit 100, a logical transition unit 200, a level shifter 300, and a line driver 400.

In an exemplary implementation, the shift register circuit 100 may be a shift register circuit composed of triggers (D Flip Flops). The shift register circuit 100 is connected to the display drive circuit, and receives the timing signal generated by the display drive circuit. The timing signal may include a start signal STV and a clock signal CKV, and the shift register circuit 100 is configured to shift register the received timing signal to initially generate a timing that can be shifted row by row. The logical transition unit 200 is connected to the shift register circuit 100, and is configured to perform a logic operation on the shifted signal to generate a plurality of target timings with different waveforms. The level shifter 300 is connected to the logical transition unit 200, and is configured to perform voltage domain conversion on the target timings. The line driver 400 is connected to the level shifter 300, and is configured to enhance the converted signals, enhance an output capability, and output scan signals to the display area.

In an exemplary implementation, for a pixel drive circuit in the display area including the first scan signal line S1, the second scan signal line S2, and the third scan signal line S3, an output circuit composed of the level shifter 300 and the line driver 400 may include three output sub-circuits. One output sub-circuit is connected to the first scan signal line S1 of one pixel row in the display area and configured to output a first scan signal to the display area, another output sub-circuit is connected to the second scan signal line S2 of one pixel row in the display area and configured to output a second scan signal to the display area, and a third output sub-circuit is connected to the third scan signal line S3 of one pixel row in the display area and configured to output a third scan signal to the display area.

In an exemplary implementation, the first scan signal may be referred to as a write switch (WS) signal, and is configured to control turn on and turn off of the first transistor T1 in the pixel drive circuit. The second scan signal may be referred to as a display switch (DS) signal, and is configured to control the turn on and turn off of the second transistor T2 in the pixel drive circuit. The third scan signal may be referred to as a display reset (auto zero, AZ) signal, and is configured to control the turn on and turn off of the fourth transistor T4 in the pixel drive circuit.

In an exemplary embodiment, the signals such as the start signal and the clock signal are output by the display drive circuit, voltage domain thereof is inconsistent with a voltage domain of the pixel drive circuit, and a required voltage (0 V to -2 V & -5 V) is introduced through the conversion by the level shifter, so that an voltage of the output gate drive signal can be ensured to match the pixel drive circuit.

In an exemplary implementation, the start signal STV may be referred to as a frame start signal, with a period being one frame. The clock signal CKV may be referred to as a row drive clock signal, with a period being one row.

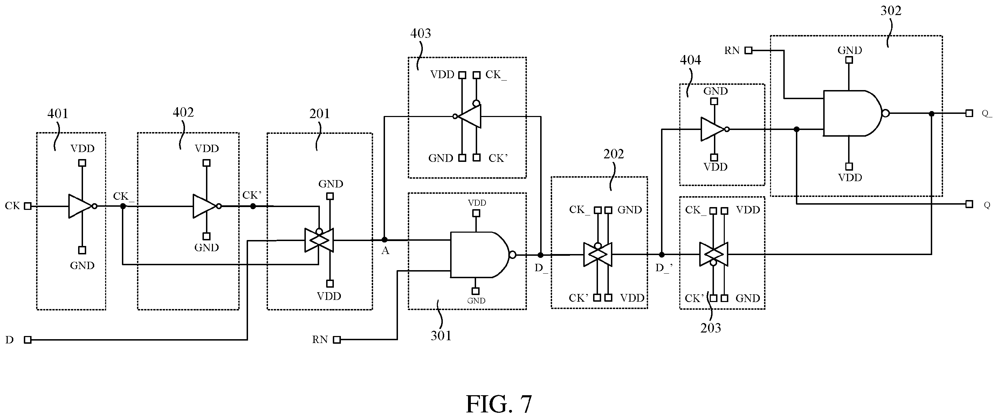

FIG. 7 is a working principle diagram of a shift register according to an exemplary embodiment of the present disclosure. The shift register circuit may be a shift register circuit composed of D flip flops, and may include 9 parts. The 9 parts are respectively three transmission gates (TG), four inverters (INVX) and two NAND gates (NANDs), and an inverter may also be referred to as a NOT gate (NOT gate). As shown in FIG. 7, the shift register circuit may include a first transmission gate 201, a second transmission gate 202, a third transmission gate 203, a first NAND gate 301, a second NAND gate 302, a first inverter 401, a second inverter 402, a third inverter 403, and a fourth inverter 404.

In an exemplary implementation, an input terminal of the first inverter 401 is connected to a clock signal terminal CK of the shift register circuit, and an output terminal of the first inverter 401 is connected to a first node CK_. An input terminal of the second inverter 402 is connected to the first node CK_, and an output terminal of the second inverter 402 is connected to a second node CK'. A first terminal of the first transmission gate 201 is connected to an input terminal D of the shift register circuit, a second terminal of the first transmission gate 201 is respectively connected to an output terminal of the third inverter 403 and a first input terminal of the first NAND gate 301, a high-level active enable terminal of the first transmission gate 201 is connected to the first node CK_, and a low-level active enable terminal of the first transmission gate 201 is connected to the second node CK'. A second input terminal of the first NAND gate 301 is connected to a reset terminal RN of the shift register circuit, an output terminal of the first NAND gate 301 is respectively connected to an input terminal of the third inverter 403 and a first terminal of the second transmission gate 202. A high-level active enable terminal of the third inverter 403 is connected to the second node CK', and a low-level active enable terminal of the third inverter 403 is connected to the first node CK_. A second terminal of the second transmission gate 202 is respectively connected to an input terminal of the fourth inverter 404 and a first terminal of the third transmission gate 203, a high-level active enable terminal of the second transmission gate 202 is connected to the second node CK', and a low=level active enable terminal of the second transmission gate 202 is connected to the first node CK_. An output terminal of the fourth inverter 404 is connected to a first input terminal of the second NAND gate 302 and a first output terminal Q of the shift register circuit. A second terminal of the third transmission gate 203 is respectively connected to an output terminal of the second NAND gate 302 and a second output terminal Q_ of the shift register circuit, a high-active enable terminal of the third transmission gate 203 is connected to the first node CK_, and a low-active enable terminal of the third transmission gate 203 is connected to the second node CK'. A second input terminal of the second NAND gate 302 is connected to a reset terminal RN of the shift register circuit.

In an exemplary implementation, the shift register circuit is active at rising edges, and when each rising edge comes, its output maintains a state of D input in a previous stage, N is reset, and the shift register circuit is active at high level. The working principle of the shift register circuit is:
(1) When an input signal of the clock signal terminal CK of the shift register circuit is 0 and an input signal of the input terminal D of the shift register circuit is 0, the first transmission gate 201 is turned on, the second transmission gate 202 is turned off, the third transmission gate 203 is turned on, an output of the first output terminal Q of the shift register circuit is 0, and an output of the second output terminal Q_ of the shift register circuit is 1.
(2) When the input signal of the clock signal terminal CK of the shift register circuit is 1 and the input signal of the input terminal D of the shift register circuit is 0, the first transmission gate 201 is turned off, the second transmission gate 202 is turned on, the third transmission gate 203 is turned off, the output of the first output terminal Q of the shift register circuit is 0, and the output of the second output terminal Q_ of the shift register circuit is 1.
(3) When the input signal of the clock signal terminal CK of the shift register circuit is 0 and the input signal of the input terminal D of the shift register circuit is 1, the first transmission gate 201 is turned on, the second transmission gate 202 is turned off, the third transmission gate 203 is turned on, and the second transmission gate 202 is latched backward to maintain the output.
(4) When the input signal of the clock signal terminal CK of the shift register circuit is 1 and the input signal of the input terminal D of the shift register circuit is 0, the first transmission gate 201 is turned off, the second transmission gate 202 is turned on, the third transmission gate 203 is turned off, the output of the first output terminal Q of the shift register circuit is 0, and the output of the second output terminal Q_ of the shift register circuit is 1.
(5) When the input signal of the clock signal terminal CK of the shift register circuit is 0 and the input signal of the input terminal D of the shift register circuit is 1, the first transmission gate 201 is turned on, the second transmission gate 202 is turned off, the third transmission gate 203 is turned on, and the second transmission gate 202 is latched backward to maintain the output.
(6) When the input signal of the clock signal terminal CK of the shift register circuit is 1 and the input signal of the input terminal D of the shift register circuit is 0, the first transmission gate 201 is turned off, the second transmission gate 202 is turned on, the third transmission gate 203 is turned off, and the first output terminal Q of the shift register circuit outputs a high level.

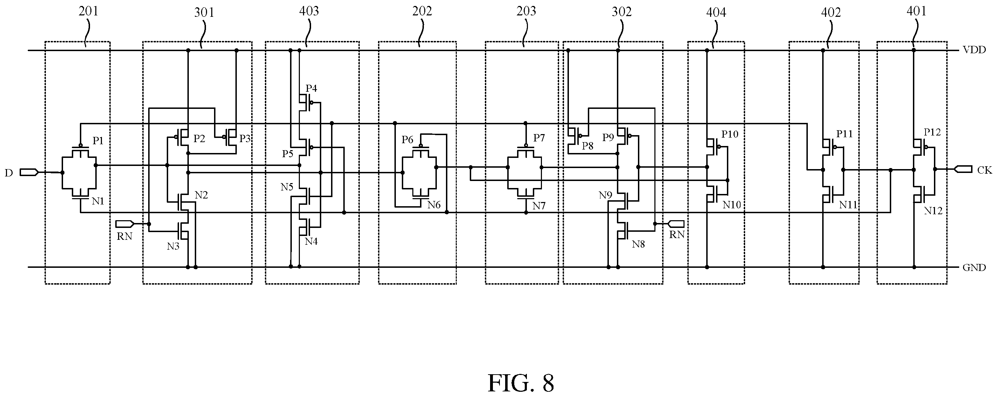

FIG. 8 is an equivalent circuit diagram of a shift register according to an exemplary embodiment of the present disclosure. As shown in FIG. 8, a shift register circuit of a gate drive circuit in a display substrate of an embodiment of the present disclosure may include 24 transistors. Among them, the first transmission gate 201, the second transmission gate 202, the third transmission gate 203, the first inverter 401, the second inverter 402, and the fourth inverter 404 each include one P-type transistor and one N-type transistor, and the first NAND gate 301, the second NAND gate 302, and the third inverter 403 each include two P-type transistors and two N-type transistors.

In an exemplary implementation, the first transmission gate 201, the first NAND gate 301, the third inverter 403, the second transmission gate 202, the third transmission gate 203, the second NAND gate 302, the fourth inverter 404, the second inverter 402, and the first inverter 401 may be disposed sequentially in a first direction X (a direction close to the display area).

In an exemplary implementation, the first transmission gate 201 is composed of a first P-type transistor P1 and a first N-type transistor N1. A gate electrode of the first P-type transistor P1 is respectively connected to a gate electrode of a fifth N-type transistor N5, a gate electrode of a sixth N-type transistor N6, a gate electrode of a seventh P-type transistor P7, a second electrode of an eleventh P-type transistor P11 and a second electrode of an eleventh N-type transistor N11. A gate electrode of the first N-type transistor N1 is respectively connected to a gate electrode of a fifth P-type transistor P5, a gate electrode of a sixth P-type transistor P6, a gate electrode of a seventh N-type transistor N7, a gate electrode of an eleventh P-type transistor P11, a gate electrode of an eleventh N-type transistor N11, a second electrode of a twelfth P-type transistor P12 and a second electrode of an twelfth N-type transistor N12. A first electrode of the first P-type transistor P1 and a first electrode of the first N-type transistor N1 are connected to each other, and are connected to the input terminal D of the shift register circuit. A second electrode of the first P-type transistor P1 and a second electrode of the first N-type transistor N1 are connected to each other, and are respectively connected to a gate electrode of a second P-type transistor P2, a gate electrode of a second N-type transistor N2, a second electrode of the fifth P-type transistor P5 and a second electrode of the fifth N-type transistor N5.

In an exemplary implementation, the first NAND gate 301 is composed of the second P-type transistor P2, a third P-type transistor P3, the second N-type transistor N2, and a third N-type transistor N3. The gate electrode of the second P-type transistor P2 and the gate electrode of the second N-type transistor N2 are connected to each other, and are respectively connected to the second electrode of the first P-type transistor P1, the second electrode of the first N-type transistor N1, the second electrode of the fifth P-type transistor P5 and the second electrode of the fifth N-type transistor N5. A gate electrode of the third P-type transistor P3 and a gate electrode of the third N-type transistor N3 are connected to each other, and are connected to the rest terminal RN. Both a first electrode of the second P-type transistor P2 and a first electrode of the third P-type transistor P3 are connected to a first power supply line VDD. A second electrode of the second P-type transistor P2 and a second electrode of the third P-type transistor P3 are connected to each other, and are respectively connected to a second electrode of the second N-type transistor N2, a gate electrode of a fourth P-type transistor P4, a gate electrode of the fourth N-type transistor N4, a first electrode of a sixth P-type transistor P6 and a first electrode of a sixth N-type transistor N6. A first electrode of the third N-type transistor N3 is connected to a ground line GNN, and a second electrode of the third N-type transistor N3 is connected to a first electrode of the second N-type transistor N2.

In an exemplary implementation, the third inverter 403 is composed of the fourth P-type transistor P4, the fifth P-type transistor P5, the fourth N-type transistor N4, and the fifth N-type transistor N5. A gate electrode of the fourth P-type transistor P4 and the gate electrode of the fourth N-type transistor N4 are connected to each other, and are respectively connected to the second electrode of the second P-type transistor P2, the second electrode of the second N-type transistor N2, the second electrode of the third P-type transistor P3, a first electrode of the sixth P-type transistor P6 and a first electrode of the sixth N-type transistor N6. A gate electrode of the fifth P-type transistor P5 is respectively connected to a gate electrode of the first N-type transistor N1, a gate electrode of the sixth P-type transistor P6, a gate electrode of the seventh N-type transistor N7, a gate electrode of the eleventh P-type transistor P11, a gate electrode of the eleventh N-type transistor N11, a second electrode of the twelfth P-type transistor P12 and a second electrode of the twelfth N-type transistor N12. A gate electrode of the fifth N-type transistor N5 is respectively connected to the gate electrode of the first P-type transistor P1, a gate electrode of the sixth N-type transistor N6, a gate electrode of the seventh P-type transistor P7, a second electrode of the eleventh P-type transistor P11 and a second electrode of the eleventh N-type transistor N11. A first electrode of the fourth P-type transistor P4 is connected to the first power supply line VDD, and a second electrode of the fourth P-type transistor P4 is connected to a first electrode of the fifth P-type transistor P5. A first electrode of the fourth N-type transistor N4 is connected to the ground line GND, and a second electrode of the fourth N-type transistor N4 is connected to a first electrode of the fifth N-type transistor N5. The second electrode of the fifth P-type transistor P5 and the second electrode of the fifth N-type transistor N5 are connected to each other, and are respectively connected to the second electrode of the first P-type transistor P1, the second electrode of the first N-type transistor N1, the gate electrode of the second P-type transistor P2, and the gate electrode of the second N-type transistor N2.

In an exemplary implementation, the second transmission gate 202 is composed of the sixth P-type transistor P6 and the sixth N-type transistor N6. The gate electrode of the sixth P-type transistor P6 is respectively connected to the gate electrode of the first N-type transistor N1, the gate electrode of the fifth P-type transistor P5, the gate electrode of the seventh N-type transistor N7, the gate electrode of the eleventh P-type transistor P11, the gate electrode of the eleventh N-type transistor N11, the second electrode of the twelfth P-type transistor P12 and a second electrode of the twelfth N-type transistor N12. The gate electrode of the sixth N-type transistor N6 is respectively connected to the gate electrode of the first P-type transistor P1, the gate electrode of the fifth N-type transistor N5, the gate electrode of the seventh P-type transistor P7, the second electrode of the eleventh P-type transistor P11 and the second electrode of the eleventh N-type transistor N11. The first electrode of the sixth P-type transistor P6 and the first electrode of the sixth N-type transistor N6 are connected to each other, and are respectively connected to the second electrode of the second P-type transistor P2, the second electrode of the third P-type transistor P3, the second electrode of the second N-type transistor N2, the gate electrode of the fourth P-type transistor P4 and the gate electrode of the fourth N-type transistor N4. A second electrode of the sixth P-type transistor P6 and a second electrode of the sixth N-type transistor N6 are connected to each other, and are respectively connected to a first electrode of the seventh P-type transistor P7, a first electrode of the seventh N-type transistor N7, a gate electrode of a tenth P-type transistor P10 and a gate electrode of a tenth N-type transistor N10.

In an exemplary implementation, the third transmission gate 203 is composed of the seventh P-type transistor P7 and the seventh N-type transistor N7. The gate electrode of the seventh P-type transistor P7 is respectively connected to the gate electrode of the first P-type transistor P1, the gate electrode of the fifth N-type transistor N5, the gate electrode of the sixth N-type transistor N6, the second electrode of the eleventh P-type transistor P11 and the second electrode of the eleventh N-type transistor N11. The gate electrode of the seventh N-type transistor N7 is respectively connected to the gate electrode of the first N-type transistor N1, the gate electrode of the fifth P-type transistor P5, the gate electrode of the sixth P-type transistor P6, the gate electrode of the eleventh P-type transistor P11, the gate electrode of the eleventh N-type transistor N11, the second electrode of the twelfth P-type transistor P12 and the second electrode of the twelfth N-type transistor N12. The first electrode of the seventh P-type transistor P7 and the first electrode of the seventh N-type transistor N7 are connected to each other, and are respectively connected to the second electrode of the sixth P-type transistor P6, the second electrode of the sixth N-type transistor N6, a gate electrode of the tenth P-type transistor P10 and a gate electrode of the tenth N-type transistor N10. A second electrode of the seventh P-type transistor P7 and a second electrode of the seventh N-type transistor N7 are connected to each other, and are respectively connected to a second electrode of an eighth P-type transistor P8, a second electrode of a ninth P-type transistor P9 and a second electrode of a ninth N-type transistor N9.

In an exemplary implementation, the second NAND gate 302 is composed of the eighth P-type transistor P8, the ninth P-type transistor P9, an eighth N-type transistor N8, and the ninth N-type transistor N9. A gate electrode of the eighth P-type transistor P8 and a gate electrode of the eighth N-type transistor N8 are connected to each other, and are connected to the reset terminal RN of the shift register circuit. A gate electrode of the ninth P-type transistor P9 and a gate electrode of the ninth N-type transistor N9 are connected to each other, and are respectively connected to a second electrode of the tenth P-type transistor P10 and a second electrode of the tenth N-type transistor N10. Both a first electrode of the eighth P-type transistor P8 and a first electrode of the ninth P-type transistor P9 are connected to the first power supply line VDD. A second electrode of the eighth P-type transistor P8 and a second electrode of the ninth P-type transistor P9 are connected to each other, and are respectively connected to a second electrode of the ninth N-type transistor N9, a second electrode of the seventh P-type transistor P7 and the second electrode of the seventh N-type transistor N7. A first electrode of the eighth N-type transistor N8 is connected to the ground line GND, and a second electrode of the eighth N-type transistor N8 is connected to a first electrode of the ninth P-type transistor P9.

In an exemplary implementation, the fourth inverter 404 is composed of the tenth P-type transistor P10 and the tenth N-type transistor N10. The gate electrode of the tenth P-type transistor P10 and the gate electrode of the tenth N-type transistor N10 are connected to each other, and are respectively connected to the second electrode of the sixth P-type transistor P6, the second electrode of the sixth N-type transistor N6, the first electrode of the seventh P-type transistor P7 and the first electrode of the seventh N-type transistor N7. A first electrode of the tenth P-type transistor P10 is connected to the first power supply line VDD. A first electrode of the tenth N-type transistor N10 is connected to the ground line GND. The second electrode of the tenth P-type transistor P10 and the second electrode of the tenth N-type transistor N10 are connected to each other, and are respectively connected to the gate electrode of the ninth P-type transistor P9 and the gate electrode of the ninth N-type transistor N9.

In an exemplary implementation, the second inverter 402 is composed of the eleventh P-type transistor P11 and the eleventh N-type transistor N11. The gate electrode of the eleventh P-type transistor P11 and the gate electrode of the eleventh N-type transistor N11 are connected to each other, and are respectively connected to the gate electrode of the first N-type transistor N1, the gate electrode of the fifth P-type transistor P5, the gate electrode of the sixth P-type transistor P6, the gate electrode of the seventh N-type transistor N7, the second electrode of the twelfth P-type transistor P12 and a second electrode of the twelfth P-type transistor N12. A first electrode of the eleventh P-type transistor P11 is connected to the first power supply line VDD, and a first electrode of the eleventh N-type transistor N11 is connected to the ground line GND. The second electrode of the eleventh P-type transistor P11 and the second electrode of the eleventh N-type transistor N11 are connected to each other, and are respectively connected to the gate electrode of the first P-type transistor P1, the gate electrode of the fifth N-type transistor N5, the gate electrode of the sixth N-type transistor N6 and the gate electrode of the seventh P-type transistor P7.

In an exemplary implementation, the first inverter 401 is composed of the twelfth P-type transistor P12 and the twelfth N-type transistor N12. A gate electrode of the twelfth P-type transistor P12 and a gate electrode of the twelfth N-type transistor N12 are connected to each other, and are connected to the clock signal terminal CK of the shift register circuit. A first electrode of the twelfth P-type transistor P12 is connected to the first power supply line VDD, and a first electrode of the twelfth N-type transistor N12 is connected to the ground line GND. The second electrode of the twelfth P-type transistor P12 and the second electrode of the twelfth N-type transistor N12 are connected to each other, and are respectively connected to the gate electrode of the first N-type transistor N1, the gate electrode of the fifth P-type transistor P5, the gate electrode of the sixth P-type transistor P6, the gate electrode of the seventh N-type transistor N7, the gate electrode of the eleventh P-type transistor P11 and the gate electrode of the eleventh N-type transistor N11.

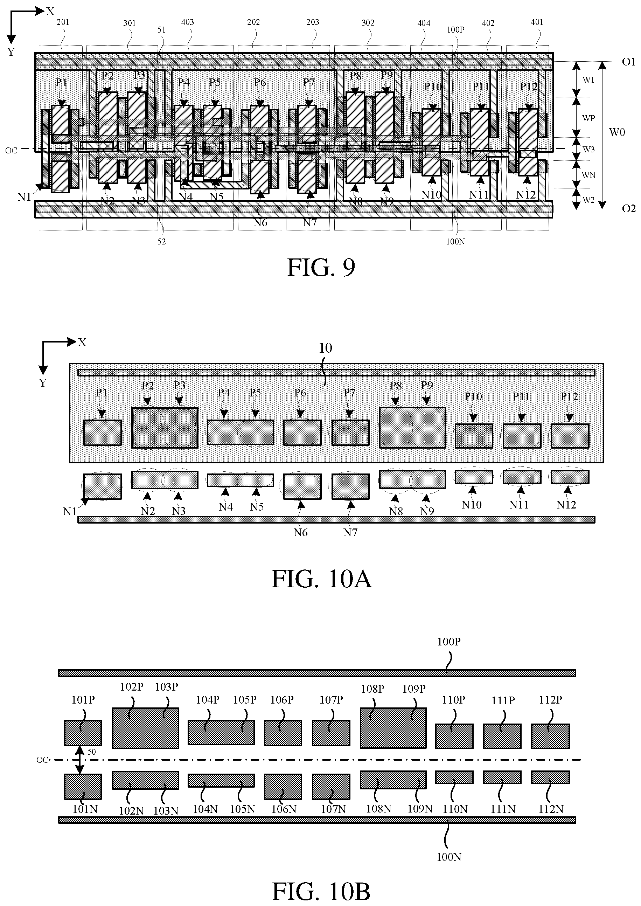

FIG. 9 is a schematic diagram of a structure of a shift register circuit according to an exemplary embodiment of the present disclosure. In an exemplary implementation, a display substrate of an exemplary embodiment of the present disclosure may include at least a display area and a non-display area. The display area may include a plurality of sub-pixels forming a plurality of pixel rows and a plurality of pixel columns. At least one sub-pixel includes a pixel drive circuit and at least one scan signal line, and the scan signal line is configured to provide a scan signal to a connected pixel drive circuit. The non-display area may include a plurality of cascaded gate drive circuits, and at least one gate drive circuit is connected to a scan signal line in one pixel row in the display area. At least one gate drive circuit may include a shift register circuit, a logical transition unit, a level shifter, and a line driver disposed on a silicon substrate. The shift register circuit is configured to generate a timing with row by row shift according to a timing signal, the logical transition unit is configured to generate a target timing by a logic operation, the level shifter configured to perform voltage domain conversion on the target timing, and the line driver configured to enhance the converted signal before outputting to a scan signal line in the display area.

As shown in FIG. 9, the shift register circuit may include a plurality of transistor groups sequentially disposed in a first direction X (a pixel row direction in the display area), and at least one transistor group may include P-type transistors and N-type transistors disposed on one side of the P-type transistors in a second direction Y (a pixel column direction in the display area), wherein the first direction X and the second direction Y intersect.

In an exemplary implementation, a P-type transistor may include at least a P-type active region, and an N-type transistor may include at least an N-type active region. There is a gap region 50 between the P-type active region and the N-type active region in the second direction Y, the gap region 50 has a gap centerline OC, and the gap centerline OC may be a straight line bisecting the gap region 50 in the second direction Y and extending in the first direction X.

In an exemplary implementation, the plurality of transistor groups may form at least one transmission gate, at least one NAND gate, and at least one inverter, and gap centerlines OC of the transistor groups in the at least one transmission gate, the at least one NAND gate, and the at least one inverter may be on a same straight line extending in the first direction X.

In an exemplary implementation, the plurality of transistor groups form a first transmission gate 201, a first NAND gate 301, a third inverter 403, a second transmission gate 202, a third transmission gate 203, a second NAND gate 302, a fourth inverter 404, a second inverter 402, and a first inverter 401, which are sequentially disposed in the direction close to the display area. Widths of gap regions of the transistor groups in a same type of devices may be substantially the same, gap center lines of the transistor groups in the same type of devices may be substantially on a same straight line extending in the first direction X, and the widths of the gap regions may be dimensions in the second direction Y.

In an exemplary implementation, the first transmission gate 201 may include a first P-type transistor P1 and a second P-type transistor P2. The first NAND gate 301 may include a second P-type transistor P2, a third P-type transistor P3, a second N-type transistor N2, and a third N-type transistor N3. The third inverter 403 may include a fourth P-type transistor P4, a fifth P-type transistor P5, a fourth N-type transistor N4, and a fifth N-type transistor N5. The second transmission gate 202 may include a sixth P-type transistor P6, and a sixth N-type transistor N6. The third transmission gate 203 may include a seventh P-type transistor P7, and a seventh N-type transistor N7. The second NAND gate 302 may include an eighth P-type transistor P8, a ninth P-type transistor P9, an eighth N-type transistor N8, and a ninth N-type transistor N9. The fourth inverter 404 may include a tenth P-type transistor P10, and a tenth N-type transistor N10. The second inverter 402 may include an eleventh P-type transistor P11, and an eleventh N-type transistor N11. The first inverter 401 may include a twelfth P-type transistor P12, and a twelfth N-type transistor N12.

In an exemplary implementation, in the at least one transistor group, a P-type transistor may include a P-type gate electrode, a P-type active region, a P-type source electrode (first electrode), and a P-type drain electrode (second electrode). The P-type source electrode is connected to a first region of the P-type active region through a via and the P-type drain electrode is connected to a second region of the P-type active region through a via. An N-type transistor may include an N-type gate electrode, an N-type active region, an N-type source electrode (first electrode) and an N-type drain electrode (second electrode). The N-type source electrode is connected to a first region of the N-type active region through a via, and the N-type drain electrode is connected to a second region of the N-type active region through a via.

In an exemplary implementation, the shift register circuit may further include a power supply active region 100P, a ground active region 100N, a first power supply line 51, and a ground line 52. Shapes of the power supply active region 100P and the first power supply line 51 may be a straight line or a polyline extending in the first direction X, may be located on a side of the plurality of transistor groups in a direction opposite to the second direction Y, and the first power supply line 51 may be connected to the power supply active region 100P through a plurality of vias. Shapes of the ground active region 100N and the ground line 52 may be a straight line or a polyline extending in the first direction X, may be located on one side of the plurality of transistor groups in the second direction Y, and the ground line 52 may be connected to the ground active region 100N through a plurality of vias.

In an exemplary implementation, the power supply active region 100P and the ground active region 100N may be disposed in a same layer as the P-type active region and the N-type active region, and the first power supply line 51 and the ground line 52 may be disposed in a same layer as the P-type source electrode, the P-type drain electrode, the N-type source electrode, and the N-type drain electrode.

In an exemplary implementation, the shift register circuit has a circuit width WO. The circuit width WO may be a distance between a first center line O1 and a second center line O2, and may be a dimension in the second direction Y. In an exemplary implementation, the first center line O1 may be a straight line bisecting the power supply active region 100P in the second direction Y and extending in the first direction X, and the second center line O2 may be a straight line bisecting the ground active region 100N in the second direction Y and extending in the first direction X.

In an exemplary implementation, the circuit width WO may be less than or equal to a width of a pixel row in the display area.

In an exemplary implementation, the circuit width WO may be less than or equal to 6.3 µm, so that a width of the gate drive circuit and a width of a sub-pixel in the pixel region are substantially consistent, to meet a display requirement of a pixel density of 4000.

In an exemplary implementation, in at least one transistor group, there is a first width W1 between an edge of the P-type active region of the P-type transistor close to the first center line O1 and the first center line O1, there is a second width W2 between an edge of the N-type active region of the N-type transistor close to the second center line O2 and the second center line O2, and there is a third width W3 between an edge of the P-type active region away from the first center line O1 and an edge of the N-type active region away from the second center line O2. The first width W1, the second width W2, and the third width W3 may be dimensions in the second direction Y.

In an exemplary implementation, the first width W1 may be greater than or equal to 0.2 µm.

In an exemplary implementation, the second width W2 may be greater than or equal to 0.2 µm.

In an exemplary implementation, the third width W3 may be greater than or equal to 1.5µm.

In an exemplary implementation, in at least one transistor group, there is a P-type active region width WP between the edge of the P-type active region close to the first center line O1 and the edge of the P-type active region away from the first center line O1, and the P-type active region width WP is a P-type channel width of the P-type transistor, which may be a dimension in the second direction Y. There is an N-type active region width WN between the edge of the N-type active region close to the second center line O2 and the edge of the N-type active region away from the second center line O2, that is, the N-type active region width WN is an N-type channel width of the N-type transistor, which may be a dimension in the second direction Y.

In an exemplary implementation, the P-type active region width WP may be greater than 0.556 µm, and the N-type active region width WN may be greater than 0.556 µm.

In an exemplary implementation, the circuit width WO may be a sum of the first width W1, the P-type active region width WP, the third width W3, the N-type active region width WN, and the second width W2.

In an exemplary implementation, in at least one transistor group, a width-to-length ratio of a P-type transistor may be larger than a width-to-length ratio of an N-type transistor.

In an exemplary implementation, a ratio of the width-to-length ratio of the P-type transistor to the width-to-length ratio of the N-type transistor may be greater than 1 and less than 3.

A manufacturing process of the display substrate will be described below by way of example. A "patterning process" mentioned in the present disclosure includes a treatment such as deposition of a film layer, photoresist coating on a film layer, mask exposure, development, etching, and photoresist stripping for a metal material, an inorganic material, or a transparent conductive material, and includes a treatment such as organic material coating, mask exposure, and development for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a certain material on a base substrate using deposition, coating, or other processes. If the "thin film" does not need to be processed through a patterning process in the entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process. "A and B being disposed on the same layer" mentioned in the present disclosure means that A and B are formed simultaneously through the same running of the patterning process, and the "thickness" of the film layer is the dimension of the film layer in a direction perpendicular to the display substrate. In an exemplary implementation of the present disclosure, "an orthographic projection of B being within a range of an orthographic projection of A" or "an orthographic projection of A containing an orthographic projection of B" means that a boundary of the orthographic projection of B falls within a range of a boundary of the orthographic projection of A, or the boundary of the orthographic projection of A is overlapped with the boundary of the orthographic projection of B.

In an exemplary implementation, the manufacturing process of the display substrate may include the following steps.
(1) A silicon substrate is provided. In an exemplary implementation, the silicon substrate may be a P-type silicon substrate. In an exemplary implementation, the P-type silicon substrate may serve as a channel region of an N-type transistor.

In some possible exemplary implementations, the silicon substrate may be made of an N-type silicon material which serves as a channel region of a P-type transistor, and the present disclosure is not limited thereto.

(2) Patterns of an N type well (NW) area and an Active Area (AA) are sequentially formed. In an exemplary implementation, the pattern of the N-well area 10 may be formed on the P-type silicon substrate by the following: forming a photoresist pattern including an opening region by coating a photoresist on a P-type silicon substrate, exposure and development, removing the photoresist in the opening region to expose a surface of the P-type silicon substrate, implanting N-type doped ions in the opening region by ion implantation, and peeling off the remaining photoresist. Subsequently, the pattern of the active region is formed on the silicon substrate on which the aforementioned pattern is formed, as shown in FIGS. 10A and 10B, and FIG. 10B is a schematic diagram of the active area in FIG. 10A.

In an exemplary implementation, the N-well area 10 is configured to form P-type transistors and P-type devices, and a region other than the N-well area 10 is configured to form N-type transistors and N-type devices.

In an exemplary implementation, phosphorus or arsenic plasma implants may be used for n-type doping ions, and a depth and doping concentration of ion implantation may be achieved by controlling implantation energy and dose. A process of forming the N-well area may further include a process such as annealing to allow the ion implant to diffuse in the P-type silicon substrate, to form a stable N-well structure.

In an exemplary implementation, the pattern of the active area may include at least a first P-type active region 101P to a twelfth P-type active region 112P, a first N-type active region 101N to a twelfth N-type active region 112N, a power supply active region 100P, and a ground active region 100N.

In an exemplary implementation, the first P-type active region 101P may be located within an area where the N-well area 10 is located, and an orthographic projection of the first P-type active region 101P on the silicon substrate is within a range of an orthographic projection of the N-well area 10 on the silicon substrate. A shape of the first P-type active region 101P may be a strip extending in the first direction X, and the first P-type active region 101P may serve as an active region of a first P-type transistor P1.

In an exemplary implementation, the first N-type active region 101N may be located outside the area where the N-well area 10 is located, and an orthographic projection of the first N-type active region 101N on the silicon substrate is not overlapped with the orthographic projection of the N-well area 10 on the silicon substrate. A shape of the first N-type active region 101N may be a strip extending in the first direction X, located on a side of the first P-type active region 101P in the second direction Y, and the first N-type active region 101N may serve as an active region of a first N-type transistor N1.

In an exemplary implementation, a second P-type active region 102P may be located within the area where the N-well area 10 is located, and an orthographic projection of the second P-type active region 102P on the silicon substrate is within the range of the orthographic projection of the N-well area 10 on the silicon substrate. A shape of the second P-type active region 102P may be a strip extending in the first direction X, and the second P-type active region 102P may serve as an active region of a second P-type transistor P2.

In an exemplary implementation, a second N-type active region 102N may be located outside the area where the N-well area 10 is located, and an orthographic projection of the second N-type active region 102N on the silicon substrate is not overlapped with the orthographic projection of the N-well area 10 on the silicon substrate. A shape of the second N-type active region 102N may be a strip extending in the first direction X, located on a side of the second P-type active region 102P in the second direction Y, and the second N-type active region 102N may serve as an active region of a second N-type transistor N2.

In an exemplary implementation, a third P-type active region 103P may be located within the area where the N-well area 10 is located, and an orthographic projection of the third P-type active region 103P on the silicon substrate is within the range of the orthographic projection of the N-well area 10 on the silicon substrate. A shape of the third P-type active region 103P may be a strip extending in the first direction X, and the third P-type active region 103P may serve as an active region of a third P-type transistor P3.

In an exemplary implementation, the second P-type active region 102P and the third P-type active region 103P may be interconnected into an integral structure.

In an exemplary implementation, a third N-type active region 103N may be located outside the area where the N-well area 10 is located, and an orthographic projection of the third N-type active region 103N on the silicon substrate is not overlapped with the orthographic projection of the N-well area 10 on the silicon substrate. A shape of the third N-type active region 103N may be a strip extending in the first direction X, located on a side of the third P-type active region 103P in the second direction Y, and the third N-type active region 103N may serve as an active region of a third N-type transistor N3.

In an exemplary implementation, the second N-type active region 102N and the third N-type active region 103N may be interconnected into an integral structure.

In an exemplary implementation, a fourth P-type active region 104P may be located within the area where the N-well area 10 is located, and an orthographic projection of the fourth P-type active region 104P on the silicon substrate is within the range of the orthographic projection of the N-well area 10 on the silicon substrate. A shape of the fourth P-type active region 104P may be a strip extending in the first direction X, and the fourth P-type active region 104P may serve as an active region of a fourth P-type transistor P4.

In an exemplary implementation, a fourth N-type active region 104N may be located outside the area where the N-well area 10 is located, and an orthographic projection of the fourth N-type active region 104N on the silicon substrate is not overlapped with the orthographic projection of the N-well area 10 on the silicon substrate. A shape of the fourth N-type active region 104N may be a strip extending in the first direction X, located on a side of the fourth P-type active region 104P in the second direction Y, and the fourth N-type active region 104N may serve as an active region of a fourth N-type transistor N4.

In an exemplary implementation, a fifth P-type active region 105P may be located within the area where the N-well area 10 is located, and an orthographic projection of the fifth P-type active region 105P on the silicon substrate is within the range of the orthographic projection of the N-well area 10 on the silicon substrate. A shape of the fifth P-type active region 105P may be a strip extending in the first direction X, and the fifth P-type active region 105P may serve as an active region of a fifth P-type transistor P5.

In an exemplary implementation, the fourth P-type active region 104P and the fifth P-type active region 105P may be interconnected into an integral structure.

In an exemplary implementation, a fifth N-type active region 105N may be located outside the area where the N-well area 10 is located, and an orthographic projection of the fifth N-type active region 105N on the silicon substrate is not overlapped with the orthographic projection of the N-well area 10 on the silicon substrate. A shape of the fifth N-type active region 105N may be a strip extending in the first direction X, located on a side of the fifth P-type active region 105P in the second direction Y, and the fifth N-type active region 105N may serve as an active region of a fifth N-type transistor N5.

In an exemplary implementation, the fourth N-type active region 104N and the fifth N-type active region 105N may be interconnected into an integral structure.

In an exemplary implementation, a sixth P-type active region 106P may be located within the area where the N-well area 10 is located, and an orthographic projection of the sixth P-type active region 106P on the silicon substrate is within the range of the orthographic projection of the N-well area 10 on the silicon substrate. A shape of the sixth P-type active region 106P may be a strip extending in the first direction X, and the sixth P-type active region 106P may serve as an active region of a sixth P-type transistor P6.

In an exemplary implementation, a sixth N-type active region 106N may be located outside the area where the N-well area 10 is located, and an orthographic projection of the sixth N-type active region 106N on the silicon substrate is not overlapped with the orthographic projection of the N-well area 10 on the silicon substrate. A shape of the sixth N-type active region 106N may be a strip extending in the first direction X, located on a side of the sixth P-type active region 106P in the second direction Y, and the sixth N-type active region 106N may serve as an active region of a sixth N-type transistor N6.

In an exemplary implementation, a seventh P-type active region 107P may be located within the area where the N-well area 10 is located, and an orthographic projection of the seventh P-type active region 107P on the silicon substrate is within the range of the orthographic projection of the N-well area 10 on the silicon substrate. A shape of the seventh P-type active region 107P may be a strip extending in the first direction X, and the seventh P-type active region 107P may serve as an active region of a seventh P-type transistor P7.

In an exemplary implementation, a seventh N-type active region 107N may be located outside the area where the N-well area 10 is located, and an orthographic projection of the seventh N-type active region 107N on the silicon substrate is not overlapped with the orthographic projection of the N-well area 10 on the silicon substrate. A shape of the seventh N-type active region 107N may be a strip extending in the first direction X, located on a side of the seventh P-type active region 107P in the second direction Y, and the seventh N-type active region 107N may serve as an active region of a seventh N-type transistor N7.

In an exemplary implementation, an eighth P-type active region 108P may be located within the area where the N-well area 10 is located, and an orthographic projection of the eighth P-type active region 108P on the silicon substrate is within the range of the orthographic projection of the N-well area 10 on the silicon substrate. A shape of the eighth P-type active region 108P may be a strip extending in the first direction X, and the eighth P-type active region 108P may serve as an active region of an eighth P-type transistor P8.

In an exemplary implementation, an eighth N-type active region 108N may be located outside the area where the N-well area 10 is located, and an orthographic projection of the eighth N-type active region 108N on the silicon substrate is not overlapped with the orthographic projection of the N-well area 10 on the silicon substrate. A shape of the eighth N-type active region 108N may be a strip extending in the first direction X, located on a side of the eighth P-type active region 108P in the second direction Y, and the eighth N-type active region 108N may serve as an active region of an eighth N-type transistor N8.

In an exemplary implementation, a ninth P-type active region 109P may be located within the area where the N-well area 10 is located, and an orthographic projection of the ninth P-type active region 109P on the silicon substrate is within the range of the orthographic projection of the N-well area 10 on the silicon substrate. A shape of the ninth P-type active region 109P may be a strip extending in the first direction X, and the ninth P-type active region 109P may serve as an active region of a ninth P-type transistor P9.

In an exemplary implementation, the eighth P-type active region 108P and the ninth P-type active region 109P may be interconnected into an integral structure.

In an exemplary implementation, a ninth N-type active region 109N may be located outside the area where the N-well area 10 is located, and an orthographic projection of the ninth N-type active region 109N on the silicon substrate is not overlapped with the orthographic projection of the N-well area 10 on the silicon substrate. A shape of the ninth N-type active region 109N may be a strip extending in the first direction X, located on a side of the ninth P-type active region 109P in the second direction Y, and the ninth N-type active region 109N may serve as an active region of a ninth N-type transistor N9.

In an exemplary implementation, the eighth N-type active region 108N and the ninth N-type active region 109N may be interconnected into an integral structure.

In an exemplary implementation, a tenth P-type active region 110P may be located within the area where the N-well area 10 is located, and an orthographic projection of the tenth P-type active region 110P on the silicon substrate is within the range of the orthographic projection of the N-well area 10 on the silicon substrate. A shape of the tenth P-type active region 110P may be a strip extending in the first direction X, and the tenth P-type active region 110P may serve as an active region of a tenth P-type transistor P10.

In an exemplary implementation, a tenth N-type active region 110N may be located outside the area where the N-well area 10 is located, and an orthographic projection of the tenth N-type active region 110N on the silicon substrate is not overlapped with the orthographic projection of the N-well area 10 on the silicon substrate. A shape of the tenth N-type active region 110N may be a strip extending in the first direction X, located on a side of the tenth P-type active region 110P in the second direction Y, and the tenth N-type active region 110N may serve as an active region of a tenth N-type transistor N10.

In an exemplary implementation, an eleventh P-type active region 111P may be located within the area where the N-well area 10 is located, and an orthographic projection of the eleventh P-type active region 111P on the silicon substrate is within the range of the orthographic projection of the N-well area 10 on the silicon substrate. A shape of the eleventh P-type active region 111P may be a strip extending in the first direction X, and the eleventh P-type active region 111P may serve as an active region of an eleventh P-type transistor P11.

In an exemplary implementation, an eleventh N-type active region 111N may be located outside the area where the N-well area 10 is located, and an orthographic projection of the eleventh N-type active region 111N on the silicon substrate is not overlapped with the orthographic projection of the N-well area 10 on the silicon substrate. A shape of the eleventh N-type active region 111N may be a strip extending in the first direction X, located on a side of the eleventh P-type active region 111P in the second direction Y, and the eleventh N-type active region 111N may serve as an active region of an eleventh N-type transistor N11.

In an exemplary implementation, a twelfth P-type active region 112P may be located within the area where the N-well area 10 is located, and an orthographic projection of the twelfth P-type active region 112P on the silicon substrate is within the range of the orthographic projection of the N-well area 10 on the silicon substrate. A shape of the twelfth P-type active region 112P may be a strip extending in the first direction X, and the twelfth P-type active region 112P may serve as an active region of a twelfth P-type transistor P12.

In an exemplary implementation, a twelfth N-type active region 112N may be located outside the area where the N-well area 10 is located, and an orthographic projection of the twelfth N-type active region 112N on the silicon substrate is not overlapped with the orthographic projection of the N-well area 10 on the silicon substrate. A shape of the twelfth N-type active region 112N may be a strip extending in the first direction X, located on a side of the twelfth P-type active region 112P in the second direction Y, and the twelfth N-type active region 112N may serve as an active region of a twelfth N-type transistor N12.

In an exemplary implementation, a plurality of N-type active regions may be located on a side of a plurality of P-type active regions in the second direction Y, forming a compact arrangement layout in which the plurality of N-type active regions and the plurality of P-type active regions are separated in the second direction Y (separated vertically) and sequentially disposed in the first direction X (in a long strip).

In an exemplary implementation, in the second direction Y, there may be a gap region 50 between a P-type active region and an N-type active region in one transistor group, and the gap region 50 is configured as an isolation region between the P-type transistor and the N-type transistor on the one hand, and is configured to accommodate a gate via for connecting a gate conductive layer and a first conductive layer on the other hand, so as to optimize a structural layout of the gate drive circuit.

In an exemplary implementation, widths of gap regions 50 in some transistor groups may be substantially the same, widths of gap regions 50 in some other transistor groups may be different, and the widths of the gap regions may be dimensions in the second direction Y.

In an exemplary implementation, that is, widths of gap regions 50 of a same type of devices may be substantially the same. For example, widths of gap regions 50 in the first transmission gate, the second transmission gate, and the third transmission gate may be substantially the same. As another example, widths of gap regions 50 in the first NAND gate and the second NAND gate may be substantially the same. As another example, widths of gap regions 50 in the first inverter, the second inverter, the third inverter, and the fourth inverter may be substantially the same.

In an exemplary implementation, widths of gap regions 50 of different types of devices may be different. For example, widths of gap regions 50 in the first transmission gate and the first inverter may be different. As another example, widths of gap regions 50 in the first transmission gate and the first NAND gate may be different. As another example, widths of gap regions50 in the first NAND gate and the first inverter may be different.

In an exemplary implementation, a gap region 50 in one transistor group may have a gap center line OC, and the gap center line OC may be a straight line bisecting the gap region 50 in the second direction Y and extending in the first direction X.

In an exemplary implementation, gap centerlines OC in the first transmission gate, the second transmission gate, and the third transmission gate may be substantially on a same straight line extending in the first direction X, gap centerlines OC in the first NAND gate and the second NAND gate may be substantially on a same straight line extending in the first direction X, and gap centerlines OC in the first inverter, the second inverter, the third inverter, and the fourth inverter may be substantially on a same straight line extending in the first direction X, that is the gap centerlines OC of a same type of devices may be substantially on a same straight line extending in the first direction X.

In an exemplary implementation, gap centerlines of transistor groups in the at least one transmission gate, at least one NAND gate and at least one inverter are on a same straight line extending in said first direction, that is, the gap centerlines OC of different types of devices may be substantially on a same straight line extending in the first direction X. For example, the gap centerlines OC in the first transmission gate, the first inverter, and the first NAND gate may be substantially on a same straight line extending in the first direction X. In the present disclosure, by setting positions of the transmission gates, the inverters and the NAND gates, it can be effectively ensured that connection lines between the devices are the shortest, which optimizes layout design space, ensures that the resistance capacitance loading (RC Loading) of the gate electrodes of the P-type transistors and the N-type transistors are substantially consistent, and improve uniformity.

In an exemplary implementation, a distance between a P-type active region and an N-type active region in one transistor group may be equivalent to a distance between a P-type transistor and ab N-type transistor in the transistor group.

In an exemplary implementation, the power supply active region 100P may be located within the region where the N-well area 10 is located, and an orthographic projection of the power supply active region 100P on the silicon substrate is within the range of the orthographic projection of the N-well area 10 on the silicon substrate. A shape of the power supply active region 100P may be a straight line or a polyline extending in the first direction X, the power supply active region 100P may be located on a side of the plurality of P-type active regions in a direction opposite to the second direction Y, that is, on a side of the plurality of P-type active regions away from the plurality of N-type active regions, and the power supply active region 100P is configured to be connected to a first power supply line to be formed subsequently.

In an exemplary implementation, the ground active region 100N may be located outside the region where the N-well area 10 is located, and an orthographic projection of the ground active region 100N on the silicon substrate is not overlapped with the orthographic projection of the N-well area 10 on the silicon substrate. A shape of the ground active region 100N may be a straight line or a polyline extending in the first direction X, the ground active region 100N may be located on a side of the plurality of N-type active regions in the second direction Y, that is, on a side of the plurality of N-type active regions away from the plurality of P-type active regions, and the ground active region 100N is configured to be connected to a ground line to be formed subsequently.

In an exemplary implementation, the first P-type active region 101P to the twelfth P-type active region 112P may be sequentially disposed in the first direction X (in the direction close to the display area). The second P-type active region 102P and the third P-type active region 103P in the integral structure may be located on a side of the first P-type active region 101P in the first direction X. The fourth P-type active region 104P and the fifth P-type active region 105P in the integral structure may be located on a side of the second P-type active region 102P and the third P-type active region 103P in the integral structure in the first direction X. The sixth P-type active region 106P may be located on a side of the fourth P-type active region 104P and the fifth P-type active region 105P in the integral structure in the first direction X. The seventh P-type active region 107P may be located on a side of the sixth P-type active region 106P in the first direction X. The eighth P-type active region 108P and the ninth P-type active region 109P in the integral structure may be located on a side of the seventh P-type active region 107P in the first direction X. The tenth P-type active region 110P may be located on a side of the eighth P-type active region 108P and the ninth P-type active region 109P in the integral structure in the first direction X. The eleventh P-type active region 111P may be located on a side of the tenth P-type active region 110P in the first direction X. The twelfth P-type active region 112P may be located on a side of the eleventh P-type active region 111P in the first direction X.

In an exemplary implementation, the first N-type active region 101N to the twelfth N-type active region 112N may be sequentially disposed in the first direction X (in the direction close to the display area). The second N-type active region 102N and the third N-type active region 103N in the integral structure may be located on a side of the first N-type active region 101N in the first direction X. The fourth N-type active region 104N and the fifth N-type active region 105N in the integral structure may be located on a side of the second N-type active region 102N and the third N-type active region 103N in the integral structure in the first direction X. The sixth N-type active region 106N may be located on a side of the fourth N-type active region 104N and the fifth N-type active region 105N in the integral structure in the first direction X. The seventh N-type active region 107N may be located on a side of the sixth N-type active region 106N in the first direction X. The eighth N-type active region 108N and the ninth N-type active region 109N in the integral structure may be located on a side of the seventh N-type active region 107N in the first direction X. The tenth N-type active region 110N may be located on a side of the eighth N-type active region 108N and the ninth N-type active region 109N in the integral structure in the first direction X. The eleventh N-type active region 111N may be located on a side of the tenth N-type active region 110N in the first direction X. The twelfth N-type active region 112N may be located on a side of the eleventh N-type active region 111N in the first direction X.

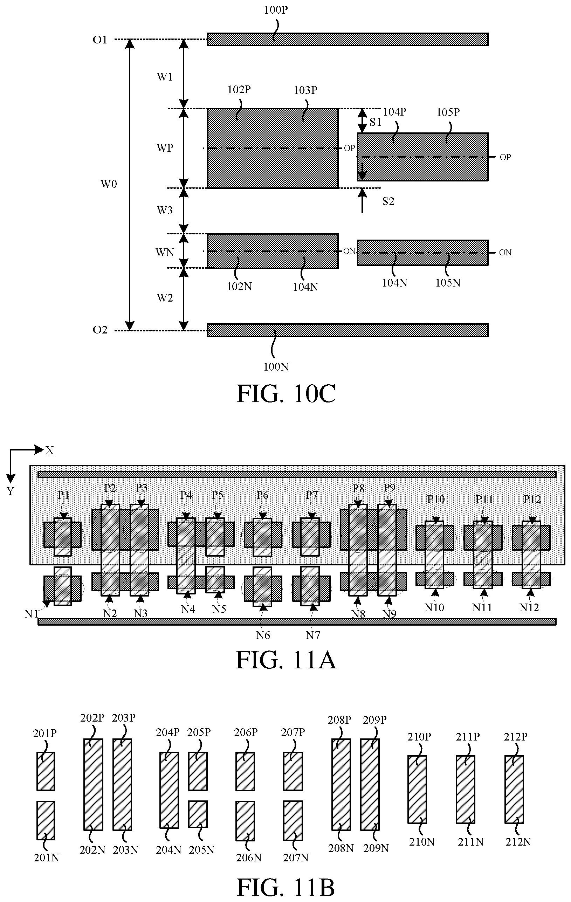

FIG. 10C is an enlarged schematic diagram of an area where the first NAND gate and the third inverter in FIG. 10A are located. As illustrated in FIG. 10C, the power supply active region 100P may have a first center line O1, and the ground active region 100N may have a second center line O2. A distance between the first center line O1 and the second center line O2 is a circuit width WO, and the circuit width WO may be a dimension in the second direction Y. The first center line O1 may be a straight line bisecting the power supply active region 100P in the second direction Y and extending in the first direction X, and the second center line O2 may be a straight line bisecting the ground active region 100N in the second direction Y and extending in the first direction X.

In an exemplary implementation, the circuit width WO may be less than or equal to a width of a pixel row in the display area.

In an exemplary implementation, the circuit width WO may be less than or equal to 6.3 µm, so that a width of a gate circuit and a width of a sub-pixel in the pixel area are substantially consistent, to meet the display requirement of the pixel density of 4000.

In an exemplary implementation, taking the second transistor group as an example, there is a first width W1 between the first center line O1 and an edge of the second P-type active region 102P close to the power supply active region 100P (the first center line O1), there is a second width W2 between the second center line O2 and an edge of the second N-type active region 102N close to the ground active region 100N (the second center line O2), there is a third width W3 between an edge of the second P-type active region 102P away from the power supply active region 100P (the first center line O1) and an edge of the second N-type active region 102N away from the ground active region 100N (the second center line O2), there is a P-type active region width WP between the edge of the second P-type active region 102P close to the power supply active region 100P (the first center line O1) and the edge of the second P-type active region 102P away from the power supply active region 100P (the first center line O1), and there is an N-type active region width WN between the edge of the second N-type active region 102N close to the ground active region 100N (the second center line O2) and the edge of the second N-type active region 102N away from the ground active region 100N (the second center line O2), then: $W 0 = W 1 + WP + W 3 + WN + W 2 .$

In an exemplary implementation, first widths W1 in the first transmission gate, the second transmission gate, and the third transmission gate may be substantially the same, first widths W1 in the first NAND gate and the second NAND gate may be substantially the same, first widths W1 in the first inverter, the second inverter, the third inverter, and the fourth inverter may be substantially the same, that is, first widths W1 in a same type of devices may be substantially the same.

In an exemplary implementation, first widths W1 in the first transmission gate and the first NAND gate may be different, first widths W1 in the first NAND gate and the first inverter may be different, first widths W1 in the first transmission gate and the first inverter may be different, that is, first widths W1 in different types of devices may be different.

In an exemplary implementation, W1+WP+W3+WN+W2 may be less than or equal to 6.3µm.

In an exemplary implementation, the first width W1 may be greater than 0.2 µm, to meet process requirement.

In an exemplary implementation, the first width W1 may be 15%*WO to 45%*WO. For example, the first width W1 may be about 34%*WO.

In an exemplary implementation, the first width W1 may be greater than 1 µm and less than 3 µm, ensuring that there is a distance between the second P-type transistor P6 and the first power supply line, to reduce mutual interference between them. For example, the first width W1 may be about 2.1µm to 2.2µm.

In an exemplary implementation, second widths W2 in the first transmission gate, the second transmission gate, and the third transmission gate may be substantially the same, second widths W2 in the first NAND gate and the second NAND gate may be substantially the same, second widths W2 in the first inverter, the second inverter, the third inverter, and the fourth inverter may be substantially the same, that is, second widths W2 in a same type of devices may be substantially the same.

In an exemplary implementation, second widths W2 in the first transmission gate and the first NAND gate may be different, second widths W2 in the first NAND gate and the first inverter may be different, second widths W2 in the first transmission gate and the first inverter may be different, that is, second widths W2 in different types of devices may be different.

In an exemplary implementation, the second width W2 may be greater than 0.2µm, to meet process requirements.

In an exemplary implementation, the second width W2 may be 15%*WO to 45%*WO. For example, the first width W1 may be about 34%*WO.

In an exemplary implementation, the second width W2 may be greater than 1 µm and less than 3 µm, ensuring that there is a distance between the second N-type transistor N6 and the ground line, to reduce mutual interference between them. The second width W2 may be about 2.1µm to 2.2µm.

In an exemplary implementation, third widths W3 in the first transmission gate, the second transmission gate, and the third transmission gate may be substantially the same, third widths W3 in the first NAND gate and the second NAND gate may be substantially the same, third widths W3 in the first inverter, the second inverter, the third inverter, and the fourth inverter may be substantially the same, that is, third widths W3 in a same type of devices may be substantially the same.

In an exemplary implementation, third widths W3 in the first transmission gate and the first NAND gate may be different, third widths W3 in the first NAND gate and the first inverter may be different, third widths W3 in the first transmission gate and the first inverter may be different, that is, third widths W3 in different types of devices may be different.

In the exemplary embodiment, the third width W3 may be greater than or equal to 1.5 µm, ensuring that there is a distance between the second P-type transistor P6 and the second N-type transistor N6 to reduce the mutual interference between them, ensuring that signal adapter lines to be formed subsequently can be accommodated, and that the signal adapter lines will have an appropriate trace width and distance to reduce mutual interference between the adapter lines.

In an exemplary implementation, P-type active region widths WP in the first transmission gate, the second transmission gate, and the third transmission gate may be substantially the same, P-type active region widths WP in the first NAND gate and the second NAND gate may be substantially the same, P-type active region widths WP in the first inverter, the second inverter, the third inverter, and the fourth inverter may be substantially the same, that is, P-type active region widths WP in a same type of devices may be substantially the same.

In an exemplary implementation, N-type active region widths WN in the first transmission gate, the second transmission gate, and the third transmission gate may be substantially the same, N-type active region widths WN in the first NAND gate and the second NAND gate may be substantially the same, N-type active region widths WN in the first inverter, the second inverter, the third inverter, and the fourth inverter may be substantially the same, that is, N-type active region widths WN in a same type of devices may be substantially the same.

In an exemplary implementation, P-type active region widths WP in the first transmission gate and the first NAND gate may be different, P-type active region widths WP in the first NAND gate and the first inverter may be different, P-type active region widths WP in the first transmission gate and the first inverter may be different, that is, P-type active region widths WP in different types of devices may be different.

In an exemplary implementation, N-type active region widths WN in the first transmission gate and the first NAND gate may be different, N-type active region widths WN in the first NAND gate and the first inverter may be different, and N-type active region widths WN in the first transmission gate and the first inverter may be different, that is, N-type active region widths WN in different types of devices may be different.

In an exemplary implementation, a P-type active region width WP in the first NAND gate may be larger than a P-type active region width WP in the first transmission gate, and the P-type active region width WP in the first NAND gate may be larger than a P-type active region width WP in the first inverter.

In an exemplary implementation, an N-type active region width WN in the first transmission gate may be larger than an N-type active region width WN in the first NAND gate, and the N-type active region width WN in the first NAND gate may be larger than an N-type active region width WN in the first inverter.

In an exemplary implementation, the P-type active region width WP may be greater than 0.556 µm, and the N-type active region width WN may be greater than 0.556 µm, to meet process requirements.

In an exemplary implementation, the P-type active region width WP may be 15%*WO to 45%*WO, and the N-type active region width WN may be 15%*WO to 45%*WO. For example, the P-type active region width WP may be about 30%*WO, and the N-type active region width WN may be about 30%*WO.

In an exemplary implementation, the P-type active region width WP may be greater than 1 µm and less than 3 µm, and the N-type active region width WN may be greater than 1 µm and less than 3 µm. For example, the P-type active region width WP may be about 2 µm, and the N-type active region width WN may be about 2 µm.

In the present disclosure, by setting a minimum width of each region, mutual influences between the P-type active regions and the N-type active regions, between the P-type active regions and the first power supply line, between the N-type active regions and the ground line, and between the first power supply line and the ground line can be effectively reduced, which improves working reliability of the shift register circuit, and ensure a signal output quality of the gate drive circuit.

In an exemplary implementation, there is a first distance S1 between an edge of the third P-type active region 103P close to the first center line O1 and an edge of the fourth P-type active region 104P close to the first center line O1, and there is a second distance S2 between an edge of the third P-type active region 103P away from the first center line O1 and an edge of the fourth P-type active region 104P away from the first center line O1, wherein the second distance S2 may be larger than the first distance S1.

In the present disclosure, by setting a positional relationship between the P-type active region of the first NAND gate and the P-type active region of the third inverter, a mutual influence between the NAND gate and the inverter can be reduced, which improves the working reliability of the shift register circuit, and ensures the signal output quality of the gate drive circuit.

In an exemplary implementation, in the second direction Y, the at least one P-type active region may have a P-type active center line OP, and the P-type active center line OP may be a straight line bisecting the P-type active region in the second direction Y and extending in the first direction X.

In an exemplary implementation, P-type active centerlines OP in the first transmission gate, the second transmission gate, and the third transmission gate may be substantially on a same straight line extending in the first direction X, P-type active centerlines OP in the first NAND gate and the second NAND gate may be substantially on a same straight line extending in the first direction X, and P-type active centerlines OP in the first inverter, the second inverter, the third inverter, and the fourth inverter may be substantially on a same straight line extending in the first direction X, that is, P-type active centerlines OP in a same type of devices may be substantially on a same straight line extending in the first direction X.

In an exemplary implementation, P-type active centerlines OP in the first transmission gate, the first inverter, and the first NAND gate may not be on a same straight line extending in the first direction X, that is, P-type active centerlines OP in different types of devices may not be on a same straight line extending in the first direction X.

In an exemplary implementation, in the second direction Y, an N-type active region in one transistor group may have an N-type active centerline ON, and the N-type active centerline ON may be a straight line bisecting the N-type active region in the second direction Y and extending in the first direction X.

In an exemplary implementation, N-type active centerlines ON in the first transmission gate, the second transmission gate, and the third transmission gate may be substantially on a same straight line extending in the first direction X, N-type active centerlines ON in the first NAND gate and the second NAND gate may be substantially on a same straight line extending in the first direction X, N-type active centerlines ON in the first inverter, the second inverter, the third inverter, and the fourth inverter may be substantially on a same straight line extending in the first direction X, that is, N-type active centerlines ON in a same type of devices may be substantially on a same straight line extending in the first direction X.

In an exemplary implementation, N-type active centerlines ON in the first transmission gate, the first inverter, and the first NAND gate may not be on a same straight line extending in the first direction X, that is, N-type active centerlines ON in different types of devices may not be on a same straight line extending in the first direction X.

(3) A pattern of a gate conductive layer is formed. In an exemplary implementation, forming the pattern of the gate conductive layer may include: depositing a first insulation thin film and a polysilicon thin film in sequence on the silicon substrate on which the aforementioned patterns are formed, first patterning the polysilicon thin film through a patterning process to form a first insulation layer overlaying the silicon substrate and a polysilicon layer disposed on the first insulation layer, and then performing doping on the polysilicon layer to form the pattern of the gate conductive layer, as shown in FIGS. 11A and 11B, and FIG. 11B is a schematic diagram of the gate conductive layer in FIG. 11A.

In an exemplary implementation, the pattern of the gate conductive layer may include at least a first P-type gate electrode 201P to a twelfth P-type gate electrode 212P, and a first N-type gate electrode 201N to a twelfth N-type gate electrode 212N.

In an exemplary implementation, the first P-type gate electrode 201P may be in a shape of a strip extending in the second direction Y. An orthographic projection of the first P-type gate electrode 201P on the silicon substrate is at least partially overlapped with the orthographic projection of the first P-type active region 101P on the silicon substrate. The first P-type gate electrode 201P may serve as the gate electrode of the first P-type transistor P1.

In an exemplary implementation, the first N-type gate electrode 201N may be in a shape of a strip extending in the second direction Y. An orthographic projection of the first N-type gate electrode 201N on the silicon substrate is at least partially overlapped with the orthographic projection of the first N-type active region 101N on the silicon substrate. The first N-type gate electrode 201N may serve as the gate electrode of the first N-type transistor N1.

In an exemplary implementation, the second P-type gate electrode 202P may be in a shape of a strip extending in the second direction Y. An orthographic projection of the second P-type gate electrode 202P on the silicon substrate is at least partially overlapped with the orthographic projection of the second P-type active region 102P on the silicon substrate. The second P-type gate electrode 202P may serve as the gate electrode of the second P-type transistor P2.

In an exemplary implementation, the second N-type gate electrode 202N may be in a shape of a strip extending in the second direction Y. An orthographic projection of the second N-type gate electrode 202N on the silicon substrate is at least partially overlapped with the orthographic projection of the second N-type active region 102N on the silicon substrate. The second N-type gate electrode 202N may serve as the gate electrode of the second N-type transistor N2.

In an exemplary implementation, the second P-type gate electrode 202P and the second N-type gate electrode 202N may be interconnected into an integral structure.

In an exemplary implementation, the third P-type gate electrode 203P may be in a shape of a strip extending in the second direction Y. An orthographic projection of the third P-type gate electrode 203P on the silicon substrate is at least partially overlapped with the orthographic projection of the third P-type active region 103P on the silicon substrate. The third P-type gate electrode 203P may serve as the gate electrode of the third P-type transistor P3.

In an exemplary implementation, the third N-type gate electrode 203N may be in a shape of a strip extending in the second direction Y. An orthographic projection of the third N-type gate electrode 203N on the silicon substrate is at least partially overlapped with the orthographic projection of the third N-type active region 103N on the silicon substrate. The third N-type gate electrode 203N may serve as the gate electrode of the third N-type transistor N3.

In an exemplary implementation, the third P-type gate electrode 203P and the third N-type gate electrode 203N may be interconnected into an integral structure.

In an exemplary implementation, the fourth P-type gate electrode 204P may be in a shape of a strip extending in the second direction Y. An orthographic projection of the fourth P-type gate electrode 204P on the silicon substrate is at least partially overlapped with the orthographic projection of the fourth P-type active region 104P on the silicon substrate. The fourth P-type gate electrode 204P may serve as the gate electrode of the fourth P-type transistor P4.

In an exemplary implementation, the fourth N-type gate electrode 204N may be in a shape of a strip extending in the second direction Y. An orthographic projection of the fourth N-type gate electrode 204N on the silicon substrate is at least partially overlapped with the orthographic projection of the fourth N-type active region 104N on the silicon substrate. The fourth N-type gate electrode 204N may serve as the gate electrode of the fourth N-type transistor N4.

In an exemplary implementation, the fourth P-type gate electrode 204P and the fourth N-type gate electrode 204N may be interconnected into an integral structure.

In an exemplary implementation, the fifth P-type gate electrode 205P may be in a shape of a strip extending in the second direction Y. An orthographic projection of the fifth P-type gate electrode 205P on the silicon substrate is at least partially overlapped with the orthographic projection of the fifth P-type active region 105P on the silicon substrate. The fifth P-type gate electrode 205P may serve as the gate electrode of the fifth P-type transistor P5.

In an exemplary implementation, the fifth N-type gate electrode 205N may be in a shape of a strip extending in the second direction Y. An orthographic projection of the fifth N-type gate electrode 205N on the silicon substrate is at least partially overlapped with the orthographic projection of the fifth N-type active region 105N on the silicon substrate. The fifth N-type gate electrode 205N may serve as the gate electrode of the fifth N-type transistor N5.

In an exemplary implementation, the sixth P-type gate electrode 206P may be in a shape of a strip extending in the second direction Y. An orthographic projection of the sixth P-type gate electrode 206P on the silicon substrate is at least partially overlapped with the orthographic projection of the sixth P-type active region 106P on the silicon substrate. The sixth P-type gate electrode 206P may serve as the gate electrode of the sixth P-type transistor P6.

In an exemplary implementation, the sixth N-type gate electrode 206N may be in a shape of a strip extending in the second direction Y. An orthographic projection of the sixth N-type gate electrode 206N on the silicon substrate is at least partially overlapped with the orthographic projection of the sixth N-type active region 106N on the silicon substrate. The sixth N-type gate electrode 206N may serve as the gate electrode of the sixth N-type transistor N6.

In an exemplary implementation, the seventh P-type gate electrode 207P may be in a shape of a strip extending in the second direction Y. An orthographic projection of the seventh P-type gate electrode 207P on the silicon substrate is at least partially overlapped with the orthographic projection of the seventh P-type active region 107P on the silicon substrate. The seventh P-type gate electrode 207P may serve as the gate electrode of the seventh P-type transistor P7.

In an exemplary implementation, the seventh N-type gate electrode 207N may be in a shape of a strip extending in the second direction Y. An orthographic projection of the seventh N-type gate electrode 207N on the silicon substrate is at least partially overlapped with the orthographic projection of the seventh N-type active region 107N on the silicon substrate. The seventh N-type gate electrode 207N may serve as the gate electrode of the seventh N-type transistor N7.

In an exemplary implementation, the eighth P-type gate electrode 208P may be in a shape of a strip extending in the second direction Y. An orthographic projection of the eighth P-type gate electrode 208P on the silicon substrate is at least partially overlapped with the orthographic projection of the eighth P-type active region 108P on the silicon substrate. The eighth P-type gate electrode 208P may serve as the gate electrode of the eighth P-type transistor P8.

In an exemplary implementation, the eighth N-type gate electrode 208N may be in a shape of a strip extending in the second direction Y. An orthographic projection of the eighth N-type gate electrode 208N on the silicon substrate is at least partially overlapped with the orthographic projection of the eighth N-type active region 108N on the silicon substrate. The eighth N-type gate electrode 208N may serve as the gate electrode of the eighth N-type transistor N8.

In an exemplary implementation, the eighth P-type gate electrode 208P and the eighth N-type gate electrode 208N may be interconnected into an integral structure.

In an exemplary implementation, the ninth P-type gate electrode 209P may be in a shape of a strip extending in the second direction Y. An orthographic projection of the ninth P-type gate electrode 209P on the silicon substrate is at least partially overlapped with the orthographic projection of the ninth P-type active region 109P on the silicon substrate. The ninth P-type gate electrode 209P may serve as the gate electrode of the ninth P-type transistor P9.

In an exemplary implementation, the ninth N-type gate electrode 209N may be in a shape of a strip extending in the second direction Y. An orthographic projection of the ninth N-type gate electrode 209N on the silicon substrate is at least partially overlapped with the orthographic projection of the ninth N-type active region 109N on the silicon substrate. The ninth N-type gate electrode 209N may serve as the gate electrode of the ninth N-type transistor N9.

In an exemplary implementation, the ninth P-type gate electrode 209P and the ninth N-type gate electrode 209N may be interconnected into an integral structure.

In an exemplary implementation, the tenth P-type gate electrode 210P may be in a shape of a strip extending in the second direction Y. An orthographic projection of the tenth P-type gate electrode 210P on the silicon substrate is at least partially overlapped with the orthographic projection of the tenth P-type active region 110P on the silicon substrate. The tenth P-type gate electrode 210P may serve as the gate electrode of the tenth P-type transistor P10.

In an exemplary implementation, the tenth N-type gate electrode 210N may be in a shape of a strip extending in the second direction Y. An orthographic projection of the tenth N-type gate electrode 210N on the silicon substrate is at least partially overlapped with the orthographic projection of the tenth N-type active region 110N on the silicon substrate. The tenth N-type gate electrode 210N may serve as the gate electrode of the tenth N-type transistor N10.

In an exemplary implementation, the tenth P-type gate electrode 210P and the tenth N-type gate electrode 210N may be interconnected into an integral structure.

In an exemplary implementation, the eleventh P-type gate electrode 211P may be in a shape of a strip extending in the second direction Y. An orthographic projection of the eleventh P-type gate electrode 211P on the silicon substrate is at least partially overlapped with the orthographic projection of the eleventh P-type active region 111P on the silicon substrate. The eleventh P-type gate electrode 211P may serve as the gate electrode of the eleventh P-type transistor P11.

In an exemplary implementation, the eleventh N-type gate electrode 211N may be in a shape of a strip extending in the second direction Y. An orthographic projection of the eleventh N-type gate electrode 211N on the silicon substrate is at least partially overlapped with the orthographic projection of the eleventh N-type active region 111N on the silicon substrate. The eleventh N-type gate electrode 211N may serve as the gate electrode of the eleventh N-type transistor N11.

In an exemplary implementation, the eleventh P-type gate electrode 211P and the eleventh N-type gate electrode 211N may be interconnected into an integral structure.

In an exemplary implementation, the twelfth P-type gate electrode 212P may be in a shape of a strip extending in the second direction Y. An orthographic projection of the twelfth P-type gate electrode 212P on the silicon substrate is at least partially overlapped with the orthographic projection of the twelfth P-type active region 112P on the silicon substrate. The twelfth P-type gate electrode 212P may serve as the gate electrode of the twelfth P-type transistor P12.

In an exemplary implementation, the twelfth N-type gate electrode 212N may be in a shape of a strip extending in the second direction Y. An orthographic projection of the twelfth N-type gate electrode 212N on the silicon substrate is at least partially overlapped with the orthographic projection of the twelfth N-type active region 112N on the silicon substrate. The twelfth N-type gate electrode 212N may serve as the gate electrode of the twelfth N-type transistor N12.

In an exemplary implementation, the twelfth P-type gate electrode 212P and the twelfth N-type gate electrode 212N may be interconnected into an integral structure.

In an exemplary implementation, the first P-type gate electrode 201P to the twelfth P-type gate electrode 212P may be sequentially disposed in the first direction X, and the first N-type gate electrode 201N to the twelfth N-type gate electrode 212N may be sequentially disposed in the first direction X.

In an exemplary implementation, widths of the first P-type gate electrode 201P to the twelfth P-type gate electrode 212P may be substantially equal, and widths of the first N-type gate electrode 201N to the twelfth N-type gate electrode 212N may be substantially equal.

In an exemplary implementation, width-to-length ratios of P-type transistors in the first transmission gate, the second transmission gate, and the third transmission gate may be substantially the same, width-to-length ratios of P-type transistors in the first NAND gate and the second NAND gate may be substantially the same, and width-to-length ratios of P-type transistors in the first inverter, the second inverter, the third inverter, and the fourth inverter may be substantially the same, that is, width-to-length ratios of P-type transistors in a same type of devices may be substantially the same.

In an exemplary implementation, width-to-length ratios of N-type transistors in the first transmission gate, the second transmission gate, and the third transmission gate may be substantially the same, width-to-length ratios of N-type transistors in the first NAND gate and the second NAND gate may be substantially the same, width-to-length ratios of N-type transistors in the first inverter, the second inverter, the third inverter, and the fourth inverter may be substantially the same, that is, width-to-length ratios of N-type transistors in a same type of devices may be substantially the same.

In an exemplary implementation, width-length ratios of P-type transistors in the first transmission gate and the first NAND gate may be different, width-length ratios of P-type transistors in the first NAND gate and the first inverter may be different, width-length ratios of P-type transistors in the first transmission gate and the first inverter may be different, that is, width-length ratios of P-type transistors in different types of devices may be different.

In an exemplary implementation, width-length ratios of N-type transistors in the first transmission gate and the first NAND gate may be different, width-length ratios of N-type transistors in the first NAND gate and the first inverter may be different, width-length ratios of N-type transistors in the first transmission gate and the first inverter may be different, that is, width-length ratios of N-type transistors in different types of devices may be different.

In an exemplary implementation, in at least one transistor group, a width-to-length ratio of P-type transistors is larger than a width-to-length ratio of N-type transistors.

In an exemplary implementation, in at least one transistor group, a ratio of the width-length ratio of the P-type transistors to the width-length ratio of the N-type transistors may be greater than 1 and less than 3.

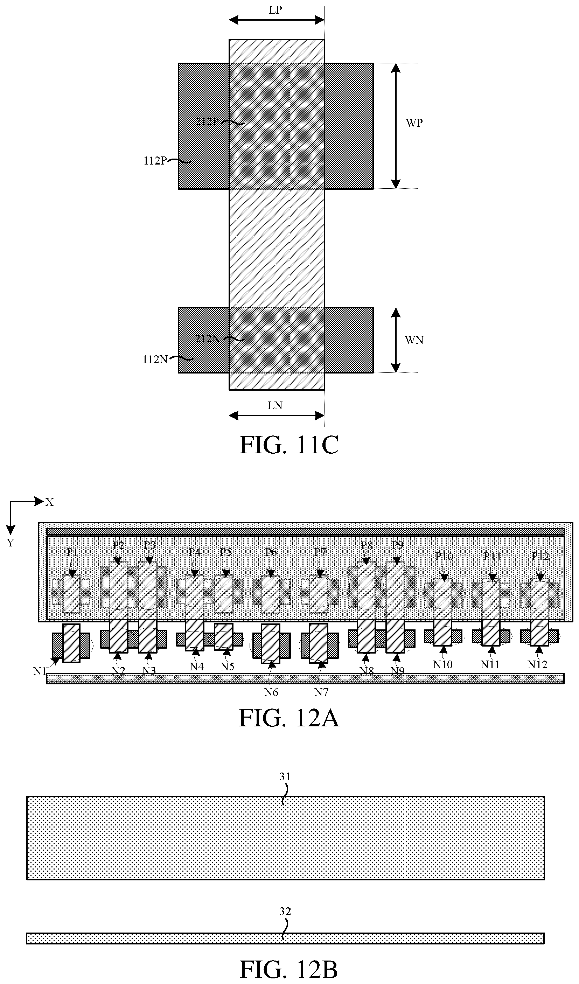

FIG. 11C is an enlarged schematic diagram of the twelfth P-type gate electrode and the twelfth N-type gate electrode in FIG. 11A. As shown in FIG. 11C, the first inverter may include a twelfth P-type transistor P12 and a twelfth N-type transistor N12. The twelfth P-type active region 112P may serve as a P-type active region of the twelfth P-type transistor P12. The twelfth P-type active region 112P has a P-type active region width WP. The twelfth P-type gate electrode 212P may serve as a P-type gate electrode of the twelfth P-type transistor P12. The twelfth P-type gate electrode 212P has a P-type gate electrode width LP. A width-to-length ratio of the twelfth P-type transistor P12 is WP/LP. The twelfth N-type active region 112N may serve as an N-type active region of the twelfth N-type transistor N12. The twelfth N-type active region 112N has an N-type active region width WN. The twelfth N-type gate electrode 212N may serve as an N-type gate electrode of the twelfth N-type transistor N12. The twelfth N-type gate electrode 212N has an N-type gate electrode width LN. A width-to-length ratio of the twelfth N-type transistor N12 is WN/LN.

In an exemplary implementation, a ratio of the width-to-length ratio (WP/LP) of the twelfth P-type transistor P12 to the width-to-length ratio (WN/LN) of the twelfth N-type transistor N12 is K, and 1 < K < 3.

In an exemplary implementation, the P-type gate electrode width LP and the N-type gate electrode width LN may be substantially equal, and thus K = WP/WN, that is, the ratio of the P-type active region width WP to the twelfth N-type active region 112N may be greater than 1 and less than 3.

In an exemplary implementation, K may be substantially equal to about 2.

In an exemplary implementation, K in the first inverter, the second inverter, the third inverter, and the fourth inverter may be substantially the same.

In the present disclosure, by disposing the ratio of the width-to-length ratio of the P-type transistor to the width-to-length ratio of the N-type transistor in the inverter, the propagation delay can be symmetrical, so that the rising and falling times of the P-type transistor and the N-type transistor are substantially equal, the noise margins of the high and low levels are substantially the same, and the charging and discharging times are substantially the same, thereby improving the electrical performance of the inverter.

In an exemplary implementation, ratios of the width-to-length ratios of the P-type transistors to the width-to-length ratios of the N-type transistors in the first transmission gate, the second transmission gate, and the third transmission gate may be substantially the same, and the ratio K of the width-to-length ratio of the P-type transistors to the width-to-length ratio of the N-type transistors may be greater than 0.9 and less than 1.1. For example, K can be about 1.0.

In an exemplary implementation, ratios of the width-to-length ratios of the P-type transistors to the width-to-length ratios of the N-type transistors in the first NAND gate and the second NAND gate may be substantially the same, and the ratio K of the width-to-length ratio of the P-type transistors to the width-to-length ratio of the N-type transistors may be greater than 1.3 and less than 3.3. For example, K can be about 2.3.

In an exemplary implementation, a ratio of the width-to-length ratio of the P-type transistors to the width-to-length ratio of the N-type transistor in the first NAND gate may be greater than a ratio of the width-to-length ratio of the P-type transistors to the width-to-length ratio of the N-type transistors in the first inverter, and a ratio of the width-to-length ratio of the P-type transistors to the width-to-length ratio of the N-type transistors in the first inverter may be greater than a ratio of the width-to-length ratio of the P-type transistors to the width-to-length ratio of the N-type transistor in the first transmission gate.

By disposing ratios of the width-to-length ratios of the P-type transistors and the width-to-length ratios of the N-type transistors in different devices, the present disclosure can ensure that the loading is substantially consistent, and the electrical performance of the shift register circuit can be improved.

(4) A pattern of P-type doped (SP) regions is formed. In an exemplary implementation, forming a pattern of P-type doped regions may include: coating a photoresist on a silicon substrate on which the aforementioned patterns are formed, forming a plurality of opening regions by exposure and development, removing the photoresist in the plurality of opening regions, and forming a plurality of P-type doped regions in the opening regions by a doping process, as shown in FIGS. 12A and 12B, and FIG. 12B is a schematic diagram of the P-type doped regions in FIG. 12A.

In an exemplary implementation, the plurality of P-type doped regions may include at least a first P-type doped region 31 and a second P-type doped region 32.

In an exemplary implementation, the first P-type doped region 31 may be located within the area where the N-well area 10 is located, and an orthographic projection of the first P-type doped region 31 on the silicon substrate contains the orthographic projections of the first P-type active region 101P to the twelfth P-type active region 112P on the silicon substrate, so that a P-type source region and a P-type drain region are respectively formed on two sides of the P-type gate electrodes in the first direction X .

In an exemplary implementation, some active regions between adjacent P-type gate electrodes may simultaneously serve as a P-type source region of one P-type transistor and a P-type source region of another P-type transistor, or may simultaneously serve as a P-type drain region of one P-type transistor and a P-type drain region of another P-type transistor, or may simultaneously serve as a P-type source region of one P-type transistor and a P-type drain region of another P-type transistor.

In an exemplary implementation, both a P-type source region and a P-type drain region of each P-type transistor are P-type heavily doped regions P +.

In an exemplary implementation, the second P-type doped region 32 may be located outside the area where the N-well area 10 is located, and an orthographic projection of the second P-type doped region 32 on the silicon substrate contains the orthographic projection of the ground active region 100N on the silicon substrate.

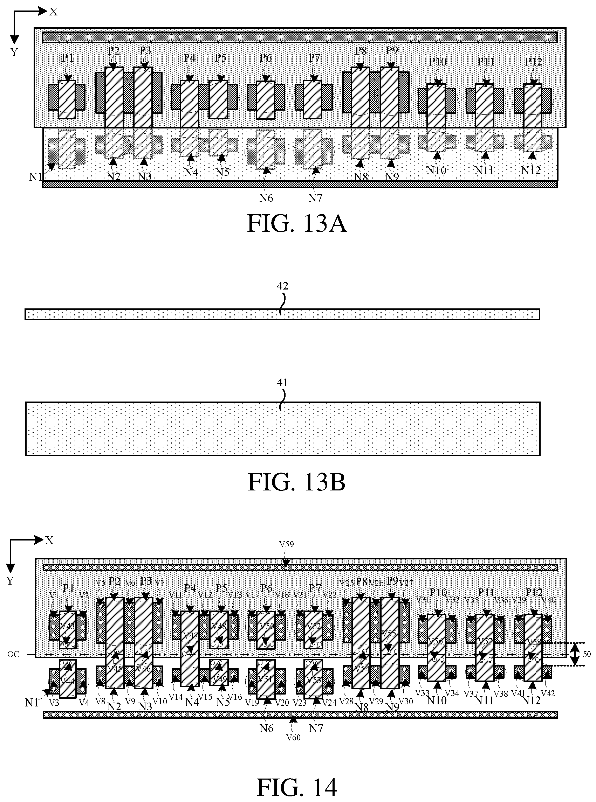

(5) A pattern of N-type doped (SN) regions is formed. In an exemplary implementation, forming a pattern of N-type doped regions may include: coating a photoresist on the silicon substrate on which the aforementioned patterns are formed, forming a plurality of opening regions by exposure and development, removing the photoresist in the plurality of opening regions, and forming a plurality of N-type doped regions in the opening regions by a doping process, as shown in FIGS. 13A and 13B, and FIG. 13B is a schematic diagram of the N-type doped regions in FIG. 13A.

In an exemplary implementation, the plurality of N-type doped regions may include at least a first N-type doped region 41 and a second N-type doped region 42.

In an exemplary implementation, the first N-type doped region 41 may be located outside the area where the N-well area 10 is located, and an orthographic projection of the first N-type doped region 41 on the silicon substrate contains the orthographic projections of the first N-type active region 101N to the ninth N-type active region 109N on the silicon substrate, so that an N-type source region and an N-type drain region are respectively formed on two sides of the N-type gate electrodes in the first direction X.

In an exemplary implementation, some active regions between adjacent N-type gate electrodes may simultaneously serve as an N-type source region of one N-type transistor and an N-type source region of another N-type transistor, or may simultaneously serve as an N-type drain region of one N-type transistor and an N-type drain region of another N-type transistor, or may simultaneously serve as an N-type source region of one N-type transistor and an N-type drain region of another N-type transistor.

In an exemplary implementation, the N-type source region and the N-type drain region of each N-type transistor are N-type heavily doped regions N +.

In an exemplary implementation, the second N-type doped region 42 may be located within the area where the N-well area 10 is located, and an orthographic projection of the second N-type doped region 42 on the silicon substrate contains the orthographic projection of the power supply active region 100P on the silicon substrate.

(6) A pattern of a second insulation layer is formed. In an exemplary implementation, forming a pattern of a second insulation layer may include: depositing a second insulation thin film on the silicon substrate on which the aforementioned patterns are formed, and patterning the second insulation thin film by a patterning process, to form the second insulation layer overlaying the pattern of the gate conductive layer, and a plurality of vias are disposed on the second insulation layer, as shown in FIG. 14.

In an exemplary implementation, the plurality of vias at least include first vias V1 to sixtieth vias V60.

In an exemplary implementation, orthographic projections of the first vias V1 on the silicon substrate may be within a range of an orthographic projection of a first P-type active region of the first P-type transistor P1 on the silicon substrate. The first insulation layer and the second insulation layer within the first vias V1 are etched away to expose a surface of the first P-type active region. The first vias V1 are configured such that a seventeenth connection electrode to be formed subsequently is connected to the first P-type active region through these vias.

In an exemplary implementation, orthographic projections of second vias V2 on the silicon substrate may be within a range of an orthographic projection of a first P-type drain region of the first P-type transistor P1on the silicon substrate. The first insulation layer and the second insulation layer within the second vias V2 are etched away to expose a surface of the first P-type drain region. The second vias V2 are configured such that an eighteenth connection electrode to be formed subsequently is connected to the first P-type drain region through these vias.

In an exemplary implementation, orthographic projections of third vias V3 on the silicon substrate may be within a range of an orthographic projection of a first N-type active region of the first N-type transistor N1 on the silicon substrate. The first insulation layer and the second insulation layer within the third vias V3 are etched away to expose a surface of the first N-type active region. The third vias V3 are configured such that the seventeenth connection electrode to be formed subsequently is connected to the first N-type active region through these vias.

In an exemplary implementation, orthographic projections of fourth vias V4 on the silicon substrate may be within a range of an orthographic projection of a first N-type drain region of the first N-type transistor N1 on the silicon substrate. The first insulation layer and the second insulation layer within the fourth vias V4 are etched away to expose a surface of the first N-type drain region. The fourth vias V4 are configured such that an eighteenth connection electrode to be formed subsequently is connected to the first N-type drain region through these vias.

In an exemplary implementation, orthographic projections of fifth vias V5 on the silicon substrate may be within a range of an orthographic projection of a second P-type source region of the second P-type transistor P2 on the silicon substrate. The second insulation layer and the second insulation layer within the fifth vias V5 are etched away to expose a surface of the second P-type source region. The fifth vias V5 are configured such that a nineteenth connection electrode to be formed subsequently is connected to the second P-type source region through these vias.

In an exemplary implementation, orthographic projections of sixth vias V6 on the silicon substrate may be within a range of an orthographic projection of a second P-type drain region of the second P-type transistor P2 (also a third P-type drain region of the third P-type transistor P3) on the silicon substrate. The first insulation layer and the second insulation layer within the sixth vias V6 are etched away to expose a surface of the second P-type drain region (also the third P-type drain region). The sixth vias V6 are configured such that a twentieth connection electrode to be formed subsequently is connected to the second P-type drain region (also the third P-type drain region) through these vias.

In an exemplary implementation, orthographic projections of seventh vias V7 on the silicon substrate may be within a range of an orthographic projection of a third P-type source region of the third P-type transistor P3 on the silicon substrate. The first insulation layer and the second insulation layer within the seventh vias V7 are etched away to expose a surface of the third P-type source region. The seventh vias V7 are configured such that a twenty-first connection electrode to be formed subsequently is connected to the third P-type source region through these via.

In an exemplary implementation, orthographic projections of eighth vias V8 on the silicon substrate may be within a range of an orthographic projection of a second N-type drain region of the second N-type transistor N2 on the silicon substrate. The first insulation layer and the second insulation layer within the eighth vias V8 are etched away to expose a surface of the second N-type drain region. The eighth vias V8 are configured such that a twenty-second connection electrode to be formed subsequently is connected to the second N-type drain region through these vias.

In an exemplary implementation, orthographic projections of ninth vias V9 on the silicon substrate may be within a range of an orthographic projection of a second N-type source region of the second N-type transistor N2 (also a third N-type drain region of the third N-type transistor N3) on the silicon substrate. The first insulation layer and the second insulation layer within the ninth vias V9 are etched away to expose a surface of the second N-type source region (also the third N-type drain region). The ninth vias V9 are configured such that a twenty-third connection electrode to be formed subsequently is connected to the second N-type source region (also the third N-type drain region) through these vias.

In an exemplary implementation, orthographic projections of tenth vias V10 on the silicon substrate may be within a range of an orthographic projection of a third N-type source region of the third N-type transistor N3 on the silicon substrate. The first insulation layer and the second insulation layer within the tenth vias V10 are etched away to expose a surface of the third N-type source region. The tenth vias V10 are configured such that a twenty-fourth connection electrode to be formed subsequently is connected to the third N-type source region through these vias.

In an exemplary implementation, orthographic projections of eleventh vias V11 on the silicon substrate may be within a range of an orthographic projection of a fourth P-type source region of the fourth P-type transistor P4 on the silicon substrate. The first insulation layer and the second insulation layer within the eleventh vias V11 are etched away to expose a surface of the fourth P-type source region. The eleventh vias V11 are configured such that a twenty-fifth connection electrode to be formed subsequently is connected to the fourth P-type source region through these vias.

In an exemplary implementation, orthographic projections of twelfth vias V12 on the silicon substrate may be within a range of an orthographic projection of a fourth P-type drain region of the fourth P-type transistor P4 (also a fifth P-type source region of the fifth P-type transistor P5) on the silicon substrate. The first insulation layer and the second insulation layer within the twelfth vias V12 are etched away to expose a surface of the fourth P-type drain region (also the fifth P-type source region). The twelfth vias V12 are configured such that a twenty-sixth connection electrode to be formed subsequently is connected to the fourth P-type drain region (also the fifth P-type source region) through these vias.

In an exemplary implementation, orthographic projections of thirteenth vias V13 on the silicon substrate may be within a range of an orthographic projection of a fifth P-type drain region of the fifth P-type transistor P5 on the silicon substrate. The first insulation layer and the second insulation layer within the thirteenth vias V13 are etched away to expose a surface of the fifth P-type drain region. The thirteenth vias V13 are configured such that a twenty-seventh connection electrode to be formed subsequently is connected to the fifth P-type drain region through these vias.

In an exemplary implementation, an orthographic projection of a fourteenth via V14 on the silicon substrate may be within a range of an orthographic projection of a fourth N-type source region of the fourth N-type transistor N4 on the silicon substrate. The first insulation layer and the second insulation layer within the fourteenth via V14 are etched away to expose a surface of the fourth N-type source region. The fourteenth via V14 is configured such that a twenty-eighth connection electrode to be formed subsequently is connected to the fourth N-type source region through this via.

In an exemplary implementation, an orthographic projection of a fifteenth via V15 on the silicon substrate may be within a range of an orthographic projection of the fourth N-type drain region of the fourth N-type transistor N4 (also a fifth N-type source region of the fifth N-type transistor N5) on the silicon substrate. The first insulation layer and the second insulation layer within the fifteenth via V15 are etched away to expose a surface of the fourth N-type drain region (also the fifth N-type source region). The fifteenth via V15 is configured such that a twenty-ninth connection electrode to be formed subsequently is connected to the fourth N-type drain region (also the fifth N-type source region) through the via.

In an exemplary implementation, an orthographic projection of a sixteenth via V16 on the silicon substrate may be within a range of an orthographic projection of a fifth N-type drain region of the fifth N-type transistor N5 on the silicon substrate. The first insulation layer and the second insulation layer within the sixteenth via V16 are etched away to expose a surface of the fifth N-type drain region. The sixteenth via V16 is configured such that a thirtieth connection electrode to be formed subsequently is connected to the fifth N-type drain region through this via.

In an exemplary implementation, orthographic projections of seventeenth vias V17 on the silicon substrate may be within a range of an orthographic projection of a sixth P-type source region of the sixth P-type transistor P6 on the silicon substrate. The first insulation layer and the second insulation layer within the seventeenth vias V17 are etched away to expose a surface of the sixth P-type source region. The seventeenth vias V17 are configured such that a thirty-first connection electrode to be formed subsequently is connected to the sixth P-type source region through these vias.

In an exemplary implementation, orthographic projections of eighteenth vias V18 on the silicon substrate may be within a range of an orthographic projection of a sixth P-type drain region of the sixth P-type transistor P6 on the silicon substrate. The first insulation layer and the second insulation layer within the eighteenth vias V18 are etched away to expose a surface of the sixth P-type drain region. The eighteenth vias V18 are configured such that a thirty-second connection electrode to be formed subsequently is connected to the sixth P-type drain region through these vias.

In an exemplary implementation, orthographic projections of nineteenth vias V19 on the silicon substrate may be within a range of an orthographic projection of a sixth N-type source region of the sixth N-type transistor N6 on the silicon substrate. The first insulation layer and the second insulation layer within the nineteenth via V19 are etched away to expose a surface of the sixth N-type source region. The nineteenth vias V19 are configured such that a thirty-third connection electrode to be formed subsequently is connected to the sixth N-type source region through these vias.

In an exemplary implementation, orthographic projections of twentieth vias V20 on the silicon substrate may be within a range of an orthographic projection of a sixth N-type drain region of the sixth N-type transistor N6 on the silicon substrate. The first insulation layer and the second insulation layer within the twentieth vias V20 are etched away to expose a surface of the sixth N-type drain region. The twentieth vias V20 are configured such that a thirty-fourth connection electrode to be formed subsequently is connected to the sixth N-type drain region through these vias.

In an exemplary implementation, orthographic s of twenty-first vias V21 on the silicon substrate may be within a range of an orthographic projection of a seventh P-type source region of the seventh P-type transistor P7 on the silicon substrate. The first insulation layer and the second insulation layer within the twenty-first vias V21 are etched away to expose a surface of the seventh P-type source region. The twenty-first vias V21 are configured such that a thirty-fifth connection electrode to be formed subsequently is connected to the seventh P-type source region through these vias.

In an exemplary implementation, orthographic projections of twenty-second vias V22 on the silicon substrate may be within a range of an orthographic projection of a seventh P-type drain region of the seventh P-type transistor P7 on the silicon substrate. The first insulation layer and the second insulation layer within the twenty-second vias V22 are etched away to expose a surface of the seventh P-type drain region. The twenty-second vias V22 are configured such that a thirty-sixth connection electrode to be formed subsequently is connected to the seventh P-type drain region through these vias.

In an exemplary implementation, orthographic projections of twenty-third vias V23 on the silicon substrate may be within a range of an orthographic projection of a seventh N-type source region of the seventh N-type transistor N7 on the silicon substrate. The first insulation layer and the second insulation layer within the twenty-third vias V23 are etched away to expose a surface of the seventh N-type source region. The twenty-third vias V23 are configured such that a thirty-seventh connection electrode to be formed subsequently is connected to the seventh N-type source region through these vias.

In an exemplary implementation, orthographic projections of twenty-fourth vias V24 on the silicon substrate may be within a range of an orthographic projection of a seventh N-type drain region of the seventh N-type transistor N7 on the silicon substrate. The first insulation layer and the second insulation layer within the twenty-fourth vias V24 are etched away to expose a surface of the seventh N-type drain region. The twenty-fourth vias V24 are configured such that the thirty-eighth connection electrode to be formed subsequently is connected to the seventh N-type drain region through these vias.

In an exemplary implementation, orthographic projections of twenty-fifth vias V25 on the silicon substrate may be within a range of an orthographic projection of an eighth P-type source region of the eighth P-type transistor P8 on the silicon substrate. The first insulation layer and the second insulation layer within the twenty-fifth vias V25 are etched away to expose a surface of the eighth P-type source region. The twenty-fifth vias V25 are configured such that a thirty-ninth connection electrode to be formed subsequently is connected to the eighth P-type source region through these vias.

In an exemplary implementation, orthographic projections of twenty-sixth vias V26 on the silicon substrate may be within a range of an orthographic projection of an eighth P-type drain region of the eighth P-type transistor P8 (also a ninth P-type drain region of the ninth P-type transistor P9) on the silicon substrate. The first insulation layer and the second insulation layer within the twenty-sixth vias V26 are etched away to expose a surface of the eighth P-type drain region (also the ninth P-type drain region). The twenty-sixth vias V26 are configured such that a fortieth connection electrode to be formed subsequently is connected to the eighth P-type drain region (also the ninth P-type drain region) through these vias.

In an exemplary implementation, orthographic projections of twenty-seventh vias V27 on the silicon substrate may be within a range of an orthographic projection of a ninth P-type source region of the ninth P-type transistor P9 on the silicon substrate. The first insulation layer and the second insulation layer within the twenty-seventh vias V27 are etched away to expose a surface of the ninth P-type source region. The twenty-seventh vias V27 are configured such that a forty-first connection electrode to be formed subsequently is connected to the ninth P-type source region through these vias.

In an exemplary implementation, orthographic projections of twenty-eighth vias V28 on the silicon substrate may be within a range of an orthographic projection of an eighth N-type source region of the eighth N-type transistor N8 on the silicon substrate. The first insulation layer and the second insulation layer within the twenty-eighth vias V28 are etched away to expose a surface of the eighth N-type source region. The twenty-eighth vias V28 are configured such that a ground line to be formed subsequently is connected to the eighth N-type source region through these vias.

In an exemplary implementation, orthographic projections of twenty-ninth vias V29 on the silicon substrate may be within a range of an orthographic projection of an eighth N-type drain region of the eighth N-type transistor N8 (also a ninth N-type source region of the ninth N-type transistor N9) on the silicon substrate. The first insulation layer and the second insulation layer in the twenty-ninth vias V29 are etched away to expose a surface of the eighth N-type drain region (also the ninth N-type source region). The twenty-ninth vias V29 are configured such that a forty-third connection electrode to be formed subsequently is connected to the eighth N-type drain region (also the ninth N-type source region) through these vias.

In an exemplary implementation, orthographic projections of thirtieth vias V30 on the silicon substrate may be within a range of an orthographic projection of a ninth N-type drain region of the ninth N-type transistor N9 on the silicon substrate. The first insulation layer and the second insulation layer within the thirtieth vias V30 are etched away to expose a surface of the ninth N-type drain region. The thirtieth vias V30 are configured such that the forth-fourth connection electrode to be formed subsequently is connected to the ninth N-type drain region through these vias.

In an exemplary implementation, orthographic projections of thirty-first vias V31 on the silicon substrate may be within a range of an orthographic projection of a tenth P-type drain region of the tenth P-type transistor P10 on the silicon substrate. The first insulation layer and the second insulation layer in the thirty-first vias V31 are etched away to expose a surface of the tenth P-type drain region. The thirty-first vias V31 are configured such that a forty-fifth connection electrode to be formed subsequently is connected to the tenth P-type drain region through these vias.

In an exemplary implementation, orthographic projections of thirty-second vias V32 on the silicon substrate may be within a range of an orthographic projection of a tenth P-type source region of the tenth P-type transistor P10 on the silicon substrate. The first insulation layer and the second insulation layer within the thirty-second vias V32 are etched away to expose a surface of the tenth P-type source region. The thirty-second vias V32 are configured such that a forty-sixth connection electrode to be formed subsequently is connected to the tenth P-type source region through these vias.

In an exemplary implementation, an orthographic projection of thirty-third via V33 on the silicon substrate may be within a range of an orthographic projection of a tenth N-type drain region of the tenth N-type transistor N10 on the silicon substrate. The first insulation layer and the second insulation layer within the thirty-third via V33 are etched away to expose a surface of the tenth N-type drain region. The thirty-third via V33 is configured such that a forty-seventh connection electrode to be formed subsequently is connected to the tenth N-type drain region through this via.

In an exemplary implementation, an orthographic projection of thirty-fourth via V34 on the silicon substrate may be within a range of an orthographic projection of a tenth N-type source region of the tenth N-type transistor N10 on the silicon substrate. The first insulation layer and the second insulation layer within the thirty-fourth via V34 are etched away to expose a surface of the tenth N-type source region. The thirty-fourth via V34 is configured such that a forty-eighth connection electrode to be formed subsequently is connected to the tenth N-type source region through this via.

In an exemplary implementation, orthographic projections of thirty-fifth vias V35 on the silicon substrate may be within a range of an orthographic projection of an eleventh P-type drain region of the eleventh P-type transistor P11 on the silicon substrate. The first insulation layer and the second insulation layer within the thirty-fifth vias V35 are etched away to expose a surface of the eleventh P-type drain region. The thirty-fifth vias V35 are configured such that a forty-ninth connection electrode to be formed subsequently is connected to the eleventh P-type drain region through these vias.

In an exemplary implementation, orthographic projections of thirty-sixth vias V36 on the silicon substrate may be within a range of an orthographic projection of an eleventh P-type source region of the eleventh P-type transistor P11 on the silicon substrate. The first insulation layer and the second insulation layer within the thirty-sixth vias V36 are etched away to expose a surface of the eleventh P-type source region. The thirty-sixth vias V36 are configured such that a fiftieth connection electrode to be formed subsequently is connected to the eleventh P-type source region through these vias.

In an exemplary implementation, an orthographic projection of thirty-seventh via V37 on the silicon substrate may be within a range of an orthographic projection of an eleventh N-type drain region of the eleventh N-type transistor N11 on the silicon substrate. The first insulation layer and the second insulation layer within the thirty-seventh via V37 are etched away to expose a surface of the eleventh N-type drain region. The thirty-seventh via V37 is configured such that a fifty-first connection electrode to be formed subsequently is connected to the eleventh N-type drain region through this via.

In an exemplary implementation, an orthographic projection of thirty-eighth via V38 on the silicon substrate may be within a range of an orthographic projection of an eleventh N-type source region of the eleventh N-type transistor N11 on the silicon substrate. The first insulation layer and the second insulation layer within the thirty-eighth via V38 are etched away to expose a surface of the eleventh N-type source region. The thirty-eighth via V38 is configured such that a fifty-second connection electrode to be formed subsequently is connected to the eleventh N-type source region through this via.

In an exemplary implementation, orthographic projections of thirty-ninth vias V39 on the silicon substrate may be within a range of an orthographic projection of a twelfth P-type drain region of the twelfth P-type transistor P12 on the silicon substrate. The first insulation layer and the second insulation layer within the thirty-ninth vias V39 are etched away to expose a surface of the twelfth P-type drain region. The thirty-ninth vias V39 are configured such that a fifty-third connection electrode to be formed subsequently is connected to the twelfth P-type drain region through these vias.

In an exemplary implementation, orthographic projections of fortieth vias V40 on the silicon substrate may be within a range of an orthographic projection of a twelfth P-type source region of the twelfth P-type transistor P12 on the silicon substrate. The first insulation layer and the second insulation layer within the fortieth vias V40 are etched away to expose a surface of the twelfth P-type source region. The fortieth vias V40 are configured such that a fifty-fourth connection electrode to be formed subsequently is connected to the twelfth P-type source region through these vias.

In an exemplary implementation, an orthographic projection of a forty-first via V41 on the silicon substrate may be within a range of an orthographic projection of a twelfth N-type drain region of the twelfth N-type transistor N12 on the silicon substrate. The first insulation layer and the second insulation layer within the forty-first via V41 are etched away to expose a surface of the twelfth N-type drain region. The forty-first via V41 is configured such that a fifty-fifth connection electrode to be formed subsequently is connected to the first region of the twelfth N-type drain region through this via.

In an exemplary implementation, an orthographic projection of the forty-second via V42 on the silicon substrate may be within a range of an orthographic projection of a twelfth N-type source region of the twelfth N-type transistor N12 on the silicon substrate. The first insulation layer and the second insulation layer within the forty-second via V42 are etched away to expose a surface of the twelfth N-type source region. The forty-second via V42 is configured such that the fifty-sixth connection electrode to be formed subsequently is connected to the twelfth N-type source region through this via.

In an exemplary implementation, orthographic projections of forty-third vias V43 on the silicon substrate may be within a range of an orthographic projection of the first P-type gate electrode 201P on the silicon substrate. The second insulation layer within the forty-third vias V43 is etched away to expose a surface of the first P-type gate electrode 201P. The forty-third vias V43 are configured such that a first connection electrode to be formed subsequently is connected to the first P-type gate electrode 201P through these vias.

In an exemplary implementation, orthographic projections of forty-fourth vias V44 on the silicon substrate may be within a range of an orthographic projection of the first N-type gate electrode 201N on the silicon substrate. The second insulation layer within the forty-fourth vias V44 is etched away to expose a surface of the first N-type gate electrode 201N. The forty-fourth vias V44 are configured such that a second connection electrode to be formed subsequently is connected to the first N-type gate electrode 201N through these vias.

In an exemplary implementation, orthographic projections of forty-fifth vias V45 on the silicon substrate may be within a range of an orthographic projection of the second P-type gate electrode 202P (also the second N-type gate electrode 202N) on the silicon substrate. The second insulation layer within the forty-fifth vias V45 is etched away to expose a surface of the second P-type gate electrode 202P (also the second N-type gate electrode 202N). The forty-fifth vias V45 are configured such that a third connection electrode to be formed subsequently is connected to the second P-type gate electrode 202P (also the second N-type gate electrode 202N) through these vias.

In an exemplary implementation, orthographic projections of forty-sixth vias V46 on the silicon substrate may be within a range of an orthographic projection of the third P-type gate electrode 203 P (also the third N-type gate electrode 203 N) on the silicon substrate. The second insulation layer within the forty-sixth vias V46 is etched away to expose a surface of the third P-type gate electrode 203 P (also the third N-type gate electrode 203 N). The forty-sixth vias V46 are configured such that a fourth connection electrode to be formed subsequently is connected to the third P-type gate electrode 203 P (also the third N-type gate electrode 203 N) through these vias.

In an exemplary implementation, orthographic projections of forty-seventh vias V47 on the silicon substrate may be within a range of an orthographic projection of the fourth P-type gate electrode 204P (also the fourth N-type gate electrode 204N) on the silicon substrate. The second insulation layer within the forty-seventh vias V47 is etched away to expose a surface of the fourth P-type gate electrode 204P (also the fourth N-type gate electrode 204N). The forty-seventh vias V47 are configured such that a fifth connection electrode to be formed subsequently is connected to the fourth P-type gate electrode 204P (also the fourth N-type gate electrode 204N) through these vias.

In an exemplary implementation, orthographic projections of forty-eighth vias V48 on the silicon substrate may be within a range of an orthographic projection of a fifth P-type gate electrode 205P on the silicon substrate. The second insulation layer within the forty-eighth vias V48 is etched away to expose a surface of the fifth P-type gate electrode 205P. The forty-eighth vias V48 are configured such that a sixth connection electrode formed subsequently is connected to the fifth P-type gate electrode 205P through these vias.

In an exemplary implementation, orthographic projections of forty-ninth vias V49 on the silicon substrate may be within a range of an orthographic projection of a fifth N-type gate electrode 205N on the silicon substrate. The second insulation layer within the forty-ninth vias V49 is etched away to expose a surface of the fifth N-type gate electrode 205N. The forty-ninth vias V49 are configured such that a seventh connection electrode to be formed subsequently is connected to the fifth N-type gate electrode 205N through these vias.

In an exemplary implementation, orthographic projections of fiftieth vias V50 on the silicon substrate may be within a range of an orthographic projection of a sixth P-type gate electrode 206P on the silicon substrate. The second insulation layer within the fiftieth vias V50 is etched away to expose a surface of the sixth P-type gate electrode 206P. The fiftieth vias V50 are configured such that an eighth connection electrode to be formed subsequently is connected to the sixth P-type gate electrode 206P through these vias.

In an exemplary implementation, orthographic projections of fifty-first vias V51 on the silicon substrate may be within a range of an orthographic projection of a sixth N-type gate electrode 206N on the silicon substrate. The second insulation layer within the fifty-first vias V51 is etched away to expose a surface of the sixth N-type gate electrode 206N. The fifty-first vias V51 are configured such that a ninth connection electrode to be formed subsequently is connected to the sixth N-type gate electrode 206N through these vias.

In an exemplary implementation, orthographic projections of fifty-second vias V52 on the silicon substrate may be within a range of an orthographic projection of a seventh P-type gate electrode 207P on the silicon substrate. The second insulation layer within the fifty-second vias V52 is etched away to expose a surface of the seventh P-type gate electrode 207P. The fifty-second vias V52 are configured such that a tenth connection electrode formed subsequently is connected to the seventh P-type gate electrode 207P through these vias.

In an exemplary implementation, orthographic projections of fifty-third vias V53 on the silicon substrate may be within a range of an orthographic projection of a seventh N-type gate electrode 207N on the silicon substrate. The second insulation layer within the fifty-third vias V53 is etched away to expose a surface of the seventh N-type gate electrode 207N. The fifty-third vias V53 are configured such that an eleventh connection electrode to be formed subsequently is connected to the seventh N-type gate electrode 207N through these vias.

In an exemplary implementation, orthographic projections of fifty-fourth vias V54 on the silicon substrate may be within a range of an orthographic projection of the eighth P-type gate electrode 208P (also the eighth N-type gate electrode 208N) on the silicon substrate. The second insulation layer within the fifty-fourth vias V54 being etched away to expose a surface of the eighth P-type gate electrode 208P (also the eighth N-type gate electrode 208N). The fifty-fourth vias V54 are configured such that a twelfth connection electrode to be formed is connected to the eighth P-type gate electrode 208P (also the eighth N-type gate electrode 208N) through these vias.

In an exemplary implementation, orthographic projections of fifty-fifth vias V55 on the silicon substrate may be within a range of an orthographic projection of the ninth P-type gate electrode 209P (also the ninth N-type gate electrode 209N) on the silicon substrate. The second insulation layer within the fifty-fifth vias V55 is etched away to expose a surface of the ninth P-type gate electrode 209P (also the ninth N-type gate electrode 209N). The fifty-fifth vias V55 are configured such that a thirteenth connection electrode to be formed subsequently is connected to the ninth P-type gate electrode 209P (also the ninth N-type gate electrode 209N) through these vias.

In an exemplary implementation, orthographic projections of fifty-sixth vias V56 on the silicon substrate may be within a range of an orthographic projection of the tenth P-type gate electrode 210P (also the tenth N-type gate electrode 210N) on the silicon substrate. The second insulation layer within the fifty-sixth vias V56 is etched away to expose a surface of the tenth P-type gate electrode 210P (also the tenth N-type gate electrode 210N). The fifty-sixth vias V56 are configured such that a fourteenth connection electrode to be formed subsequently is connected to the tenth P-type gate electrode 210N (also the tenth N-type gate electrode 210N) through these vias.

In an exemplary implementation, orthographic projections of fifty-seventh vias V57 on the silicon substrate may be within a range of an orthographic projection of the eleventh P-type gate electrode 211P (also the eleventh N-type gate electrode 211N) on the silicon substrate. The second insulation layer within the fifty-seventh vias V57 is etched away to expose a surface of the eleventh P-type gate electrode 211P (also the eleventh N-type gate electrode 211N). The fifty-seventh vias V57 are configured such that a fifteenth connection electrode to be formed subsequently is connected to the eleventh P-type gate electrode 211P (also the eleventh N-type gate electrode 211N) through these vias.

In an exemplary implementation, orthographic projections of fifty-eighth vias V58 on the silicon substrate may be within a range of an orthographic projection of the twelfth P-type gate electrode 212 P (also the twelfth N-type gate electrode 212 N) on the silicon substrate. The second insulation layer within the fifty-eighth vias V58 is etched away to expose a surface of the twelfth P-type gate electrode 212 P (also the twelfth N-type gate electrode 212 N). The fifty-eighth vias V58 are configured such that a sixteenth connection electrode to be formed subsequently is connected to the twelfth P-type gate electrode 212 P (also the twelfth N-type gate electrode 212 N) through these vias.

In an exemplary implementation, one or more of the first vias V1 to the ninth vias V58 may be multiple, to reduce the contact resistance and improve the connection reliability.

In an exemplary implementation, the forty-third vias V43 to the fifty-eighth vias V58 may be referred to as gate vias, and one or more of the above gate vias may be located in the gap regions 50 between the P-type active regions and the N-type active regions, so as to facilitate the arrangement of a plurality of connection electrodes to be formed subsequently, optimize the connection structure between the first conductive layer and the gate conductive layer, and reduce the occupied area of the gate drive circuit.

In an exemplary implementation, gate vias of the fourth transistor group in the third inverter may be referred to as first gate vias, the first gate vias are configured such that a first gate connection electrode to be formed subsequently is connected to a P-type gate electrode of a P-type transistor and an N-type gate electrode of an N-type transistor through the first gate via, and the first gate vias may be disposed in a gap region 50. The first gate vias may include the forty-seventh vias V47.

In an exemplary implementation, gate vias in the first inverter, the second inverter. The fourth inverter may be referred to as second gate vias, the second gate vias configured such that second gate connection electrodes to be formed subsequently is connected to the P-type gate electrodes of the P-type transistors and the N-type gate electrodes of the N-type transistors through the second gate vias. The second gate vias may be disposed in the gap regions 50. The second gate vias may include the fifty-sixth vias V56, the fifty-seventh vias V57, and the fifty-eighth vias V58.

In an exemplary implementation, gate vias in the first NAND gate and the second NAND gate may be referred to as third gate vias. The third gate vias are configured such that third gate connection electrodes to be formed subsequently are connected to the P-type gate electrodes of the P-type transistors and the N-type gate electrodes of the N-type transistors through the third gate vias. The third gate vias may be disposed in the gap regions 50. The third gate vias may include the forty-fifth vias V45, the forty-sixth vias V46, the fifty-fourth vias V54, and the fifty-fifth vias V55.

In an exemplary implementation, gate vias in the first transmission gate, the second transmission gate, and the third transmission gate may be referred to as fourth gate vias. The fourth gate vias may include fourth P-type gate vias and fourth N-type gate vias, wherein the fourth P-type gate vias are configured such that fourth P-type gate connection electrodes to be formed subsequently are connected to the P-type gate electrodes of the P-type transistors through the fourth P-type gate vias, and the fourth N-type gate vias are configured such that fourth N-type gate connection electrodes to be formed subsequently are connected to the N-type gate electrodes of the N-type transistors through the fourth N-type gate vias The fourth P-type gate vias may be disposed in the gap regions 50. The fourth P-type gate vias may include the forty-third vias V43, the fiftieth vias V50, and the fifty-second vias V52, and the fourth N-type gate vias may include the forty-fourth vias V44, the fifty-first vias V51, and the fifty-third vias V53.

In an exemplary implementation, gate vias of the fifth transistor group in the third inverter may be referred to as fourth gate vias.

In an exemplary implementation, positions of the first gate vias may be substantially on a gap centerline OC, and orthographic projections of the first gate vias on the silicon substrate are at least partially overlapped with an orthographic projection of the gap centerline OC on the silicon substrate.

In an exemplary implementation, at least one second gate via is closer to the N-type active region of the N-type transistor relative to the first gate vias in the second direction Y. For example, the fifty-eighth vias V58 (the second gate vias in the first inverter) are closer to the N-type active region of the N-type transistor than the forty-seventh vias V47 (the first gate vias in the third inverter).

In an exemplary implementation, at least one third gate via is closer to the P-type active region of the P-type transistor relative to the first gate vias in the second direction Y. For example, the forty-fifth vias V45 (the third gate vias in the first NAND gate) are closer to the P-type active region of the P-type transistor than the forty-seventh vias V47 (the first gate vias in the third inverter).

In an exemplary implementation, at least one fourth P-type gate via is closer to the P-type active region of the P-type transistor relative to the first gate vias in the second direction Y. For example, the forty-third vias V43 (the fourth P-type gate vias in the first transmission gate) are closer to the P-type active region of the P-type transistor than the forty-seventh vias V47 (the first gate vias in the third inverter).

In an exemplary implementation, at least one fourth N-type gate via is closer to the N-type active region of the N-type transistor relative to the first gate vias in the second direction Y. For example, the forty-fourth vias V44 (the fourth N-type gate vias in the first transmission gate) are closer to the N-type active region of the N-type transistor than the forty-seventh vias V47 (the first gate vias in the third inverter).

In an exemplary implementation, a plurality of second gate vias in the first inverter, the second inverter, and the fourth inverter may be located on a same straight line extending in the first direction X.

In an exemplary implementation, a plurality of third gate vias in the first NAND gate and the second NAND gate may be located on a same straight line extending in the first direction X.

In an exemplary implementation, in the first transmission gate, the second transmission gate, and the third transmission gate, a plurality of fourth P-type gate vias may be located on a same straight line extending in the first direction X, and a plurality of fourth N-type gate vias may be located on a same straight line extending in the first direction X.

In the present disclosure, by setting the positions of the gate vias, the connection structure between the first conductive layer and the gate conductive layer may be optimized, which is not only beneficial to process uniformity and signal transmission uniformity, but also beneficial to the arrangement of the plurality of connection electrodes to be formed subsequently.

In an exemplary implementation, orthographic projections of fifty-ninth vias V59 on the silicon substrate may be within a range of an orthographic projection of the power supply active region 100P on the silicon substrate. The first insulation layer and the second insulation layer within the fifty-ninth vias V59 are etched away to expose a surface of the power supply active region 100P. The fifty-ninth vias V59 are configured such that a first power line to be formed subsequently is connected to the power supply active region 100P through these vias.

In an exemplary implementation, the fifty-ninth vias V59 are multiple. A plurality of fifty-ninth vias V59 may be sequentially disposed in the first direction X, to reduce the contact resistance and improve the connection reliability.

In an exemplary implementation, orthographic projections of sixtieth vias V60 on the silicon substrate may be within a range of an orthographic projection of the ground active region 100N on the silicon substrate. The first insulation layer and the second insulation layer within the sixtieth via V60 are etched away to expose a surface of the ground active region 100N. The sixtieth vias V60 are configured such that a ground line to be formed subsequently is connected to the ground active region 100N through these vias.

In an exemplary implementation, the sixtieth vias V60 are multiple. A plurality of sixtieth vias V60 may be sequentially disposed in the first direction X, to reduce the contact resistance and improve the connection reliability.

In an exemplary implementation, a plurality of fifty-ninth vias V59 sequentially disposed in the first direction X form a first via row, a plurality of sixtieth vias V60 sequentially disposed in the first direction X form a second via row, and the first via row and the second via row are respectively located on two sides of the plurality of transistors in the second direction, so that the plurality of transistors are located between the first via row and the second via row, and mutual interference between different gate drive circuits can be effectively avoided.

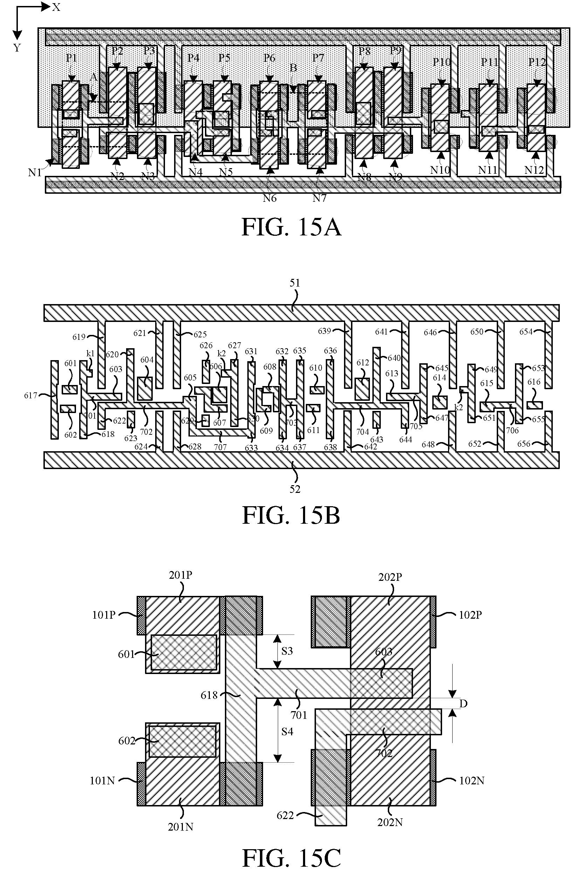

(7) A pattern of a first conductive layer is formed. In an exemplary implementation, forming a pattern of a first conductive layer may include: depositing a first conductive film on the silicon substrate, on which the aforementioned patterns are formed, and patterning the first conductive film through a patterning process, to form the pattern of the first conductive layer on the second insulation layer, as shown in FIGs. 15A and 15B, and FIG. 15B is a schematic diagram of the first conductive layer in FIG. 15A. In an exemplary implementation, the first conductive layer may be referred to as a first gate metal (Metal1) layer.

In an exemplary implementation, the pattern of the first conductive layer may include at least a first power supply line 51, a ground line 52, a first connection electrode 601 to a fifty-sixth connection electrode 656, and a first connection line 701 to a sixth connection line 706.

In an exemplary implementation, a shape of the first power supply line 51 may be a straight line or a polyline extending in the first direction X The first power supply line 51 may be disposed on a side of the plurality of transistors in a direction opposite to the second direction Y. The first power supply line 51 is connected to the power supply active region 100P through the plurality of fifty-ninth vias V59.

In an exemplary implementation, since the power supply active region 100P is located within the area where the N-well area 10 is located, the first power supply line 51 can write a first power supply signal to the N-well area 10, which can not only provide better current drive capability and response speed, meet the operation requirements of the output circuit, but also reduce the voltage drop and power consumption loss in the output circuit, and improve the overall efficiency of the output circuit.

In an exemplary implementation, a shape of the ground line 52 may be a straight line or a polyline extending in the first direction X. The ground line 52may be disposed on a side of the plurality of transistors in the second direction Y. The ground line 52 is connected to the ground active region 100N through the plurality of sixtieth vias V60.

In an exemplary implementation, since the ground active region 100N is located outside the area where the N-well area 10 is located, the ground line 52 can not only achieve a relatively stable potential reference and ensure that the output circuit has consistent and reliable performance under different working conditions, but also provide a better signal isolation effect, reduce the influence of interconnection capacitance, reduce signal crosstalk and interference, and improve the stability and reliability of the circuit.

In an exemplary implementation, the eleventh connection electrode 601 may be in a shape of a block (such as a rectangle). The eleventh connection electrode 601 is connected to the first P-type gate electrode 201P through the forty-first vias V43. The eleventh connection electrode 601 is configured to be connected to a first signal adapter line to be formed subsequently.

In an exemplary implementation, a second connection electrode 602 may be in a shape of a block (such as a rectangle). The second connection electrode 602 is connected to the first N-type gate electrode 201N through the forty-fourth vias V44. The second connection electrode 602 is configured to be connected to a second signal adapter line to be formed subsequently.

In an exemplary implementation, a third connection electrode 603 may be in a shape of a strip extending in the first direction X. The third connection electrode 603 is connected to the second P-type gate electrode 202P (also the second N-type gate electrode 202N) through the forty-fifth vias V45.

In an exemplary implementation, a fourth connection electrode 604 may be in a shape of a block (such as a rectangle). The fourth connection electrode 604 is connected to the third P-type gate electrode 203P (also the third N-type gate electrode 203N) through the forty-sixth vias V46. The fourth connection electrode 604 is configured to be connected to a third signal adapter line to be formed subsequently.

In an exemplary implementation, a fifth connection electrode 605 may be in a shape of a strip extending in the second direction Y. The fifth connection electrode 605 is connected to the fourth P-type gate electrode 204P (also the fourth N-type gate electrode 204N) through the forty-seventh vias V47.

In an exemplary implementation, a sixth connection electrode 606 may be in a shape of a block (such as a rectangle). The sixth connection electrode 606 is connected to the fifth P-type gate electrode 205P through the forty-eighth vias V48. The sixth connection electrode 606 is configured to be connected to a signal adapter line to be formed subsequently.

In an exemplary implementation, a seventh connection electrode 607 may be in a shape of a polyline extending in the first direction X. A first terminal of the seventh connection electrode 607 is connected to the fifth N-type gate electrode 205N through the forty-ninth vias V49. A second terminal of the seventh connection electrode 607 extends in a direction to the fourth P-type gate electrode 204P. The second terminal of the seventh connection electrode 607 is configured to be connected to the first signal adapter line to be formed subsequently.

In an exemplary implementation, an eighth connection electrode 608 may be in a shape of an "L" shape. A first terminal of the eighth connection electrode 608 is connected to the sixth P-type gate electrode 206P through the fiftieth vias V50. A second terminal of the eighth connection electrode 608 extends in a direction to the sixth N-type gate electrode 206N. The second terminal of the eighth connection electrode 608 is configured to be connected to the second signal adapter line to be formed subsequently.

In an exemplary implementation, a ninth connection electrode 609 may be in a shape of an "L" shape. A first terminal of the ninth connection electrode 609 is connected to the sixth N-type gate electrode 206N through the fifty-first vias V51. A second terminal of the ninth connection electrode 609 extends in a direction to the sixth P-type gate electrode 206P. The second terminal of the ninth connection electrode 609 is configured to be connected to the first signal adapter line to be formed subsequently.

In an exemplary implementation, a tenth connection electrode 610 may be in a shape of a block (such as a rectangle). The tenth connection electrode 610 is connected to the seventh P-type gate electrode 207P through the fifty-second vias V52. The tenth connection electrode 610 is configured to be connected to the first signal adapter line to be formed subsequently.

In an exemplary implementation, an eleventh connection electrode 611 may be in a shape of a block (such as a rectangle). The eleventh connection electrode 611 is connected to the seventh N-type gate electrode 207N through the fifty-third vias V53. The eleventh connection electrode 611 is configured to be connected to the second signal adapter line to be formed subsequently.

In an exemplary implementation, a twelfth connection electrode 612 may be in a shape of a block (such as a rectangle). The twelfth connection electrode 612 is connected to the eighth P-type gate electrode 208P (also the eighth N-type gate electrode 208N) through the fifty-fourth vias V54. The twelfth connection electrode 612 is configured to be connected to a third signal adapter line to be formed subsequently.

In an exemplary implementation, a thirteenth connection electrode 613 may be in a shape of a block (such as a rectangle). The thirteenth connection electrode 613 is connected to the ninth P-type gate electrode 209P (also the ninth N-type gate electrode 209N) through the fifty-fifth vias V55.

In an exemplary implementation, a fourteenth connection electrode 614 may be in a shape of a block (such as a rectangle). The fourteenth connection electrode 614 is connected to the tenth P-type gate electrode 210P (also the tenth N-type gate electrode 210N) through the fifty-sixth via V56. The fourteenth connection electrode 614 is configured to be connected to a fifth signal adapter line to be formed subsequently.

In an exemplary implementation, a fifteenth connection electrode 615 may be in a shape of a block (such as a rectangle). The fifteenth connection electrode 615 is connected to the eleventh P-type gate electrode 211P (also the eleventh N-type gate electrode 211N) through the fifty-seventh vias V57.

In an exemplary implementation, a sixteenth connection electrode 616 may in a shape of a block (such as a rectangle). The sixteenth connection electrode 616 is connected to the twelfth P-type gate electrode 212 P (also the twelfth N-type gate electrode 212 N) through the fifty-eighth vias V 58. In an exemplary implementation, the sixteenth connection electrode 616 may be connected to a clock signal terminal CK of a shift register circuit to be formed subsequently, so that the clock signal terminal CK of the shift register circuit writes a clock signal into a gate electrode of the twelfth P-type transistor P12 and a gate electrode of the twelfth N-type transistor N12.

In an exemplary implementation, the first connection electrode 601 to the sixteenth connection electrode 616 may be referred to as gate connection electrodes, and the gate connection electrodes are connected to the corresponding gate electrodes through the corresponding gate vias.

In an exemplary implementation, the gate connection electrodes in the third inverter may include the fifth connection electrode 605, the sixth connection electrode 606, and the seventh connection electrode 607, and the fifth connection electrode 605 may be referred to as a first gate connection electrode.

In an exemplary implementation, the gate connection electrodes in the first inverter, the second inverter, and the fourth inverter may include the fourteenth connection electrode 614, the fifteenth connection electrode 615, and the sixteenth connection electrode 616, and the above-described gate connection electrodes may be referred to as second gate connection electrodes.

In an exemplary implementation, the gate connection electrodes in the first NAND gate may include the third connection electrode 603 and the fourth connection electrode 604, and the gate connection electrodes in the second NAND gate may include the twelfth connection electrode 612 and the thirteenth connection electrode 613, and the above-described gate connection electrodes may be referred to as third gate connection electrodes.

In an exemplary implementation, the P-type gate connection electrodes in the first transmission gate, the second transmission gate, and the third transmission gate may include the first connection electrode 601, the eighth connection electrode 608, and the tenth connection electrode 610, and the above-described gate connection electrodes may be referred to as fourth P-type gate connection electrodes. The N-type gate connection electrodes in the first transmission gate, the second transmission gate, and the third transmission gate may include the second connection electrode 602, the ninth connection electrode 609, and the eleventh connection electrode 611, and the above-described gate connection electrodes may be referred to as fourth N-type gate connection electrodes.

In an exemplary implementation, a seventeenth connection electrode 617 may be in a shape of a strip extending in the second direction Y. A first terminal of the seventeenth connection electrode 617 is connected to the first P-type source region through the first vias V1. A second terminal of the seventeenth connection electrode 617 is connected to the first N-type source region through the third vias V3. The seventeenth connection electrode 617 realizes interconnection between the first electrode (source electrode) of the first P-type transistor P1 and the first electrode (source electrode) of the first N-type transistor N1.

In an exemplary implementation, the seventeenth connection electrode 617 may be connected to an input terminal D of a shift register circuit to be formed subsequently, so that the input terminal D of the shift register circuit writes an input signal into the first electrode of the first P-type transistor P1 and the first electrode of the first N-type transistor N1.

In an exemplary implementation, an eighteenth connection electrode 618 may be in a shape of a strip extending in the second direction Y. A first terminal of the eighteenth connection electrode 618 is connected to the first P-type drain region through the second vias V2. A second terminal of the eighteenth connection electrode 618 is connected to the first N-type drain region through the fourth vias V4,

In an exemplary implementation, the eighteenth connection electrode 618 is connected to a first bump k1, and the first bump k1 is configured to be connected to a fourth signal adapter line to be formed subsequently.

In an exemplary implementation, a nineteenth connection electrode 619 may be in a shape of a strip extending in the second direction Y. A first terminal of the nineteenth connection electrode 619 is connected to the first power supply line 51. A second terminal of the nineteenth connection electrode 619 is connected to the second P-type source region through the fifth vias V5, so that the first power supply line 51 writes a first power supply signal into the first electrode (source electrode) of the second P-type transistor P2.

In an exemplary implementation, a twentieth connection electrode 620 may be in a shape of a strip extending in the second direction Y. The twentieth connection electrode 620 is connected to the second P-type drain region (also the third P-type drain region) through the sixth vias V6. In an exemplary implementation, the second P-type drain region (a second region of the second P-type active region) and the third P-type drain region (a second region of the third P-type active region) share a same active region, and the twentieth connection electrode 620 may simultaneously serve as the second P-type drain electrode of the second P-type transistor P 2 and the second P-type drain electrode of the third P-type transistor P 3, that is, the second P-type drain electrode and the third P-type drain electrode share a same connection electrode.

In an exemplary implementation, a twenty-first connection electrode 621 may be in a shape of a strip extending in the second direction Y. A first terminal of the twenty-first connection electrode 621 is connected to the first power supply line 51, and a second terminal of the twenty-first connection electrode 621 is connected to the third P-type source region through the seventh vias V7, so that the first power supply line 51 writes the first power supply signal into the first electrode (source electrode) of the third P-type transistor P3.

In an exemplary implementation, a twenty-second connection electrode 622 may be in a shape of a strip extending in the second direction Y. The twenty-second connection electrode 622 is connected to the second N-type drain region through the eighth vias V8.

In an exemplary implementation, a twenty-third connection electrode 623 may be in a shape of a strip extending in the second direction Y. The twenty-third connection electrode 623 is connected to the second N-type source region (also the third N-type drain region) through the ninth vias V9.

In an exemplary implementation, a twenty-fourth connection electrode 624 may be in a shape of a strip extending in the second direction Y. A first terminal of the twenty-fourth connection electrode 624 is connected to the ground line 52. A second terminal of the twenty-fourth connection electrode 624 is connected to the third N-type source region through the tenth vias V10, so that the first electrode (source electrode) of the third N-type transistor N3 is grounded.

In an exemplary implementation, a twenty-fifth connection electrode 625 may be in a shape of a strip extending in the second direction Y. A first terminal of the twenty-fifth connection electrode 625 is connected to the first power supply line 51. A second terminal of the twenty-fifth connection electrode 625 is connected to the fourth P-type source region through the eleventh vias V11, so that the first power supply line 51 writes the first power supply signal into the first electrode (source electrode) of the fourth P-type transistor P4.

In an exemplary implementation, a twenty-sixth connection electrode 626 may be in a shape of a strip extending in the second direction Y. The twenty-sixth connection electrode 626 is connected to the fourth P-type drain region (also the fifth P-type source region) through the twelfth vias V12.

In an exemplary implementation, a twenty-seventh connection electrode 627 may be in a shape of a strip extending in the second direction Y. The twenty-seventh connection electrode 627 is connected to the fifth P-type drain region through the thirteenth vias V13.

In an exemplary implementation, the twenty-seventh connection electrode 627 is connected to a second bump k2, and the second bump k2 is configured to be connected to the fourth signal adapter line to be formed subsequently.

In an exemplary implementation, a twenty-eighth connection electrode 628 may be in a shape of a strip extending in the second direction Y. A first terminal of the twenty-eighth connection electrode 628 is connected to the ground line 52. A second terminal of the twenty-eighth connection electrode 628 is connected to the fourth N-type source region through the fourteenth via V14, so that a first electrode (source electrode) of the fourth N-type transistor N4 is grounded.

In an exemplary implementation, a twenty-ninth connection electrode 629 may be in a shape of a strip extending in the second direction Y. The twenty-ninth connection electrode 629 is connected to the fourth N-type drain region (also the fifth N-type source region) through the fifteenth via V15.

In an exemplary implementation, a thirtieth connection electrode 630 may be in a shape of a strip extending in the second direction Y. The thirtieth connection electrode 630 is connected to the fifth N-type drain region through the sixteenth via V16.

In an exemplary implementation, the twenty-seventh connection electrode 627 and the thirtieth connection electrode 630 may be interconnected into an integral structure, thereby realizing interconnection between the second electrode (drain electrode) of the fifth P-type transistor P 5 and the second electrode (drain electrode) of the fifth N-type transistor N 5.

In an exemplary implementation, a thirty-first connection electrode 631 may be in a shape of a strip extending in the second direction Y. The thirty-first connection electrode 631 is connected to the sixth P-type source region through the seventeenth vias V17.

In an exemplary implementation, a thirty-second connection electrode 632 may be in a shape of a strip extending in the second direction Y. A first terminal of the thirty-second connection electrode 632 is connected to the sixth P-type drain region through the eighteenth vias V18,

In an exemplary implementation, a thirty-third connection electrode 633 may be in a shape of a strip extending in the second direction Y. The thirty-third connection electrode 633 is connected to the sixth N-type drain region through the nineteenth vias V19,

In an exemplary implementation, the thirty-first connection electrode 631 and the thirty-third connection electrode may be interconnected into an integral structure, thus realizing an interconnection between the first electrode (source electrode) of the sixth P-type transistor P 6 and the first electrode (source electrode) of the sixth N-type transistor N 6.

In an exemplary implementation, the thirty-fourth connection electrode 634 may be in a shape of a strip extending in the second direction Y. The thirty-fourth connection electrode 634 is connected to the sixth N-type drain region through the twentieth vias V20.

In an exemplary implementation, the thirty-second connection electrode 632 and the thirty-fourth connection electrode 634 may be interconnected into an integral structure, thus realizing an interconnection between the second electrode (drain electrode) of the sixth P-type transistor P 6 and the second electrode (drain electrode) of the sixth N-type transistor N 6.

In an exemplary implementation, the sixth P-type drain region is a second region of the sixth P-type active region, the sixth N-type drain region is a second region of the sixth P-type active region, the thirty-second connection electrode 632 may serve as the sixth P-type drain electrode, and the thirty-fourth connection electrode 634 may serve as the sixth N-type drain electrode, so that the sixth P-type drain electrode and the sixth N-type drain electrode are interconnected into an integral structure.

In an exemplary implementation, a thirty-fifth connection electrode 635 may be in a shape of a strip extending in the second direction Y. The thirty-fifth connection electrode 635 is connected to the seventh P-type source region through the twenty-first vias V21.

In an exemplary implementation, a thirty-sixth connection electrode 636 may be in a shape of a strip extending in the second direction Y. The thirty-sixth connection electrode 636 is connected to the seventh P-type drain region through the twenty-second vias V22.

In an exemplary implementation, a thirty-seventh connection electrode 637 may be in a shape of a strip extending in the second direction Y. The thirty-seventh connection electrode 637 is connected to the seventh N-type source region through the twenty-third vias V23.

In an exemplary implementation, the thirty-fifth connection electrode 635 and the thirty-seventh connection electrode 637 may be interconnected into an integral structure, thus realizing an interconnection between the first electrode (source electrode) of the seventh P-type transistor P 7 and the first electrode (source electrode) of the seventh N-type transistor N 7.

In an exemplary implementation, the sixth P-type source region is a first region of the seventh P-type active region, the seventh N-type source region is a first region of the seventh P-type active region, the thirty-fifth connection electrode 635 may serve as the seventh P-type source electrode, and the thirty-seventh connection electrode 637 may serve as the seventh N-type source electrode, so that the seventh P-type source electrode and the seventh N-type source electrode are interconnected into an integral structure.

In an exemplary implementation, a thirty-eighth connection electrode 638 may be in a shape of a strip extending in the second direction Y. The thirty-eighth connection electrode 638 is connected to the seventh N-type drain region through the twenty-fourth vias V24.

In an exemplary implementation, the thirty-sixth connection electrode 636 and the thirty-eighth connection electrode 638 may be interconnected into an integral structure, thus realizing an interconnection between the second electrode (drain electrode) of the seventh P-type transistor P 7 and the second electrode (drain electrode) of the seventh N-type transistor N 7.

In an exemplary implementation, a thirty-ninth connection electrode 639 may be in a shape of a strip extending in the second direction Y. A first terminal of the thirty-ninth connection electrode 639 is connected to the first power supply line 51, and a second terminal of the thirty-ninth connection electrode 639 is connected to the eighth P-type source region through the twenty-fifth vias V25, so that the first power supply line 51 writes the first power supply signal into the first electrode (source electrode) of the eighth P-type transistor P8.

In an exemplary implementation, a fortieth connection electrode 640 may be in a shape of a strip extending in the second direction Y. The fortieth connection electrode 640 is connected to the eighth P-type drain region (also the ninth P-type drain region) through the twenty-sixth vias V26.

In an exemplary implementation, a forty-first connection electrode 641 may be in a shape of a strip extending in the second direction Y. A first terminal of the forty-first connection electrode 641 is connected to the first power supply line 51, and a second terminal of the forty-first connection electrode 641 is connected to the ninth P-type source region through the twenty-seventh vias V27, so that the first power supply line 51 writes the first power supply signal into the first electrode (source electrode) of the ninth P-type transistor P9.

In an exemplary implementation, a forty-second connection electrode 642 may be in a shape of a strip extending in the second direction Y. A first terminal of the forty-second connection electrode 642 is connected to the ground line 52, and a second terminal of the forty-second connection electrode 642 is connected to the eighth N-type source region through the twenty-eighth vias V28, so that the first electrode (source electrode) of the eighth N-type transistor N8 is grounded.

In an exemplary implementation, a forty-third connection electrode 643 may be in a shape of a strip extending in the second direction Y. The forty-third connection electrode 643 is connected to the eighth N-type drain region (also the ninth N-type source region) through the twenty-ninth vias V29.

In an exemplary implementation, a forty-fourth connection electrode 644 may be in a shape of a strip extending in the second direction Y. The forty-fourth connection electrode 644 is connected to the ninth N-type drain region through the thirtieth vias V30.

In an exemplary implementation, a forty-fifth connection electrode 645 may be a strip extending in the second direction Y, and the forty-fifth connection electrode 645 is connected to the tenth P-type drain region through the thirty-first via V31.

In an exemplary implementation, the shape of the forty-sixth connection electrode 646 may be in a shape of a strip extending in the second direction Y. A first terminal of the forty-sixth connection electrode 646 is connected to the first power supply line 51, and a second terminal of the forty-sixth connection electrode 646 is connected to the tenth P-type source region through the thirty-second vias V32, so that the first power supply line 51 writes the first power supply signal into the first electrode (source electrode) of the tenth P-type transistor P10.

In an exemplary implementation, a forty-seventh connection electrode 647 may be in a shape of a strip extending in the second direction Y. The forty-seventh connection electrode 647 is connected to the tenth N-type drain region through the thirty-third via V33.

In an exemplary implementation, the forty-fifth connection electrode 645 and the forty-seventh connection electrode 647 may be interconnected into an integral structure, thus realizing an interconnection between the second electrode (drain electrode) of the tenth P-type transistor P 10 and the second electrode (drain electrode) of the tenth N-type transistor N 10.

In an exemplary implementation, a forty-eighth connection electrode 648 may be in a shape of a strip extending in the second direction Y. A first terminal of the forty-eighth connection electrode 648 is connected to the ground line 52, and a second terminal of the forty-eighth connection electrode 648 is connected to the tenth N-type source region through the thirty-fourth via V34, so that the first electrode (source electrode) of the tenth N-type transistor N10 is grounded.

In an exemplary implementation, a forty-ninth connection electrode 649 may be in a shape of a strip extending in the second direction Y. The forty-ninth connection electrode 649 is connected to the eleventh P-type drain region through the thirty-fifth vias V35. In an exemplary implementation, the forty-ninth connection electrode 649 is a second electrode of the eleventh P-type transistor P11.

In an exemplary implementation, a fiftieth connection electrode 650 may be in a shape of a strip extending in the second direction Y. A first terminal of the fiftieth connection electrode 650 is connected to the first power supply line 51, and a second terminal of the fiftieth connection electrode 650 is connected to the eleventh P-type source region through the thirty-sixth vias V36, so that the first power supply line 51 writes the first power supply signal into the first electrode (source electrode) of the eleventh P-type transistor P11.

In an exemplary implementation, a fifty-first connection electrode 651 may be in a shape of a strip extending in the second direction Y. The fifty-first connection electrode 651 is connected to the eleventh N-type drain region through the thirty-seventh via V37. In an exemplary implementation, the fifty-first connection electrode 651 is a second electrode connection of the eleventh N-type transistor N11

In an exemplary implementation, the forty-ninth connection electrode 649 and the fifty-first connection electrode 651 may be interconnected into an integral structure, thus realizing an interconnection between the second electrode (drain electrode) of the eleventh P-type transistor P 11 and the second electrode (drain electrode) of the eleventh N-type transistor N 11.

In an exemplary implementation, a third bump k3 is connected to the forty-ninth connection electrode 649 and the fifty-first connection electrode 651 in an integral structure, and the third bump k3 is configured to be connected to a first signal adapter line to be formed subsequently.

In an exemplary implementation, the forty-ninth connection electrode 649, the fifty-first connection electrode 651, and the third bump k3 may be interconnected into an integral structure.

In an exemplary implementation, the fifty-second connection electrode 652 may be in a shape of a strip extending in the second direction Y. A first terminal of the fifty-second connection electrode 652 is connected to the ground line 52, and a second terminal of the fifty-second connection electrode 652 is connected to the eleventh N-type source region through the thirty-eighth via V38, so that the first electrode (source electrode) of the eleventh N-type transistor N11 is grounded.

In an exemplary implementation, a fifty-third connection electrode 653 may be in a shape of a strip extending in the second direction Y. The fifty-third connection electrode 653 is connected to the twelfth P-type drain region through the thirty-ninth visa V39.

In an exemplary implementation, a fifty-fourth connection electrode 654 may be in a shape of a strip in which a main body portion extends in the second direction Y. A first terminal of the fifty-fourth connection electrode 654 is connected to the first power supply line 51, and a second terminal of the fifty-fourth connection electrode 654 is connected to the twelfth P-type source region through the fortieth vias V40, so that the first power supply line 51 writes the first power supply signal into the first electrode (source electrode) of the twelfth P-type transistor P12.

In an exemplary implementation, a fifty-fifth connection electrode 655 may be in a shape of a strip extending in the second direction Y. The fifty-fifth connection electrode 655 is connected to the twelfth N-type drain region through the forty-first via V41.

In an exemplary implementation, the fifty-third connection electrode 653 and the fifty-fifth connection electrode 655 may be interconnected into an integral structure, thus realizing an interconnection between the second electrode (drain electrode) of the twelfth P-type transistor P 12 and the second electrode (drain electrode) of the twelfth N-type transistor N 12.

In an exemplary implementation, a fifty-sixth connection electrode 656 may be in a shape of a strip in which a main body portion extends in the second direction Y. A first terminal of the fifty-sixth connection electrode 656 is connected to the ground line 52, and a second terminal of the fifty-sixth connection electrode 656 is connected to the twelfth N-type source region through the forty-second via V42, so that the first electrode (source electrode) of the twelfth N-type transistor N12 is grounded.

In an exemplary implementation, a first connection line 701 may be in a shape of a strip extending in the first direction X. A first end of the first connection line 701 is connected to the eighteenth connection electrode 618, and a second end of the first connection line 701 is connected to the third connection electrode 603. In an exemplary implementation, the first connection line 701 realizes an interconnection between the second electrode (drain electrode) of the first P-type transistor P1, the second electrode (drain electrode) of the first N-type transistor N1, the gate electrode of the second P-type transistor P2, and the gate electrode of the second N-type transistor N2.

In an exemplary implementation, the third connection electrode 603, the eighteenth connection electrode 618, and the first connection line 701 may be interconnected into an integral structure.

In an exemplary implementation, a second connection line 702 may be in a shape of a strip extending in the first direction X. A first end of the second connection line 702 is connected to the twenty-second connection electrode 622, a second end of the second connection line 702 is connected to the fifth connection electrode 605, and a portion between the first end and the second end of the second connection line 702 is connected to the twentieth connection electrode 620. In an exemplary implementation, the second connection line 702 realizes an interconnection between the second electrode of the second P-type transistor P2, the second electrode of the second N-type transistor N2, the second electrode of the third P-type transistor P3, the gate electrode of the fourth P-type transistor P4, and the gate electrode of the fourth N-type transistor N4.

In an exemplary implementation, the fifth connection electrode 605, the twentieth connection electrode 620, the twenty-second connection electrode 622, and the second connection line 702 may be interconnected into an integral structure.

In an exemplary implementation, an orthographic projection of the second connection line 702 on the silicon substrate is at least partially overlapped with orthographic projections of the second P-type gate electrode 202P and the second N-type gate electrode 202N in an integral structure on the silicon substrate, and the orthographic projection of the second connection line 702 on the silicon substrate is at least partially overlapped with orthographic projections of the third P-type gate electrode 203P and the third N-type gate electrode 203N in an integral structure on the silicon substrate, that is, the second connection line 702 is connected to the gate electrodes of the fourth transistor group (the fourth P-type transistor P4 and the fourth N-type transistor N4) across the gate electrodes of the second transistor group (the second P-type transistor P2 and the third N-type transistor P3) and the gate electrodes of the third transistor group (the third P-type transistor P3 and the third N-type transistor N3).

In an exemplary implementation, a third connection line 703 may in a shape of a strip extending in the first direction X. A first end of the third connection line 703 is connected to the thirty-second connection electrode 632 and the thirty-fourth connection electrode 634 in an integral structure, and a second end of the third connection line 703 is connected to the thirty-fifth connection electrode 635 and the thirty-seventh connection electrode 637 in an integral structure. In an exemplary implementation, the third connection line 703 realizes an interconnection between the second electrode of the sixth P-type transistor P6, the second electrode of the sixth N-type transistor N6, the first electrode of the seventh P-type transistor P7, and the first electrode of the seventh N-type transistor N7.

In an exemplary implementation, the thirty-second connection electrode 632, the thirty-fourth connection electrode 634, the thirty-fifth connection electrode 635, the thirty-seventh connection electrode 637, and the third connection line 703 may be interconnected into an integral structure.

In an exemplary implementation, a fourth connection line 704 may be in a shape of a strip extending in the first direction X. A first end of the fourth connection line 704 is connected to the thirty-sixth connection electrode 636 and the thirty-eighth connection electrode 638 in an integral structure, a second end of the fourth connection line 704 is connected to the forty-fourth connection electrode 644, and a portion between the first end and the second end of the fourth connection line 704 is connected to the fortieth connection electrode 640. The fourth connection line 704 realizes an interconnection between the second electrode of the seventh P-type transistor P7, the second electrode of the seventh N-type transistor N7, the second electrode of the eighth P-type transistor P8, the second electrode of the ninth P-type transistor P9, and the second electrode of the ninth N-type transistor N9.

In an exemplary implementation, the thirty-sixth connection electrode 636, the thirty-eighth connection electrode 638, the fortieth connection electrode 640, the forty-fourth connection electrode 644, and the fourth connection line 704 may be interconnected into an integral structure.

In an exemplary implementation, the fourth connection line 704, the second electrode of the seventh P-type transistor P7, the second electrode of the seventh N-type transistor N7, the second electrode of the eighth P-type transistor P8, the second electrode of the ninth P-type transistor P9, and the second electrode of the ninth N-type transistor N9 in an integral structure may serve as the second output terminal Q_ of the shift register circuit and be connected to the second input terminal of the logical transition unit, so that the shift register circuit transmits the second output signal to the logical transition unit.

In an exemplary implementation, an orthographic projection of the fourth connection line 704 on the silicon substrate is at least partially overlapped with orthographic projections of the eighth P-type gate electrode 208P and the eighth N-type gate electrode 208N in an integral structure on the silicon substrate, and the orthographic projection of the fourth connection line 704 on the silicon substrate is at least partially overlapped with orthographic projections of the ninth P-type gate electrode 209P and the ninth N-type gate electrode 209N in an integral structure on the silicon substrate, that is, the fourth connection line 704 is connected to the second electrode of the ninth N-type transistor N9 across the gate electrodes of the eighth transistor group (the eighth P-type transistor P8 and the eighth N-type transistor N8) and the gate electrodes of the ninth transistor group (the ninth P-type transistor P9 and the ninth N-type transistor N9).

In an exemplary implementation, a fifth connection line 705 may be in a shape of a strip extending in the first direction X. A first end of the fifth connection line 705 is connected to the thirteenth connection electrode 613, and a second end of the fifth connection line 705 is connected to the forty-fifth connection electrode 645 and the forty-seventh connection electrode 647 in an integral structure. The fifth connection line 705 realizes an interconnection between the gate electrode of the ninth P-type transistor P9, the gate electrode of the ninth N-type transistor N9, the second electrode of the tenth P-type transistor P10, and the second electrode of the tenth N-type transistor N10.

In an exemplary implementation, the thirteenth connection electrode 613, the forty-fifth connection electrode 645, the forty-seventh connection electrode 647, and the fifth connection line 705 may be interconnected into an integral structure.

In an exemplary implementation, the fifth connection line 705, the gate electrode of the ninth P-type transistor P9, the gate electrode of the ninth N-type transistor N9, the second electrode of the tenth P-type transistor P10, and the second electrode of the tenth N-type transistor N10 in an integral structure may serve as the first output terminal Q of the shift register circuit and be connected to the first input terminal of the logical transition unit, so that the shift register circuit transmits the first output signal to the logical transition unit.

In an exemplary implementation, a sixth connection line 706 may be in a shape of a strip extending in the first direction X. A first end of the sixth connection line 706 is connected to the fifteenth connection electrode 615, and a second end of the sixth connection line 706 is connected to the fifty-third connection electrode 653 and the fifty-fifth connection electrode 655 in an integral structure. The sixth connection line 706 realizes an interconnection between the gate electrode of the eleventh P-type transistor P11, the gate electrode of the eleventh N-type transistor N11, the second electrode of the twelfth P-type transistor P12, and the second electrode of the twelfth N-type transistor N12.

In an exemplary implementation, the fifteenth connection electrode 615, the fifty-third connection electrode 653, the fifty-fifth connection electrode 655, and the sixth connection line 706 may be interconnected into an integral structure.

In an exemplary implementation, a seventh connection line 707 may be in a shape of a strip extending in the first direction X. A first end of the seventh connection line 707 is connected to the fifth connection electrode 605, and a second end of the seventh connection line 707 is connected to the thirty-first connection electrode 631 and the thirty-third connection electrode 633 in an integral structure. The seventh connection line 707 realizes an interconnection between the gate electrode of the fourth P-type transistor P4, the gate electrode of the fourth N-type transistor N4, the first electrode of the sixth P-type transistor P6, and the first electrode of the sixth N-type transistor N6.

In an exemplary implementation, the fifth connection electrode 605, the thirty-first connection electrode 631, the thirty-third connection electrode 633, and the seventh connection line 707 may be interconnected into an integral structure.

In an exemplary implementation, the seventh connection line 707 may be located on a side of the fifth N-type active region 105N away from the fifth P-type active region 105P, and an orthographic projection of the seventh connection line 707 on the silicon substrate is not overlapped with an orthographic projection of the fifth N-type gate electrode 205N on the silicon substrate.

In an exemplary implementation, since the second connection line 702 and the seventh connection line 707 are both connected to the fifth connection electrode 605, the second connection line 702 realizes an interconnection between the second electrode of the second P-type transistor P2, the second electrode of the third P-type transistor P3, the second electrode of the second N-type transistor N2, the gate electrode of the fourth P-type transistor P4, and the gate electrode of the fourth N-type transistor N4, and the seventh connection line 707 realizes an interconnection between the gate electrode of the fourth P-type transistor P4, the gate electrode of the fourth N-type transistor N4, the first electrode of the sixth P-type transistor P6 and the first electrode of the sixth N-type transistor N6, thereby realizing an interconnection between the second electrode of the second P-type transistor P2, the second electrode of the second N-type transistor N2, the second electrode of the third P-type transistor P3, the gate electrode of the fourth P-type transistor P4, the gate electrode of the fourth N-type transistor N4, the first electrode of the sixth P-type transistor P6 and the first electrode of the sixth N-type transistor N6.

In an exemplary implementation, the fifth connection electrode 605, the twentieth connection electrode 620, the twenty-second connection electrode 622, the thirty-first connection electrode 631, the thirty-third connection electrode 633, the second connection line 702, and the seventh connection line 707 may be interconnected into an integral structure.

In an exemplary implementation, one or more of the first connection line 701 to the sixth connection line 706 may be located in the gap regions 50 between the P-type active regions and the N-type active regions, which not only facilitates optimization of the connection structure, but also reduces the influence on the transistor channel areas.

FIG. 15C is a schematic diagram of an area A in FIG. 15A. As shown in FIGS. 15A, 15B, and 15C, for the first connection line 701 in a shape of a strip extending in the first direction X, in the second direction Y, at least a portion of the first connection line 701 is disposed between the first P-type active region 101P and the first N-type active region 101N, and at least a portion of the first connection line 701 is disposed between the second P-type active region 102P and the second N-type active region 102N. For the second connection line 702 in a shape of a strip extending in the first direction X, in the second direction Y, at least a portion of the second connection line 702 is disposed between the second P-type active region 102P and the second N-type active region 102N, at least a portion of the second connection line 702 is disposed between the third P-type active region 103P and the third N-type active region 103N, and the second connection line 702 may be disposed on a side of the first connection line 701 in the second direction Y (close to the second N-type active region 102N).

In an exemplary implementation, there is an electrode distance D between an edge of the first connection line 701 close to the second connection line 702 and an edge of the second connection line 702 close to the first connection line 701, and the electrode distance D may be greater than or equal to 0.256 µm, and on the basis of meeting the process requirements, metal adhesion between electrodes is avoided.

In an exemplary implementation, there is a third distance S3 between an edge of the first connection line 701 close to the first P-type active region 101P and an edge of the first P-type active region 101P close to the first connection line 701, and there is a fourth distance S4 between an edge of the first connection line 701 close to the first N-type active region 101N and an edge of the first N-type active region 101N close to the first connection line 701, and the third distance S3 may be less than or equal to the fourth distance S4.

In an exemplary implementation, a ratio of the third distance S3 to the fourth distance S4 may be about 0.8 to 1.0.

In an exemplary implementation, since the first connection line 701 is connected to the eighteenth connection electrode 618, the eighteenth connection electrode 618 is respectively connected to the first P-type drain region and the first N-type drain region, and the eighteenth connection electrode 618 simultaneously serves as the first P-type drain electrode of the first P-type transistor and the first N-type drain electrode of the first N-type transistor, it may affect the signal writing quality to set positions of the first connection line 701. In the present disclosure, by setting the distance relationships between the first connection line and the first P-type active region and the first N-type active region, the first connection line is basically disposed in a middle area between two active regions, and synchronization of signal writing can be ensured.

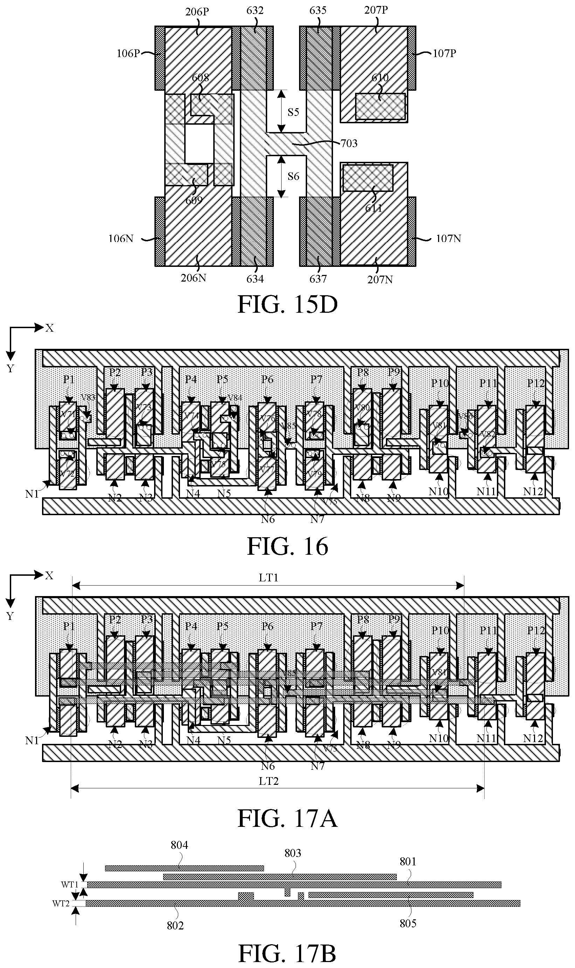

FIG. 15D is a schematic diagram of an area B in FIG. 15A. As shown in FIGS. 15A, 15B, and 15D, the third connection line 703 in a shape of a strip extending in the first direction X is disposed between the P-type active region and the N-type active region, the first end of the third connection line 703 is connected to the thirty-second connection electrode 632 and the thirty-fourth connection electrode 634 in an integral structure, and the second end of the third connection line 703 is connected to the thirty-fifth connection electrode 635 and the thirty-seventh connection electrode 637 in an integral structure.

In an exemplary implementation, there is a fifth distance S5 between an edge of the third connection line 703 close to the sixth P-type active region 106P and an edge of the sixth P-type active region 106P close to the third connection line 703, or a fifth distance S5 between an edge of the third connection line 703 close to the seventh P-type active region 107P and an edge of the seventh P-type active region 107P close to the third connection line 703, a sixth distance S6 between an edge of the third connection line 703 close to the sixth N-type active region 106N and an edge of the sixth N-type active region 106N close to the third connection line 703, or a sixth distance S6 between an edge of the third connection line 703 close to the seventh N-type active region 107N and an edge of the seventh N-type active region 107N close to the third connection line 703, and a ratio of the fifth distance S5 to the sixth distance S6 may be about 0.9 to 1.1.

In an exemplary implementation, the fifth distance S5 and the sixth distance S6 may be substantially equal.

In an exemplary implementation, since the thirty-second connection electrode 632 is connected to the sixth P-type drain region, the thirty-fourth connection electrode 634 is connected to the sixth N-type drain region, the thirty-fifth connection electrode 635 is connected to the seventh P-type source region, and the thirty-seventh connection electrode 637 is connected to the seventh N-type source region, setting the position of the third connection line 703 may affect the signal writing quality. In the present disclosure, by setting distance relationships between the third connection line 703 and the P-type active region and the N-type active region, the third connection line 703 is basically disposed in an middle area between two active regions, and synchronization of signal writing can be ensured.

(8) A pattern of a third insulation layer is formed. In an exemplary implementation, forming a pattern of a third insulation layer may include: depositing a third insulation thin film on the silicon substrate on which the aforementioned patterns are formed, and patterning the third insulation thin film by a patterning process to form the third insulation layer overlaying the pattern of the first conductive layer. A plurality of vias are disposed on the third insulation layer, as shown in FIG. 16.

In an exemplary implementation, the plurality of vias may include seventy-first vias V71 to eighty-sixth vias V86.

In an exemplary implementation, orthographic projections of the seventy-first vias V71 on the silicon substrate may be within a range of an orthographic projection of the first connection electrode 601 on the silicon substrate. The third insulation layer within the seventy-first vias V71 is etched away to expose a surface of the first connection electrode 601. The seventy-first vias V71 are configured such that the first signal adapter line to be formed subsequently is connected to the first connection electrode 601 through these vias.

In an exemplary implementation, orthographic projections of seventy-second vias V72 on the silicon substrate may be within a range of an orthographic projection of the second connection electrode 602 on the silicon substrate. The third insulation layer within the seventy-second vias V72 is etched away to expose a surface of the second connection electrode 602. The seventy-second vias V72 are configured such that the second signal adapter line to be formed subsequently is connected to the second connection electrode 602 through these vias.

In an exemplary implementation, orthographic projections of seventy-third vias V73 on the silicon substrate may be within a range of an orthographic projection of the fourth connection electrode 604 on the silicon substrate. The third insulation layer within the seventy-third vias V73 is etched away to expose a surface of the fourth connection electrode 604. The seventy-third vias V73 are configured such that the third signal adapter line to be formed subsequently is connected to the fourth connection electrode 604 through these vias.

In an exemplary implementation, orthographic projections of seventy-fourth vias 74 on the silicon-based substrate may be within a range of an orthographic projection of the second terminal of the seventh connection electrode 607 on the silicon-based substrate. The third insulation layer within the seventy-fourth vias V74 is etched away to expose a surface of the second terminal of the seventh connection electrode 607. The seventy-fourth vias V74 are configured such that the first signal adapter line to be formed subsequently is connected to the second terminal of the seventh connection electrode 607 through these vias V74.

In an exemplary implementation, orthographic projections of the seventy-fifth vias V75 on the silicon substrate may be within a range of an orthographic projection of the sixth connection electrode 606 on the silicon substrate. The third insulation layer within the seventy-fifth vias V75 is etched away to expose a surface of the sixth connection electrode 606. The seventy-fifth vias V75 are configured such that the second signal adapter line to be formed subsequently is connected to the sixth connection electrode 606 through these vias.

In an exemplary implementation, orthographic projections of seventy-sixth vias V76 on the silicon substrate is within a range of an orthographic projection of a second terminal of the ninth connection electrode 609 on the silicon substrate. The third insulation layer within the seventy-sixth vias V76 is etched away to expose a surface of the second terminal of the ninth connection electrode 609. The seventy-sixth vias V76 are configured such that the first signal adapter line to be formed subsequently is connected to the second terminal of the ninth connection electrode 609 through these vias.

In an exemplary implementation, orthographic projections of seventy-seventh vias V77 on the silicon substrate is within a range of an orthographic projection of a second terminal of the eighth connection electrode 608 on the silicon substrate, the third insulation layer within the seventy-seventh vias V77 is etched away to expose a surface of the second terminal of the eighth connection electrode 608, and the seventy-seventh vias V77 are configured such that the second signal adapter line to be formed subsequently is connected to the second terminal of the eighth connection electrode 608 through these vias.

In an exemplary implementation, orthographic projections of seventy-eighth vias V78 on the silicon substrate may be within a range of an orthographic projection of the tenth connection electrode 610 on the silicon substrate. The third insulation layer within the seventy-eighth vias V78 is etched away to expose a surface of the tenth connection electrode 610. The seventy-eighth vias V78 are configured such that the first signal adapter line to be formed subsequently is connected to the tenth connection electrode 610 through these vias.

In an exemplary implementation, orthographic projections of seventy-ninth vias V79 on the silicon substrate may be within a range of an orthographic projection of the eleventh connection electrode 611 on the silicon substrate. The third insulation layer within the seventy-ninth vias V79 is etched away to expose a surface of the eleventh connection electrode 611. The seventy-ninth vias V79 are configured such that the first signal adapter line to be formed subsequently is connected to the eleventh connection electrode 611 through these vias.

In an exemplary implementation, orthographic projections of eightieth vias V80 on the silicon substrate may be within a range of an orthographic projection of the sixty-second connection electrode 612 on the silicon substrate. The third insulation layer within the twelfth vias V80 is etched away to expose a surface of the sixty-second connection electrode 612. The eightieth vias V80 are configured such that the third signal adapter line to be formed subsequently is connected to the sixty-second connection electrode 612 through these vias.

In an exemplary implementation, orthographic projections of eighty-first vias 14 on the silicon-based substrate may be within a range of an orthographic projection of the fourteenth connection electrode 614 on the silicon-based substrate. The third insulation layer within eighty-first vias V81 is etched away to expose a surface of the fourteenth connection electrode 614. The eighty-first vias V81 are configured such that the fifth signal adapter line to be formed subsequently is connected to the fourteenth connection electrode 614 through these vias.

In an exemplary implementation, orthographic projections of eighty-second vias V82 on the silicon substrate may be within a range of an orthographic projection of the fifteenth connection electrode 615 on the silicon substrate. The third insulation layer within the eighty-second vias V82 is etched away to expose a surface of the fifteenth connection electrode 615. The eighty-second vias V82 are configured such that the second signal adapter line to be formed subsequently is connected to the fifteenth connection electrode 615 through these vias.

In an exemplary implementation, orthographic projections of eighty-third vias V83 on the silicon substrate may be within a range of an orthographic projection of the first bump k1 on the silicon substrate. The second insulation layer within the eighty-third vias V83 is etched away to expose a surface of the first bump k1. The eighty-third vias V83 are configured such that the fourth signal adapter line to be formed subsequently is connected to the first bump k1 through these vias.

In an exemplary implementation, orthographic projections of eighty-fourth vias 84 on the silicon substrate may be within a range of an orthographic projection of the second bump k2 on the silicon substrate. The third insulation layer within the eighty-fourth vias V84 is etched away to expose a surface of the second bump k2. The eighty-fourth vias V84 are configured such that the fourth signal adapter line to be formed subsequently is connected to the second bump k2 through these vias.

In an exemplary implementation, orthographic projections of eighty-fifth vias V85 on the silicon substrate may be within a range of an orthographic projection of the third connection line 703 on the silicon substrate. The third insulation layer within the eighty-fifth vias V85 is etched away to expose a surface of the third connection line 703. The eighty-fifth vias V85 are configured such that the fifth signal adapter line to be formed subsequently is connected to the third connection line 703 through these vias.

In an exemplary implementation, orthographic projections of eighty-sixth vias V86 on the silicon substrate is within a range of an orthographic projection of a third bump k3 on the silicon substrate. The third insulation layer within the eighty-sixth vias V86 is etched away to expose a surface of the third bump k3. The eighty-sixth vias V86 are configured such that the fifth signal adapter line to be formed subsequently is connected to the third bump k3 through these vias.

In an exemplary implementation, the seventy-first vias V71 to eighty-sixth vias V86 may be multiple, to reduce the contact resistance and improve the connection reliability.

(9) A pattern of a second conductive layer is formed. In an exemplary implementation, forming a pattern of a second conductive layer may include: depositing a second conductive thin film on the silicon substrate on which the aforementioned patterns are formed, and patterning the second conductive thin film by the patterning process, to form the pattern of the second conductive layer on the second insulation layer, as shown in FIGS. 17A and 17B, and FIG. 17B is a schematic diagram of the second conductive layer in FIG. 17A. In an exemplary implementation, the second conductive layer may be referred to as a second gate metal (Metal2) layer.

In an exemplary implementation, the pattern of the second conductive layer may include at least the first signal adapter line 801, the second signal adapter line 802, the third signal adapter line 803, the fourth signal adapter line 804, and the fifth signal adapter line 805.

In an exemplary implementation, the first signal adapter line 801 may be in a shape of a straight line or a polyline extending in the first direction X, and the first signal adapter line 801 may be sequentially connected to the first connection electrode 601 through the seventy-first vias V71, with the second terminal of the seventh connection electrode 607 through the seventy-fourth vias V74, with the second terminal of the ninth connection electrode 609 through the seventy-sixth vias V76, with the tenth connection electrode 610 through the seventy-eighth via V78, and with the third bump k3 through the eighty-sixth vias V86.

In the exemplary embodiment, since the first connection electrode 601 is connected to the first P-type gate electrode through vias, the seventh connection electrode 607 is connected to the fifth N-type gate electrode through vias, the ninth connection electrode 609 is connected to the sixth N-type gate electrode through vias, the tenth connection electrode 610 is connected to the seventh P-type gate electrode through vias, and the third bump k3 is connected to the eleventh P-type drain region and the eleventh N-type drain region, the first signal adapter line 801 realizes an interconnection between the gate electrode of the first P-type transistor P1, the gate electrode of the fifth N-type transistor N5, the gate electrode of the sixth N-type transistor N6, the gate electrode of the seventh P-type transistor P7, the second electrode of the eleventh P-type transistor P11 and the second electrode of the eleventh N-type transistor N11.

In an exemplary implementation, in the first direction X, the first signal adapter line 801 may have a first signal transmission length LT1, and the first signal transmission length LT1 may be a distance between a geometric center of a seventy-first via V71 on a side close to the eighty-sixth vias V86 and a geometric center of a eighty-sixth via V86 on a side close to the seventy-first vias V71.

In an exemplary implementation, the seventy-first via V71 on the side close to the eighty-sixth vias V86 may serve as a first adapter via of the present disclosure, the eighty-sixth via V86 on the side close to the seventy-first vias V71 may serve as the second adapter via of the present disclosure, and an area located between the first adapter via and the second adapter via in the first signal adapter line 801 is a minimum distance for signal transmission.

In an exemplary implementation, the first signal adapter line 801 may have a first adapter line width WT1, and the first adapter line width WT1 may be a dimension in the second direction Y.

In an exemplary implementation, the second signal adapter line 802 may be in a shape of a straight line or a polyline extending in the first direction X, and the second signal adapter line 802 may be sequentially connected to the second connection electrode 602 through the seventy-second vias V72, with the sixth connection electrode 606 through the seventy-fifth vias V75, with the second terminal of the eighth connection electrode 608 through the seventy-seventh vias V77, with the eleventh connection electrode 611 through the seventy-ninth vias V79, and with the fifteenth connection electrode 615 through the eighty-second vias V82.

In an exemplary implementation, since the second connection electrode 602 is connected to the first N-type gate electrode 201 N through vias, the sixth connection electrode 606 is connected to the fifth P-type gate electrode 205 P through vias, the first terminal of the eighth connection electrode 608 is connected to the sixth P-type gate electrode 206 P through vias, the eleventh connection electrode 611 is connected to the seventh N-type gate electrode 207 N through vias, the fifteenth connection electrode 615 is connected to the eleventh P-type gate electrode 211 P and the eleventh N-type gate electrode 211 N through vias, and the fifteenth connection electrode 615 is connected to the fifty-third connection electrode 653 and the fifty-fifth connection electrode 655 in an integral structure through the sixth connection line 706, the second signal adapter line 802 realizes an interconnection between the gate electrode of the first N-type transistor N1, the gate electrode of the fifth P-type transistor P5, the gate electrode of the sixth P-type transistor P6, the gate electrode of the seventh N-type transistor N7, the gate electrode of the eleventh P-type transistor P11, the gate electrode of the eleventh N-type transistor N11, the second electrode of the twelfth P-type transistor P12, and the second electrode of the twelfth N-type transistor P12.

In an exemplary implementation, in the first direction X, the second signal adapter line 802 may have a second signal transmission length LT2, and the second signal transmission length LT2 may be a distance between a geometric center of a seventy-second via V72 on a side close to the eighty-second vias V82 and a geometric center of an eighty-second via V82 on a side close to the seventy-second vias V72.

In an exemplary implementation, the seventy-second via V72 on the side close to the eighty-second vias V82 may serve as a third adapter via of the present disclosure, the eighty-second via V82 on the side close to the seventy-second vias V72 may serve as a fourth switch via of the present disclosure, and an area located between the third adapter via and the fourth adapter via in the second signal adapter line 802 is a minimum distance for signal transmission.

In an exemplary implementation, the second signal adapter line 802 may have a second adapter line width WT2, and the second adapter line width WT2 may be a dimension in the second direction Y.

In an exemplary implementation, a ratio of the first adapter line width WT1 to the second adapter line width WT2 may be about 0.95 to 1.05.

In an exemplary implementation, the first adapter line width WT1 and the second adapter line width WT2 may be substantially equal.

In an exemplary implementation, the second signal transmission length LT2 may be greater than the first signal transmission length LT1.

In an exemplary implementation, a difference between the second signal transmission length LT2 and the first signal transmission length LT1 may be greater than or equal to 0.8 µm. For example, LT2-LT1 may be about 2.4 µm.

In an exemplary implementation, the clock signal clk output from the clock signal terminal CK in the shift register circuit becomes an inverted clock signal clkb after passing through the twelfth P-type transistor P12 and the twelfth N-type transistor N12 (the first inverter). A part of the inverted clock signal clkb passes through the eleventh P-type transistor P11 and the eleventh N-type transistor N11 (the second inverter), and then becomes the clock signal clk, and is transmitted to the first transmission gate, the second transmission gate, and the third transmission gate, respectively, by the first signal adapter line 801. Another part of the inverted clock signal clkb is transmitted to the first transmission gate, the second transmission gate, and the third transmission gate, respectively, by the second signal adapter line 802. In the present disclosure, by setting the relationship between the signal transmission lengths in the first signal adapter line 801 and the second signal adapter line 802, a clock signal delay of the second inverter can be offset, the consistency of the clock signal delay can be ensured, and the electrical performance of the shift register circuit can be improved.

In an exemplary implementation, at least one of the first signal adapter line 801 and the second signal adapter line 802 may be located in the gap region 50 between the P-type active region and the N-type active region, which not only optimizes the connection structure, but also reduces the influence on the transistor channel area.

In an exemplary implementation, the first signal adapter line 801 may be disposed on a side of the gap region 50 close to the P-type active region, and the second signal adapter line 802 may be disposed on a side of the gap region 50 close to the N-type active region.

In an exemplary implementation, orthographic projections of the first signal adapter line 801 and the second signal adapter line 802 on the silicon substrate are not overlapped with the orthographic projection of the first connection line 701 on the silicon substrate, and the orthographic projections of the first signal adapter line 801 and the second signal adapter line 802 on the silicon substrate are not overlapped with the orthographic projection of the fifth connection line 705 on the silicon substrate, thereby reducing the interference of the clock signal on the shift register circuit.

In an exemplary implementation, the third signal adapter line 803 may be in a shape of a straight line or a polyline extending in the first direction X, and a first end of the third signal adapter line 803 is connected to the fourth connection electrode 604 through the seventy-third vias V73, and a second end of the third signal adapter line 803 is connected to the twelfth connection electrode 612 through the eightieth vias V80.

In the exemplary embodiment, since the fourth connection electrode 604 is connected to the third P-type gate electrode 203 P (also the third N-type gate electrode 203 N) through vias, and the twelfth connection electrode 612 is connected to the eighth P-type gate electrode 208 P (also the eighth N-type gate electrode 208 N) through vias, the third signal transfer line 803 realizes an interconnection between the gate electrode of the third P-type transistor P3, the gate electrode of the third N-type transistor N3, the gate electrode of the eighth P-type transistor P8, and the gate electrode of the eighth N-type transistor N8. In an exemplary implementation, the third signal adapter line 803 is configured to be connected to the reset terminal RN of the shift register circuit through a connection line to be formed subsequently.

In an exemplary implementation, an orthographic projection of the third signal adapter line 803 on the silicon substrate is at least partially overlapped with the orthographic projections of the P-type gate electrodes in the third inverter (the fourth P-type transistor P4, the fifth P-type transistor P5), the second transmission gate (the sixth P-type transistor P6) and the third transmission gate (the seventh P-type transistor P7) on the silicon substrate, that is, the third signal adapter line 803 realizes the connection between the third transistor group and the eighth transistor group across four P-type transistors.

In an exemplary implementation, the fourth signal adapter line 804 may be in a shape of a straight line shape or a polyline shape extending in the first direction X, a first end of the fourth signal adapter line 804 is connected to the first bump k1 through the eighty-third via V83, and a second end of the fourth signal adapter line 804 is connected to the second bump k2 through the eighty-fourth via V84.

In an exemplary implementation, the fourth signal adapter line 804 realizes an interconnection between the second electrode of the first P-type transistor P1, the second electrode of the first N-type transistor N1, the gate electrode of the second P-type transistor P2, the gate electrode of the second N-type transistor N2, the second electrode of the fifth P-type transistor P5, and the second electrode of the fifth N-type transistor N5.

In an exemplary implementation, an orthographic projection of the fourth signal adapter line 804 on the silicon substrate is at least partially overlapped with the orthographic projections of the P-type gate electrodes in the first NAND gate (the second P-type transistor P2 and the third P-type transistor P3), the third inverter (the fourth P-type transistor P4 and the fifth P-type transistor P5) on the silicon substrate, that is, the fourth signal adapter line 804 realizes an interconnection between the first transistor group, the second transistor group, and the fifth transistor group across four P-type transistors.

In an exemplary implementation, the fifth signal adapter line 805 may be in a shape of a straight line or a polyline extending in the first direction X, a first end of the fifth signal adapter line 805 is connected to the third connection line 703 through the eighty-fifth vias V85, and a second end of the fifth signal adapter line 805 is connected to the fourteenth connection electrode 614 through the eighty-first vias V81.

In an exemplary implementation, since the third connection line 703 realizes interconnection between the second electrode of the sixth P-type transistor P6, the second electrode of the sixth N-type transistor N6, the first electrode of the seventh P-type transistor P7, and the first electrode of the seventh N-type transistor N7, and the fourteenth connection electrode 614 is connected to the tenth P-type gate electrode 210P (also the tenth N-type gate electrode 210N) through vias, the fifth signal adapter line 805 realizes interconnection between the second electrode of the sixth P-type transistor P6, the second electrode of the sixth N-type transistor P6, the first electrode of the seventh N-type transistor P7, the gate electrode of the tenth N-type transistor N7, the gate electrode of the tenth P-type transistor P10, and the gate electrode of the tenth N-type transistor N10.

In an exemplary implementation, the fifth signal adapter line 805 realizes an interconnection between the sixth transistor group, the seventh transistor group, and the tenth transistor group across three P-type transistors (the seventh P-type transistor P7, the eighth P-type transistor P8, and the ninth P-type transistor P9).

In an exemplary implementation, the fifth signal adapter line 805 may be located in the gap region 50 between the P-type active region and the N-type active region, and an orthographic projection of the fifth signal adapter line 805 on the silicon substrate is not overlapped with the orthographic projections of the P-type active regions in the third transmission gate (the seventh P-type transistor P7), the second NAND gate (the eighth P-type transistor P8 and the ninth P-type transistor P9) on the silicon substrate, and the orthographic projection of the fifth signal adapter line 805 on the silicon substrate is not overlapped with the orthographic projections of the N-type active regions in the third transmission gate (the seventh N-type transistor N7), the second NAND gate (the eighth N-type transistor N8 and the ninth N-type transistor N9), thereby reducing the influence of the fifth signal adapter line 805 on the silicon substrate.

In an exemplary implementation, the fourth signal adapter line 804, the third signal adapter line 803, the first signal adapter line 801, the fifth signal adapter line 805, and the second signal adapter line 802 may be sequentially disposed in the second direction Y.

So far, the manufacturing of the display substrate according to an exemplary implementation of the present disclosure is completed.

In an exemplary implementation, the first insulation layer to the third insulation layer may be made of silicon oxide SiOx, silicon nitride SiNx, silicon oxynitride SiON, or the like, and may have a single-layer structure, or may have a multi-layer composite structure. The first metal layer and the second metal layer may be made of a metal material, such as Argentum (Ag), Copper (Cu), Aluminum (Al), or Molybdenum (Mo), or may be made of an alloy material consisting of metals, such as Aluminum Neodymium (AlNd) alloy or Molybdenum Niobium (MoNb) alloy, and may be of a single-layer structure or may be of a multi-layer composite structure, such as a composite structure consisting of an Mo layer, a Cu layer, and an Mo layer. In an exemplary implementation, a plane shape of a via may be a rectangle, a circle, or an ellipse. Sizes of a plurality of vias may be the same or different, and the present disclosure is not limited thereto.

The structure of the existing shift register circuit has some problems, such as complicated design, no reset terminal, etc., and can't meet the requirements of the gate drive circuit in the display substrate. An exemplary embodiment of the present disclosure provides a display substrate, wherein a shift register circuit in a gate drive circuit implements a shift register function by adopting fewer transistors, and has a reset function at the same time, can drive a display panel with a pixel density of 4K or more, and can be applied to an OLEDoS display apparatus with the pixel density of 4K or more.

In the present disclosure, by setting the ratio of the width-to-length ratio of the P-type transistor to the width-to-length ratio of the N-type transistor, the propagation delay can be symmetrical, so that the rising and falling times of the P-type transistor and the N-type transistor are substantially equal, the noise margins of the high and low levels are substantially the same, and the charging and discharging times are substantially the same, thereby improving the electrical performance of the inverter in the shift register circuit.

By setting the positional relationship between the P-type active region of the first NAND gate and the P-type active region of the third inverter, the mutual influence between the NAND gate and the inverter can be reduced, the working reliability of the shift register circuit can be improved, and the signal of the gate drive circuit can be ensured.

By setting the minimum width of each area, the present disclosure can effectively reduce the mutual influence between the P-type active region and the N-type active region, between the P-type active region and the first power supply line, between the N-type active region and the ground line, and between the first power supply line and the ground line, improve the working reliability of the shift register circuit, and ensure the signal output quality of the gate drive circuit.

In the present disclosure, by setting the distance relationships between the first connection electrode and the first P-type active region and between the first connection electrode and the first N-type active region, the first connection electrode is substantially disposed in a middle area between the two active regions, and synchronization of signal writing can be ensured.

In the present disclosure, by setting the distance relationship between the third connection line and the P-type active region and between the third connection line and the N-type active region, the third connection line is substantially disposed in a middle area between the two active regions, and synchronization of signal writing can be ensured.

In the present disclosure, by setting the relationship between signal transmission lengths in the first signal adapter line and the second signal adapter line, the clock signal delay of the second inverter can be offset, the consistency of the clock signal delay can be ensured, and the electrical performance of the shift register circuit can be improved.

By setting the positions of the plurality of gate connection vias, the present disclosure can not only ensure process uniformity and signal transmission uniformity, but also facilitate the arrangement of the connection electrodes, optimize the connection structure between the first conductive layer and the gate conductive layer, and reduce the occupied area of the gate drive circuit.

By setting the positions of the connection lines and the signal adapter lines, the present disclosure can facilitate layout arrangement, optimize the connection structure, reduce the influence on the channel area of the transistor, and improve the circuit quality and the signal quality of the gate drive circuit.

Through the above structural design, the present disclosure optimizes the layout of the gate drive circuit, optimizes the layout space, reduces the occupied area of the gate drive circuit, improves the circuit quality and the signal quality, and can realize higher display quality and display effect.
the manufacturing process of the present disclosure may be achieved by using mature preparation equipment, with little process improvement, high compatibility, simple process realization, easy implementation, high production efficiency, low production cost, and high yield rate.

A structure of the display substrate and the manufacturing process thereof according to exemplary embodiments of the present disclosure are described by way of example only. Corresponding structures may be changed and patterning processes may be added or reduced according to actual needs, the present disclosure is not limited thereto.

An exemplary embodiment of the present disclosure further provides a display apparatus, including the aforementioned display substrate. The display apparatus of the present disclosure can be used in a Virtual Reality (VR) device, an augmented display (AR) device, an Extended Reality (XR) device, a Mixed Reality (MR) device, a sight, a rangefinder, and the like.

Although implementations disclosed in the present disclosure are as above, it should be noted that the above implementations are exemplary only rather than restrictive. Therefore, the present disclosure is not limited to what is specifically shown and described herein. Various modifications, substitutions or omissions may be made in forms and details of implementations without departing from the scope of the present disclosure.

## Claims

1. A gate drive circuit comprising a shift register circuit disposed on a silicon substrate, wherein the shift register circuit comprises at least a plurality of transistor groups disposed sequentially in a first direction, at least one transistor group comprises P-type transistors and N-type transistors disposed on a side of the P-type transistors in a second direction, and the first direction and the second direction intersect with each other; a P-type transistor comprises at least a P-type active region, an N-type transistor comprises at least an N-type active region, and a gap region is provided between the P-type active region and the N-type active region in the second direction, the gap region has a gap centerline, wherein the gap centerline is a straight line bisecting the gap region in the second direction and extending in the first direction; the plurality of transistor groups form at least one transmission gate, at least one NAND gate, and at least one inverter, and gap centerlines of the transistor groups in the at least one transmission gate, the at least one NAND gate, and the at least one inverter are on a same straight line extending in the first direction.

2. The gate drive circuit according to claim 1, wherein the plurality of transistor groups form a first transmission gate, a first NAND gate, a third inverter, a second transmission gate, a third transmission gate, a second NAND gate, a fourth inverter, a second inverter, and a first inverter disposed sequentially in the first direction; widths of gap regions of transistor groups in a same type of devices are the same, gap centerlines of the transistor groups in the same type of devices are on a same straight line extending in the first direction, and the widths of the gap regions are dimensions in the second direction.

3. The gate drive circuit according to claim 2, wherein widths of gap regions of transistor groups in different types of devices are different.

4. The gate drive circuit according to claim 2, wherein P-type transistors in the same type of devices have a same width-to-length ratio, and N-type transistors in the same type of devices have a same width-to-length ratio.

5. The gate drive circuit according to claim 2, wherein P-type transistors in different types of devices have different width-to-length ratios, and N-type transistors in different types of devices have different width-to-length ratios.

6. The gate drive circuit according to claim 2, wherein in at least one of the first inverter, the second inverter, the third inverter, and the fourth inverter, a ratio of a width-to-length ratio of P-type transistors to a width-to-length ratio of N-type transistors is greater than 1 and less than 3.

7. The gate drive circuit according to claim 2, wherein in at least one of the first NAND gate and the second NAND gate, a ratio of a width-to-length ratio of P-type transistors to a width-to-length ratio of N-type transistors is greater than 1.3 and less than 3.3.

8. The gate drive circuit according to claim 2, wherein in at least one of the first transmission gate, the second transmission gate, and the third transmission gate, a ratio of a width-to-length ratio of P-type transistors to a width-to-length ratio of N-type transistors is greater than 0.9 and less than 1.1.

9. The gate drive circuit according to claim 2, wherein a ratio of a width-to-length ratio of P-type transistors to a width-to-length ratio of N-type transistors in the first NAND gate is greater than a ratio of a width-to-length ratio of P-type transistors to a width-to-length ratio of N-type transistors in the first inverter, and the ratio of the width-to-length ratio of the P-type transistors to the width-to-length ratio of the N-type transistors in the first inverter is greater than a ratio of a width-to-length ratio of P-type transistors to a width-to-length ratio of N-type transistors in the first transmission gate.

10. The gate drive circuit according to claim 1, wherein the shift register circuit further comprises a power supply active region disposed on a side of the P-type active region away from the N-type active region and a ground active region disposed on a side of the N-type active region away from the P-type active region, the power supply active region has a first centerline, the ground active region has a second centerline, the first centerline is a straight line bisecting the power supply active region in the second direction and extending in the first direction, the second centerline is a straight line bisecting the ground active region in the second direction and extending in the first direction, and a distance between the first centerline and the second centerline in the second direction is less than or equal to 6.3 µm.

11. The gate drive circuit according to claim 10, wherein in at least one transistor group, a first width is provided between the first centerline and an edge of the P-type active region close to the first centerline, and a second width is provided between the second centerline and an edge of the N-type active region close to the second centerline, the first width is greater than 1 µm and less than 3 µm, the second width is greater than 1 µm and less than 3 µm, and the first width and the second width are dimensions in the second direction.

12. The gate drive circuit according to claim 10, wherein in at least one transistor group, a third width is provided between an edge of the P-type active region away from the first centerline and an edge of the N-type active region away from the second centerline, the third width is greater than or equal to 1.5 µm, and the third width is a dimension in the second direction.

13. The gate drive circuit according to claim 10, wherein in at least one transistor group, a P-type active region width is provided between an edge of the P-type active region close to the first centerline and an edge of the P-type active region away from the first centerline; an N-type active region width is provided between an edge of the N-type active region close to the second centerline and an edge of the N-type active region away from the second centerline; the P-type active region width is greater than 1 µm and less than 3 µm, the N-type active region width is greater than 1 µm and less than 3 µm, and the P-type active region width and the N-type active region width are dimensions in the second direction.

14. The gate drive circuit according to claim 13, wherein the plurality of transistor groups form a first transmission gate, a first NAND gate, a third inverter, a second transmission gate, a third transmission gate, a second NAND gate, a fourth inverter, a second inverter, and a first inverter disposed sequentially in the first direction; P-type active region widths in a same type of devices are the same, N-type active region widths in the same type of devices are the same, P-type active region widths in different types of devices are different, and N-type active region widths in the different types of devices are different.

15. The gate drive circuit according to claim 14, wherein at least one P-type active region has a P-type active centerline, and the P-type active centerline is a straight line bisecting the P-type active region in the second direction and extending in the first direction; P-type active centerlines in the same type of devices are on a same straight line extending in the first direction, and P-type active centerlines in the different types of devices are not on a same straight line extending in the first direction X.

16. The gate drive circuit according to claim 14, wherein at least one N-type active region has an N-type active centerline, and the N-type active centerline is a straight line bisecting the N-type active region in the second direction and extending in the first direction; N-type active centerlines in the same type of devices are on a same straight line extending in the first direction, and N-type active centerlines in the different types of devices are not on a same straight line extending in the first direction X.

17. The gate drive circuit according to claim 2, wherein the first NAND gate comprises at least a third P-type transistor, the third P-type transistor comprises at least a third P-type active region; the third inverter comprises at least a fourth P-type transistor, the fourth P-type transistor comprises at least a fourth P-type active region; a first distance is provided between an edge of the third P-type active region away from the gap region and an edge of the fourth P-type active region away from the gap region, a second distance is provided between an edge of the third P-type active region close to the gap region and an edge of the fourth P-type active region close to the gap region, wherein the first distance is larger than the second distance, and the first distance and the second distance are dimensions in the second direction.

18. The gate drive circuit according to claim 2, wherein the first transmission gate comprises a first P-type transistor and a first N-type transistor, and the first NAND gate comprises a second P-type transistor, a second N-type transistor, a third P-type transistor, and a third N-type transistor; the first P-type transistor comprises at least a first P-type active region and a first P-type drain electrode, the first P-type drain electrode is connected to a second region of the first P-type active region through a via; the first N-type transistor comprises at least a first N-type active region and a first N-type drain electrode, the first N-type drain electrode is connected to a second region of the first N-type active region through a via; the shift register circuit further comprises a first connection line, wherein the first connection line is in shape of a strip extending in the first direction, a first end of the first connection line is connected to the first P-type drain electrode and the first N-type drain electrode respectively, and a second end of the first connection line is connected to a P-type gate electrode of the second P-type transistor P2 and an N-type gate electrode of the second N-type transistor N2 respectively; in the second direction, the first connection line is disposed in the gap region.

19. The gate drive circuit according to claim 18, wherein a third distance is provided between an edge of the first connection line close to the first P-type active region and an edge of the first P-type active region close to the first connection line; a fourth distance is provided between an edge of the first connection line close to the first N-type active region and an edge of the first N-type active region close to the first connection line, wherein the third distance is less than or equal to the fourth distance, and the third distance and the fourth distance are dimensions in the second direction.

20. The gate drive circuit according to claim 19, wherein a ratio of the third distance to the fourth distance is 0.8 to 1.0.

21. The gate drive circuit according to claim 18, wherein the second P-type transistor comprises at least a second P-type active region and a second P-type drain electrode connected to a second region of the second P-type active region through a via, the second N-type transistor comprises at least a second N-type active region and a second N-type drain electrode connected to a second region of the second N-type active region through a via, and the third P-type transistor comprises at least a third P-type active region and a third P-type drain electrode connected to a second region of the third P-type active region through a via; the shift register circuit further comprises a second connection line, wherein the second connection line is in shape of a strip extending in the first direction, a first end of the second connection line is connected to the second N-type drain electrode, and a second end of the second connection line is connected to the second P-type drain electrode and the third P-type drain electrode respectively; in the second direction, the second connection line is disposed in the gap region.

22. The gate drive circuit according to claim 21, wherein the second connection line is disposed on a side of the first connection line close to the second N-type active region, and an electrode distance is provided between an edge of the second connection line close to the first connection line and an edge of the first connection line close to the second connection line, the electrode distance is greater than or equal to 0.256 µm, and the electrode distance is a dimension in the second direction.

23. The gate drive circuit according to claim 21, wherein an orthographic projection of the second connection line on the silicon substrate is at least partially overlapped with orthographic projections of the P-type gate electrode of the second P-type transistor and the N-type gate electrode of the second N-type transistor on the silicon substrate, and the orthographic projection of the second connection line on the silicon substrate is at least partially overlapped with orthographic projections of a P-type gate electrode of the third P-type transistor and an N-type gate electrode of the third N-type transistor on the silicon substrate.

24. The gate drive circuit according to claim 2, wherein the second transmission gate comprises a sixth P-type transistor and a sixth N-type transistor, and the third transmission gate comprises a seventh P-type transistor and a seventh N-type transistor; the sixth P-type transistor comprises at least a sixth P-type active region and a sixth P-type drain electrode connected to a second region of the sixth P-type active region through a via, and the sixth N-type transistor comprises at least a sixth N-type active region and a sixth N-type drain electrode connected to a second region of the sixth N-type active region through a via; the seventh P-type transistor comprises at least a seventh P-type active region and a seventh P-type source electrode connected to a first region of the seventh P-type active region through a via, and the seventh N-type transistor comprises at least a seventh N-type active region and a seventh N-type source electrode connected to a first region of the seventh N-type active region through a via; the shift register circuit further comprises a third connection line, wherein the third connection line is in shape of a strip extending in the first direction, a first end of the third connection line is connected to the sixth P-type drain electrode and the sixth N-type drain electrode respectively, and a second end of the third connection line is connected to the seventh P-type source electrode and the seventh N-type source electrode, respectively; in the second direction, the third connection line is disposed in the gap region.

25. The gate drive circuit according to claim 24, wherein a fifth distance is provided between an edge of the third connection line close to the sixth P-type active region and an edge of the sixth P-type active region close to the third connection line, and a sixth distance is provided between an edge of the third connection line close to the sixth N-type active region and an edge of the sixth N-type active region close to the third connection line, and a ratio of the fifth distance to the sixth distance is 0.9 to 1.1.

26. The gate drive circuit according to claim 2, wherein the third transmission gate comprises a seventh P-type transistor and a seventh N-type transistor, and the second NAND gate comprises an eighth P-type transistor, an eighth N-type transistor, a ninth P-type transistor, and a ninth N-type transistor; the seventh P-type transistor comprises at least a seventh P-type active region and a seventh P-type drain electrode connected to a second region of the seventh P-type active region through a via, and the seventh N-type transistor comprises at least a seventh N-type active region and a seventh N-type drain electrode connected to a second region of the seventh N-type active region through a via; the eighth P-type transistor comprises at least an eighth P-type active region and an eighth P-type drain electrode connected to a second region of the eighth P-type active region through a via, the ninth P-type transistor comprises at least a ninth P-type active region and a ninth P-type drain electrode connected to a second region of the ninth P-type active region through a via, and the ninth N-type transistor comprises at least a ninth N-type active region and a ninth N-type drain electrode connected to a second region of the ninth N-type active region through a via; the shift register circuit further comprises a fourth connection line, wherein the fourth connection line is in shape of a strip extending in the first direction, a first end of the fourth connection line is connected to the seventh P-type drain electrode and the seventh N-type drain electrode respectively, and a second end of the fourth connection line is connected to the ninth N-type drain electrode; an area between the first end and the second end of the fourth connection line is connected to the eighth P-type drain electrode and the ninth P-type drain electrode respectively; in the second direction, the fourth connection line is disposed in the gap region.

27. The gate drive circuit according to claim 26, wherein an orthographic projection of the fourth connection line on the silicon substrate is at least partially overlapped with orthographic projections of a P-type gate electrode of the eighth P-type transistor and an N-type gate electrode of the eighth N-type transistor on the silicon substrate, and the orthographic projection of the fourth connection line on the silicon substrate is at least partially overlapped with orthographic projections of a P-type gate electrode of the ninth P-type transistor and an N-type gate electrode of the ninth N-type transistor on the silicon substrate.

28. The gate drive circuit according to claim 2, wherein the third inverter comprises at least a fourth N-type transistor and a fifth N-type transistor, and the second NAND gate comprises at least a sixth N-type transistor; the fourth N-type transistor comprises at least a fourth N-type gate electrode, the fifth N-type transistor comprises at least a fifth N-type gate electrode, the sixth N-type transistor comprises at least a sixth N-type active region and a sixth N-type source electrode, and the sixth N-type source electrode is connected to a first region of the sixth N-type active region through a via; the shift register circuit further comprises a seventh connection line, wherein the seventh connection line is in shape of a strip extending in the first direction, a first end of the seventh connection line is connected to the fourth N-type gate electrode, and a second end of the seventh connection line is connected to the sixth N-type source electrode; the seventh connection line is disposed on a side of the fifth N-type active region away from the gap region.

29. The gate drive circuit according to claim 28, wherein an orthographic projection of the seventh connection line on the silicon substrate is not overlapped with an orthographic projection of the fifth N-type gate electrode on the silicon substrate.

30. The gate drive circuit according to claim 2, wherein a transistor group in the third inverter comprises a first gate connection electrode connected to P-type gate electrodes of P-type transistors and N-type gate electrodes of N-type transistors through first gate vias provided in the gap regions; orthographic projections of the first gate vias on the silicon substrate are at least partially overlapped with orthographic projections of the gap centerlines on the silicon substrate.

31. The gate drive circuit according to claim 30, wherein at least one transistor group in the first inverter, the second inverter, and the fourth inverter comprises a second gate connection electrode connected to P-type gate electrodes of P-type transistors and N-type gate electrodes of N-type transistors through second gate vias provided in the gap regions; in the second direction, the second gate vias are closer to N-type active regions of the N-type transistors relative to the first gate vias.

32. The gate drive circuit according to claim 30, wherein at least one transistor group in the first NAND gate and the second NAND gate comprises a third gate connection electrode connected to P-type gate electrodes of P-type transistors and N-type gate electrodes of N-type transistors through third gate vias disposed in the gap region; in the second direction, the third gate vias are closer to P-type active regions of the P-type transistors relative to the first gate vias.

33. The gate drive circuit according to claim 30, wherein at least one transistor group in the first transmission gate, the second transmission gate, and the third transmission gate comprises a fourth P-type gate connection electrode connected to P-type gate electrodes of P-type transistors through fourth P-type gate vias, and a fourth N-type gate connection electrode connected to N-type gate electrodes of N-type transistors through fourth N-type gate vias, and the fourth P-type gate vias and the fourth N-type gate vias are provided in the gap regions; in the second direction Y, the fourth P-type gate vias are closer to the P-type active regions of the P-type transistors and the fourth N-type gate vias are closer to the N-type active regions of the N-type transistors relative to the first gate vias.

34. The gate drive circuit according to claim 2, wherein the first transmission gate comprises a first P-type transistor and a first N-type transistor, and the second inverter comprises an eleventh P-type transistor and an eleventh N-type transistor; the shift register circuit further comprises a first connection electrode, a second connection electrode, a fifteenth connection electrode, a first signal adapter line and a second signal adapter line; the first connection electrode is connected to a P-type gate electrode of the first P-type transistor, the second connection electrode is connected to an N-type gate electrode of the first N-type transistor, the fifteenth connection electrode is connected to a P-type gate electrode of the eleventh P-type transistor and an N-type gate electrode of the eleventh N-type transistor, a first end of the first signal adapter line is connected to the first connection electrode through a first adapter via, and a second end of the first signal adapter line is connected to a second electrode of the eleventh P-type transistor and a second electrode of the eleventh N-type transistor through a second adapter via; a first end of the second signal adapter line is connected to the second connection electrode through a third adapter via, and a second end of the second signal adapter line is connected to the fifteenth connection electrode through a fourth adapter via; a first signal transmission length is provided between a geometric center of the first adapter via and a geometric center of the second adapter via, and a second signal transmission length is provided between a geometric center of the third adapter via and a geometric center of the fourth adapter via, wherein the second signal transmission length is greater than the first signal transmission length, and the first signal transmission length and the second signal transmission length are dimensions in the first direction.

35. The gate drive circuit according to claim 34, wherein a difference between the second signal transmission length and the first signal transmission length is greater than or equal to 0.8 µm.

36. The gate drive circuit according to claim 34, wherein at least one of the first signal adapter line and the second signal adapter line is disposed in the gap region.

37. The gate drive circuit according to claim 2, wherein the shift register circuit further comprises a third signal adapter line, a first end of the third signal adapter line is connected to a P-type gate electrode of a third P-type transistor in the first NAND gate, and a second end of the third signal adapter line is connected to a P-type gate electrode of an eighth P-type transistor in the second NAND gate; an orthographic projection of the third signal adapter line on the silicon substrate is at least partially overlapped with orthographic projections of P-type gate electrodes in the third inverter, the second transmission gate, and the third transmission gate on the silicon substrate.

38. The gate drive circuit according to claim 2, wherein the shift register circuit further comprises a fourth signal adapter line, a first end of the fourth signal adapter line is connected to a P-type drain electrode of a first P-type transistor in the first transmission gate, and a second end of the fourth signal adapter line is connected to a P-type drain electrode of a fifth P-type transistor in the third inverter; an orthographic projection of the fourth signal adapter line on the silicon substrate is at least partially overlapped with orthographic projections of P-type gate electrodes in the first NAND gate and the third inverter on the silicon substrate.

39. The gate drive circuit according to claim 2, wherein the shift register circuit further comprises a fifth signal adapter line, a first end of the fifth signal adapter line is connected to the second transmission gate and the third transmission gate, and a second end of the fifth signal adapter line is connected to the fourth inverter; an orthographic projection of the fifth signal adapter line on the silicon substrate is not overlapped with orthographic projections of P-type active regions in the third transmission gate and the second NAND gate on the silicon substrate, and the orthographic projection of the fifth signal adapter line on the silicon substrate is not overlapped with orthographic projections of N-type active regions in the third transmission gate and the second NAND gate on the silicon substrate.

40. The gate drive circuit according to claims 1 to 39, wherein the gate drive circuit further comprises a logical transition unit, a level shifter, and a line driver disposed on the silicon substrate, wherein the shift register circuit is configured to generate a timing with row by row shift according to a timing signal, the logical transition unit is configured to generate a target timing by a logic operation, the level shifter configured to perform voltage domain conversion on the target timing, and the line driver configured to enhance the converted signal and then output the enhanced signal to a scan signal line in the display area.

41. A display substrate comprising a display area and a non-display area; the display area comprises a plurality of sub-pixels, at least one sub-pixel including a pixel drive circuit and at least one scan signal line, and the scan signal line being configured to provide a scan signal to a pixel drive circuit connected to the scan signal line; the non-display area comprises a plurality of cascaded gate drive circuits, at least one gate drive circuit being connected to a scan signal line in one pixel row in the display area connected to, and the at least one gate drive circuit comprising the gate drive circuit according to any one of claims 1 to 40.

42. A display apparatus, comprising the display substrate according to claim 41.
